# EUROPEAN PATENT APPLICATION

(11) **EP 4 571 727 A1**
(43) Date of publication of application: **18.06.2025**
(21) Application number: 24215939.0
(22) Date of filing: 27.11.2024
(51) Int. Cl.: G09G 3/3266, G11C 19/28

(54) **DRIVING CIRCUIT**

(30) Priority: 15.12.2023 KR 20230182946
(71) Applicant: Samsung Display Co., Ltd., Yongin-si, Gyeonggi-do 17113 (KR)
(72) Inventor: KEUM, Nackhyeon, 17113 Yongin-si (KR); JEON, Donghwan, 17113 Yongin-si (KR); KIM, Kyunghoon, 17113 Yongin-si (KR); BANG, Jeonghun, 17113 Yongin-si (KR); KIM, Minjoo, 17113 Yongin-si (KR); OH, Kyonghwan, 17113 Yongin-si (KR)
(74) Representative: Walaski, Jan Filip

(57) **Abstract**

A driving circuit (DRV) uses a dual-level trigger scheme. The driving circuit includes a P stage (PST) in which a transistor (T1) configured to receive a start signal (OUT) is a P-channel transistor, and an N stage (NST) in which a transistor (T1) configured to receive a start signal (OUT) is an N-channel transistor, where the N stage is arranged at a certain interval.

## Description

This application claims priority to Korean Patent Application No. 10-2023-0182946, filed on December 15, 2023.

### BACKGROUND

### 1. Field

The disclosure relates to a driving circuit and a display apparatus including the same.

### 2. Description of the Related Art

A driving circuit includes a plurality of stages connected to signal lines. In response to signals received from a controller, the stages supply output signals to the signal lines connected thereto.

### SUMMARY

One or more embodiments include a driving circuit with a small size and configured to stably output an output signal, and a display apparatus including the driving circuit. The technical aspects to be achieved by the disclosure are not limited to the aforementioned aspects, and other technical aspects that are not mentioned herein would be clearly understood by a person skilled in the art from the description of the disclosure.

Additional aspects will be set forth in part in the description which follows and, in part, will be apparent from the description, or may be learned by practice of the presented embodiments of the disclosure.

According to one or more embodiments, a driving circuit includes: a pair of first stages and a pair of second stages, which are alternately arranged, where each of the pair of first stages and the pair of second stages includes a first transistor connected between a first node and a first terminal to which a start signal is input, the first transistor including a gate connected to a clock terminal to which a clock signal is input, a second transistor connected between the first node and a second node, the second transistor including a gate connected to a second terminal to which a first voltage is supplied, an inverter connected between the second terminal and a third terminal to which a second voltage is supplied, the inverter being configured to control a voltage of a third node to be a voltage obtained by inverting a voltage level of the first node or a voltage level of the second node, a pull-down transistor connected between an output terminal and the second terminal, the pull-down transistor including a gate connected to the second node, and a pull-up transistor connected between the third terminal and the output terminal, the pull-up transistor including a gate connected to the third node. The first transistor of each of the pair of first stages is a P-channel transistor, and the first transistor of each of the pair of second stages is an N-channel transistor.

In an embodiment, the second voltage may be greater than the first voltage.

In an embodiment, the clock signal may include a first clock signal and a second clock signal, the first clock signal may be input to clock terminals of an odd-numbered first stage among the pair of first stages and an odd-numbered second stage among the pair of second stages, the second clock signal may be input to clock terminals of an even-numbered first stage among the pair of first stages and an even-numbered second stage among the pair of second stages, and the second clock signal may be phase-shifted by a 1/4 cycle with respect to the first clock signal.

In an embodiment, the inverter of each of the pair of first stages and the pair of second stages may include a third transistor connected between the third terminal and the third node, the third transistor including a gate connected to the first node, and a fourth transistor connected between the third node and the second terminal, the fourth transistor including a gate connected to the second node.

In an embodiment, the inverter of each of the pair of first stages may include a third transistor connected between the third terminal and the third node, the third transistor including a gate connected to the first node, and a fourth transistor connected between the third node and the second terminal, the fourth transistor including a gate connected to the first node.

In an embodiment, the fourth transistor of each of the pair of first stages may further include a back gate connected to the second node.

In an embodiment, each of the pair of first stages may further include a fifth transistor connected between the third terminal and the first node, the fifth transistor including a gate connected to a reset terminal.

In an embodiment, the inverter of each of the pair of second stages may include a third transistor connected between the third terminal and the third node, the third transistor including a gate connected to the second node, and a fourth transistor connected between the third node and the second terminal, the fourth transistor including a gate connected to the second node.

In an embodiment, the first transistor of each of the pair of second stages may include a pair of sub-transistors connected in series.

In an embodiment, the pair of sub-transistors connected in series may include a first sub-transistor and a second sub-transistor, the first sub-transistor may further include a back gate configured to receive a voltage of the second node of a previous stage, and the second sub-transistor may further include a back gate configured to receive a voltage of the second node of a current stage.

In an embodiment, the inverter of each of the pair of second stages may include a third transistor connected between the third terminal and the third node, the third transistor including a gate connected to the first node, and a fourth transistor connected between the third node and the second terminal, the fourth transistor including a gate connected to the second node, and the first transistor of each of the pair of second stages may include a pair of sub-transistors connected in series.

In an embodiment, the pair of sub-transistors connected in series may include a first sub-transistor and a second sub-transistor, the first sub-transistor may further include a back gate configured to receive a voltage of the second node of a previous stage, and the second sub-transistor may further include a back gate configured to receive a voltage of the second node of a current stage.

According to one or more embodiments, a driving circuit includes: a first stage and a second stage, which are alternately arranged, where each of the first stage and the second stage includes a first transistor connected between a first node and a first terminal to which a start signal is input, the first transistor including a gate connected to a clock terminal to which a clock signal is input, a second transistor connected between the first node and a second node, the second transistor including a gate connected to a second terminal to which a first voltage is supplied, an inverter connected between the second terminal and a third terminal to which a second voltage is supplied, the inverter being configured to control a voltage of a third node to be a voltage obtained by inverting a voltage level of the first node or a voltage level of the second node, a pull-down transistor connected between an output terminal and the second terminal, the pull-down transistor including a gate connected to the second node, and a pull-up transistor connected between the third terminal and the output terminal, the pull-up transistor including a gate connected to the third node. The first transistor of the first stage is a P-channel transistor, and the first transistor of the second stage is an N-channel transistor.

In an embodiment, the second voltage may be greater than the first voltage.

In an embodiment, the driving circuit may be configured to repeat a first stage group and a second stage group, each of the first stage group and the second stage group may include an odd-numbered first stage and an even-numbered second stage, the clock signal may include a first clock signal and a second clock signal, the first clock signal may be input to clock terminals of the odd-numbered first stage and the even-numbered second stage of the first stage group, the second clock signal may be input to clock terminals of the odd-numbered first stage and the even-numbered second stage of the second stage group, and the second clock signal may be phase-shifted by a 1/2 cycle with respect to the first clock signal.

In an embodiment, the inverter of each of the first stage and the second stage may include a third transistor connected between the third terminal and the third node, the third transistor including a gate connected to the first node, and a fourth transistor connected between the third node and the second terminal, the fourth transistor including a gate connected to the second node.

In an embodiment, the inverter of the first stage may include a third transistor connected between the third terminal and the third node, the third transistor including a gate connected to the first node, and a fourth transistor connected between the third node and the second terminal, the fourth transistor including a gate connected to the first node.

In an embodiment, the fourth transistor of the first stage may further include a back gate connected to the second node.

In an embodiment, the first stage may further include a fifth transistor connected between the third terminal and the first node, the fifth transistor including a gate connected to a reset terminal.

In an embodiment, the inverter of the second stage may include a third transistor connected between the third terminal and the third node, the third transistor including a gate connected to the second node, and a fourth transistor connected between the third node and the second terminal, the fourth transistor including a gate connected to the second node.

In an embodiment, the first transistor of the second stage may include a pair of sub-transistors connected in series.

In an embodiment, the pair of sub-transistors connected in series may include a first sub-transistor and a second sub-transistor, the first sub-transistor may further include a back gate configured to receive a voltage of the second node of a previous stage, and the second sub-transistor may further include a back gate configured to receive a voltage of the second node of a current stage.

In an embodiment, the inverter of the second stage may include a third transistor connected between the third terminal and the third node, the third transistor including a gate connected to the first node, and a fourth transistor connected between the third node and the second terminal, the fourth transistor including a gate connected to the second node, and the first transistor of the second stage includes a pair of sub-transistors connected in series.

In an embodiment, the pair of sub-transistors connected in series may include a first sub-transistor and a second sub-transistor, the first sub-transistor may further include a back gate configured to receive a voltage of the second node of a previous stage, and the second sub-transistor may further include a back gate configured to receive a voltage of the second node of a current stage.

In an embodiment, a clock signal input to the clock terminal of the first stage and a clock signal input to the clock terminal of the second stage may be identical to each other.

According to one or more embodiments, a driving circuit includes a plurality of stages, where a first stage among the plurality of stages includes: a first transistor connected between a first node and a first terminal to which a start signal is input, the first transistor including a gate connected to a first clock terminal to which a clock signal is input, a second transistor connected between the first node and a second node, the second transistor including a gate connected to a second terminal to which a first voltage is supplied, a third transistor connected between a third node and a third terminal to which a second voltage higher than the first voltage is supplied, the third transistor including a gate connected to the first node, a fourth transistor connected between the third node and the second terminal, the fourth transistor including a gate connected to the first node, a fifth transistor connected between a first output terminal and the second terminal, the fifth transistor including a gate connected to the second node, a sixth transistor connected between the third terminal and the first output terminal, the sixth transistor including a gate connected to the third node, and a seventh transistor connected between the third terminal and the first node, the seventh transistor including a gate connected to a reset terminal. The third transistor is a P-channel transistor, and the fourth transistor is an N-channel transistor.

In an embodiment, among the plurality of stages, a second stage sequentially connected to the first stage may include an eighth transistor connected between a fourth node and a fourth terminal to which an output signal output from the first stage is input, the eighth transistor including a gate connected to a second clock terminal to which a clock signal is input, a ninth transistor connected between the fourth node and a fifth node, the ninth transistor including a gate connected to a fifth terminal to which the first voltage is supplied, a tenth transistor connected between a sixth node and a sixth terminal to which the second voltage is supplied, the tenth transistor including a gate connected to the fifth node, an eleventh transistor connected between the sixth node and the fifth terminal, the eleventh transistor including a gate connected to the fifth node, a twelfth transistor connected between a second output terminal and the fifth terminal, the twelfth transistor including a gate connected to the fifth node, and a thirteenth transistor connected between the sixth terminal and the second output terminal, the thirteenth transistor including a gate connected to the sixth node. The tenth transistor may be a P-channel transistor, and the eleventh transistor may be an N-channel transistor.

In an embodiment, the eighth transistor may include a pair of sub-transistors connected in series, the pair of sub-transistors connected in series may include a first sub-transistor and a second sub-transistor, the first sub-transistor may further include a back gate configured to receive a voltage of the second node of the first stage, and the second sub-transistor may further include a back gate configured to receive a voltage of the fifth node of the second stage.

In an embodiment, the first stage may further include a first capacitor connected between the second node and the first output terminal, and a second capacitor connected between the third terminal and the third node. The second stage may further include a third capacitor connected between the fifth node and the second output terminal, and a fourth capacitor connected between the sixth terminal and the sixth node.

In an embodiment, the first transistor may be a P-channel transistor, and the eighth transistor may be an N-channel transistor.

### BRIEF DESCRIPTION OF THE DRAWINGS

The above and other aspects, features, and advantages of embodiments of the present disclosure will be more apparent from the following description taken in conjunction with the accompanying drawings, in which:
FIG. 1 is a schematic diagram of a driving circuit;
FIG. 2 is a schematic diagram (a timing diagram) of input and output signals of a driving circuit;
FIG. 3 is a diagram of an arbitrary stage group among a plurality of stages included in the driving circuit of FIG. 1;
FIG. 4 is a circuit diagram showing an example of a P stage among the stage group in FIG. 3;
FIG. 5 is a circuit diagram showing an example of an N stage among the stage group in FIG. 3;
FIG. 6 is a timing diagram for describing driving of the stage group of FIG. 3;
FIG. 7 is a diagram of a P stage according to another example;
FIGS. 8 to 10 are diagrams of an N stage according to other examples;
FIGS. 11 to 25 are diagrams of a stage group of a driving circuit, according to other examples;
FIG. 26 is a schematic diagram of a driving circuit according to another example;
FIG. 27 is a diagram of an arbitrary stage group among a plurality of stages included in the driving circuit of FIG. 26;
FIG. 28 is a circuit diagram showing an example of a P stage among the stage group in FIG. 27;
FIGS. 29 and 30 are circuit diagrams showing an example of an N stage among the stage group in FIG. 27;
FIGS. 31 to 37 are diagrams of a stage group of a driving circuit, according to other examples;
FIG. 38 is a schematic diagram of a driving circuit according to still another example;
FIG. 39 is a diagram of an arbitrary stage group among a plurality of stages included in the driving circuit of FIG. 38;
FIG. 40 is a timing diagram for describing driving of the stage group of FIG. 39;
FIGS. 41 to 55 are diagrams of a stage group of a driving circuit, according to other examples;
FIG. 56 is a schematic diagram of a driving circuit according to yet another example;
FIGS. 57 to 64 are diagrams of an arbitrary stage group among a plurality of stages included in the driving circuit of FIG. 56;
FIG. 65 is a schematic diagram of a driving circuit according to still another example;
FIG. 66 is a diagram of an arbitrary stage group among a plurality of stages included in the driving circuit of FIG. 65;
FIG. 67 is a timing diagram for describing driving of the stage group of FIG. 66;
FIGS. 68 to 82 are diagrams of a stage group of a driving circuit, according to other examples;
FIG. 83 is a schematic diagram of a driving circuit according to yet another example;
FIGS. 84 to 91 are diagrams of an arbitrary stage group among a plurality of stages included in the driving circuit of FIG. 83;
FIG. 92 is a diagram of a clock signal; and
FIG. 93 is a schematic diagram of a display apparatus.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Because various modifications may be applied and one or more embodiments may be implemented, specific embodiments will be shown in the drawings and described in detail in the detailed description. Effects and features, and methods for achieving them will be clarified with reference to embodiments described below in detail with reference to the drawings. However, the embodiments may have different forms and should not be construed as being limited to the descriptions set forth herein.

It will be understood that although terms "first" and "second" may be used herein to describe various elements, these elements should not be limited by these terms and these terms are only used to distinguish one element from another.

In the following embodiments, the singular forms include the plural forms unless the context clearly indicates otherwise.

It will be understood that terms "comprise," "include," and "have" used herein specify the presence of stated features or elements, but do not preclude the presence or addition of one or more other features or elements.

Sizes of elements in the drawings may be exaggerated for convenience of description. In addition, because sizes and thicknesses of elements in the drawings are arbitrarily illustrated for convenience of explanation, the following embodiments are not limited thereto.

The expression "A and/or B" used herein indicates A, B, or A and B. Also, the expression "at least one of A and B" indicates A, B, or A and B.

In the following embodiments, when X and Y are connected to each other, this may include a case where X and Y are physically connected to each other, a case where X and Y are functionally connected to each other, and a case where X and Y are electrically connected to each other. Also, when X and Y are connected to each other, this may include a case where X and Y are directly connected to each other and a case where X and Y are indirectly connected to each other with another element therebetween. In this regard, X and Y may be elements, for example, apparatuses, devices, circuits, wires, electrodes, terminals, films, layers, areas, or the like.

For example, when X and Y are electrically connected to each other, this may include a case where X and Y are directly electrically connected to each other and/or a case where X and Y are indirectly electrically connected to each other with another element therebetween. When X and Y are indirectly electrically connected to each other, this may include a case where one or more elements (e.g., switches, transistors, capacitive elements, inductors, resistance elements, diodes, etc.) that enable electrical connection between X and Y are connected between X and Y. Accordingly, this is not limited to certain connection relationships, for example, connection relationships shown in the drawings or in the detailed description, and may also include connection relationships other than those shown in the drawings or in the detailed description.

In the following embodiments, the term "ON" used in association with the state of an element may refer to an activated state of the element, and "OFF" may refer to a deactivated state of the element. The term "ON" used in association with a signal received by an element may refer to a signal that activates the element, and "OFF" may refer to a signal that deactivates the element. The element may be activated by a high-level voltage or a low-level voltage. For example, a P-channel transistor (P-type transistor) is activated by a low level voltage, and an N-channel transistor (N-type transistor) is activated by a high level voltage. Accordingly, it should be understood that "ON" voltages for the P-channel transistor and the N-channel transistor are opposite (low vs. high) voltage levels. Hereinafter, a voltage that activates (turns on) a transistor is referred to as a gate-on voltage, and a voltage that deactivates (turns off) a transistor is referred to as a gate-off voltage.

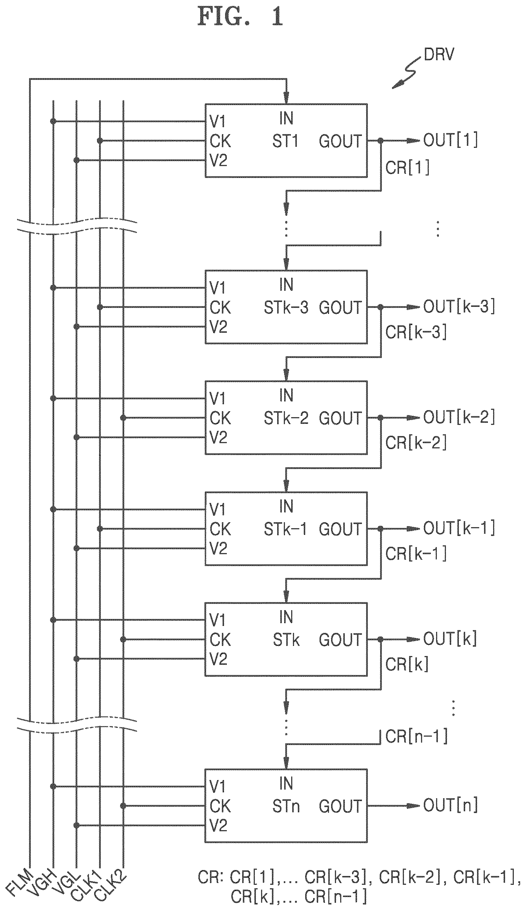

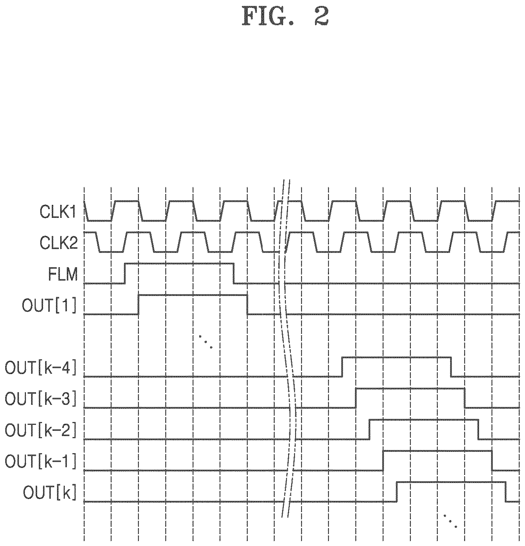

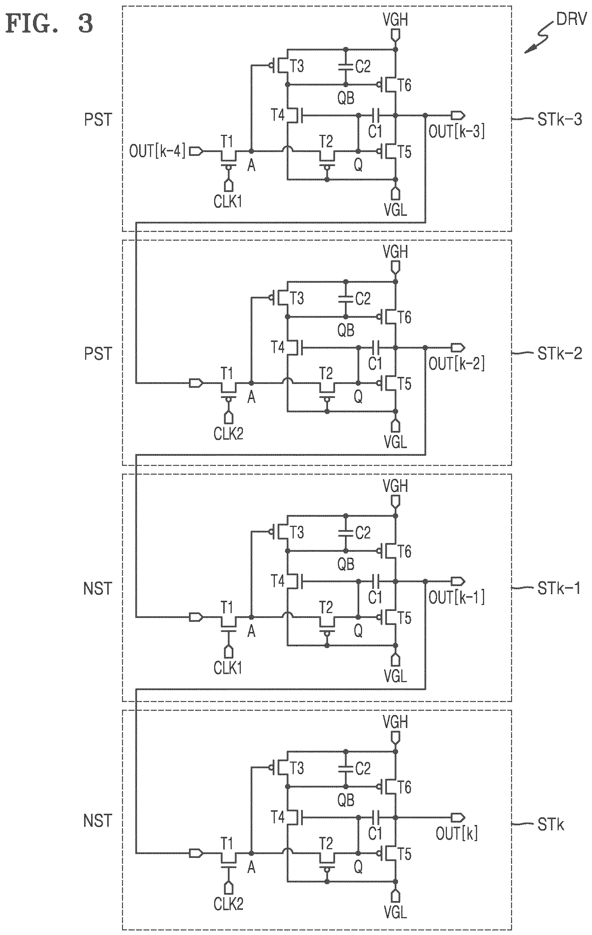

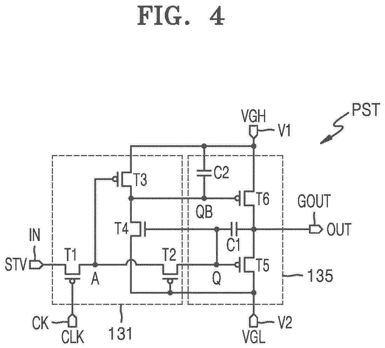

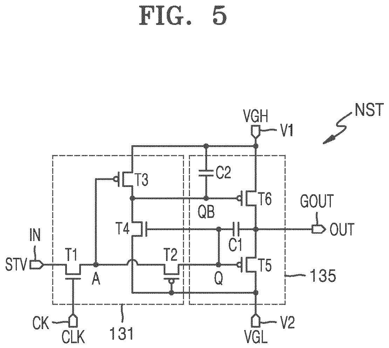

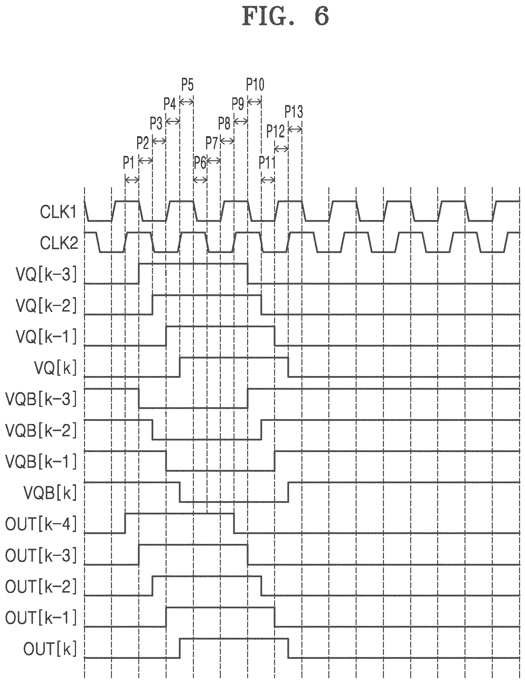

FIG. 1 is a schematic diagram (a timing diagram) of a driving circuit. FIG. 2 is a schematic diagram of input and output signals of a driving circuit. FIG. 3 is a diagram of an arbitrary stage group among a plurality of stages included in the driving circuit of FIG. 1. FIG. 4 is a circuit diagram showing an example of a P stage among the stage group in FIG. 3. FIG. 5 is a circuit diagram showing an example of an N stage among the stage group in FIG. 3. FIG. 6 is a timing diagram for describing driving of the stage group of FIG. 3.

Referring to FIG. 1, a driving circuit DRV may include a plurality of stages ST1 to STn. The plurality of stages ST1 to STn may be configured to sequentially output output signals OUT[1], ..., OUT[k-3], OUT[k-2], OUT[k-1], OUT[k], ..., and OUT[n] to signal lines, respectively.

The stages ST1 to STn may be connected to the signal lines, respectively. Each of the stages ST1 to STn may be configured to receive at least one clock signal and at least one voltage signal, generate an output signal OUT, and output the output signal OUT to a connected signal line.

The plurality of stages ST1 to STn may be configured to output, in response to a start signal STV, the output signals OUT[1], ..., OUT[k-3], OUT[k-2], OUT[k-1], OUT[k], ..., and OUT[n], respectively. For example, the n-th stage STn may be configured to output the n-th output signal OUT[n] to an n-th signal line. An external signal FLM, which is a start signal for controlling timing of the first output signal OUT[1], may be supplied to the first stage ST1.

The stages ST1 to STn may include a plurality of terminals to which a plurality of signals are input, respectively. The plurality of signals may include the clock signal and the voltage signal. The plurality of terminals may include an input terminal IN, a first voltage input terminal V1, a second voltage input terminal V2, a clock terminal CK, and an output terminal GOUT.

The start signal STV may be input (supplied) to the input terminal IN. The start signal STV may include the external signal FLM or a carry signal CR[1], ..., CR[k-3], CR[k-2], CR[k-1], CR[k], ..., or CR[n-1]. The carry signal CR[1], ..., CR[k-3], CR[k-2], CR[k-1], CR[k], ..., or CR[n-1] may be an output signal (hereinafter referred to as a previous output signal) output from a previous stage. The external signal FLM may be input as the start signal STV to an input terminal IN of the first stage ST1, and the previous output signal may be input as the start signal STV to an input terminal IN of each of the second stage to the n-th stage STn. A previous stage may be a stage located at least one stage prior to a current stage. FIG. 1 shows an example in which the previous stage is located immediately before the current stage. For example, the start signal STV (such as a carry signal CR), a (k-3)-th output signal OUT[k-3] output from a (k-3)-th stage STk-3 may be input to an input terminal IN of a (k-2)-th stage STk-2.

A first voltage VGH may be input to the first voltage input terminal V1, and a second voltage VGL may be input to the second voltage input terminal V2. The second voltage VGL may have a lower voltage level than the first voltage VGH.

A clock signal CLK may be input to the clock terminal CK. The clock signal CLK may include a first clock signal CLK1 and a second clock signal CLK2. The first clock signal CLK1 or the second clock signal CLK2 may be input to the clock terminal CK. The first clock signal CLK1 may be input to clock terminals CK of odd-numbered stages (such as a first stage ST1, a third stage, etc.). The second clock signal CLK2 may be input to clock terminals CK to even-numbered stages (such as a second stage, a fourth stage, etc.).

As shown in FIG. 2, the first clock signal CLK1 and the second clock signal CLK2 may be square wave signals that repeat a high-level voltage and a low-level voltage. The first clock signal CLK1 and the second clock signal CLK2 may be square wave signals that repeat the first voltage VGH and the second voltage VGL. The first clock signal CLK1 and the second clock signal CLK2 may be signals that have the same waveform and are phase-shifted. For example, the second clock signal CLK2 may have the same waveform as the first clock signal CLK1 and may be input by being phase-shifted (phase-delayed) at certain intervals. The second clock signal CLK2 may be shifted by a 1/4 cycle with respect to the first clock signal CLK1. In the first clock signal CLK1 and the second clock signal CLK2, a period during which a high-level voltage is maintained and a period during which a low-level voltage is maintained for one cycle may be the same.

An output signal OUT may be output from the output terminal GOUT. As shown in FIG. 2, the output signals OUT[1], ..., OUT[k-3], OUT[k-2], OUT[k-1], OUT[k], ..., and OUT[n] output from output terminals GOUT of the stages ST1 to STn may be sequentially shifted by a certain period, where n is a positive integer. The stages ST1 to STn may be configured to shift the output signals OUT[1], ..., OUT[k-3], OUT[k-2], OUT[k-1], OUT[k], ..., and OUT[n] having a high-level voltage by a 1/4 cycle of the clock signal CLK and sequentially output the same. The high-level voltage and the low-level voltage of the output signals OUT may be the first voltage VGH and the second voltage VGL, respectively.

Each of the stages ST1 to STn may be a P stage, referred to as PST or an N stage, referred to as NST. As shown in FIG. 3, the driving circuit DRV may be a shift register in which a pair of P stages PST and a pair of N stages NST are alternately arranged and cascaded. When a pair of P stages PST and a pair of N stages NST, which are adjacent to each other, are referred to as a stage group, the driving circuit DRV may include stage groups that are repeatedly arranged in one direction (e.g., a y-direction).

The stage groups may include a first stage group and a second stage group arranged consecutively to the first stage group. The first stage group may include a pair of adjacent P stages PST. The second stage group may include a pair of adjacent N stages NST.

FIG. 3 shows a stage group including the (k-3)-th stage STk-3 to a k-th stage STk among the stages ST1 to STn. In this case, k is an integer greater than 0 and smaller than or equal to n, and k is a multiple of 4. The (k-3)-th stage STk-3 and the (k-2)-th stage STk-2 may be P stages PST, and a (k-1)-th stage STk-1 and the k-th stage STk may be N stages NST. The (k-3)-th stage STk-3 and the (k-1)-th stage STk-1 may be odd-numbered stages, and the first clock signal CLK1 may be input to the clock terminal CK. The (k-2)-th stage STk-2 and the k-th stage STk may be even-numbered stages, and the second clock signal CLK2 may be input to the clock terminal CK.

An output signal OUT[k-4] of a (k-4)-th stage may be input to an input terminal IN of the (k-3)-th stage STk-3. An output signal OUT[k-3] of the (k-3)-th stage STk-3 may be input to the input terminal IN of the (k-2)-th stage STk-2. An output signal OUT[k-2] of the (k-2)-th stage STk-2 may be input to an input terminal IN of the (k-1)-th stage STk-1. An output signal OUT[k-1] of the (k-1)-th stage STk-1 may be input to an input terminal IN of the k-th stage STk.

As shown in FIGS. 4 and 5, each of the P stage PST and the N stage NST may include a control circuit 131 and an output circuit 135. Each of the control circuit 131 and the output circuit 135 may include at least one transistor. The at least one transistor may include an N-channel transistor and/or a P-channel transistor. For example, a fourth transistor T4 of the P stage PST may be an N-channel transistor, and a first transistor T1, a second transistor T2, a third transistor T3, a fifth transistor T5, and a sixth transistor T6 of the P stage PST may be P-channel transistors. In addition, a first transistor T1 and a fourth transistor T4 of the N stage NST may be N-channel transistors, and a second transistor T2, a third transistor T3, a fifth transistor T5, and a sixth transistor T6 of the N stage NST may be P-channel transistors.

The P-channel transistor may include a P-channel silicon transistor. The silicon transistor may include a silicon semiconductor, and the silicon semiconductor may include amorphous silicon, polysilicon, or the like. For example, the silicon transistor may include a low temperature polycrystalline silicon ("LTPS") thin-film transistor.

The N-channel transistor may include an N-channel oxide transistor. The oxide transistor may include an oxide semiconductor, and the oxide semiconductor is a zinc (Zn) oxide-based material and may include Zn oxide, indium (In)-Zn oxide, gallium (Ga)-In-Zn oxide, or the like. The oxide semiconductor may include an In-Ga-Zn-oxygen (O) ("IGZO") semiconductor. The oxide semiconductor may include an In-tin (Sn)-Ga-Zn-O ("ITGZO") semiconductor. For example, the oxide transistor may include a low temperature polycrystalline oxide ("LTPO") thin-film transistor.

A gate-on voltage of the P-channel transistor may be a low-level voltage, and a gate-off voltage of the P-channel transistor may be a high-level voltage. A gate-on voltage of the N-channel transistor may be a high-level voltage, and a gate-off voltage of the N-channel transistor may be a low-level voltage.

The control circuit 131 of each of the P stage PST and the N stage NST may be configured to control, in response to a signal input to the input terminal IN, voltages of a first node A, a second node Q, and a third node QB. For example, the control circuit 131 may be configured to control the voltages of the first node A, the second node Q, and the third node QB in response to the start signal STV (e.g., the external signal FLM (see FIG. 1) or the carry signal CR (see FIG. 1)). The carry signal CR may be a previous output signal. The control circuit 131 may include the first to fourth transistors T1 to T4.

The first transistor T1 of the P stage PST is a P-channel transistor, the first transistor T1 of the N stage NST is an N-channel transistor, and other configurations of the P stage PST and the N stage NST are the same.

The first transistor T1 may be connected between the input terminal IN and the first node A. A gate of the first transistor T1 may be connected to the clock terminal CK. The first transistor T1 of the P stage PST may be turned on when the clock signal CLK input to the clock terminal CK is at a low level, and may be configured to transmit, to the first node A, a start signal input to the input terminal IN. The first transistor T1 of the N stage NST may be turned on when the clock signal CLK input to the clock terminal CK is at a high level, and may be configured to transmit, to the first node A, a start signal input to the input terminal IN. The clock signal CLK may be the first clock signal CLK1 or the second clock signal CLK2.

The first clock signal CLK1 may be input to clock terminals CK of an odd-numbered P stage PST and an odd-numbered N stage NST, and the second clock signal CLK2 may be input to clock terminals CK of an even-numbered P stage PST and an even-numbered N stage NST. The second clock signal CLK2 may be input to the clock terminals CK of the odd-numbered P stage PST and the odd-numbered N stage NST, and the first clock signal CLK1 may be input to the clock terminals CK of the even-numbered P stage PST and the even-numbered N stage NST.

The second transistor T2 may be connected between the first node A and the second node Q. A gate of the second transistor T2 may be connected to the second voltage input terminal V2. The second transistor T2 may be turned on in response to the second voltage VGL input to the second voltage input terminal V2, and may be configured to transmit, to the second node Q, the start signal transmitted through the first transistor T1. The second transistor T2 may substantially always be turned on. In a stage where the second transistor T2 is omitted and the first transistor T1 is provided alone, the stress on the first transistor T1 may increase due to a prolonged low level of a voltage of the second node Q or a voltage of the first node A. As the second transistor T2 is provided, the first transistor T1 and the second transistor T2 share the stress caused by the second node Q or the first node A being at a low level for a long time, and accordingly, the stress of the first transistor T1 may be alleviated. Also, when the first transistor T1 is turned off, a line voltage drop between the input terminal IN and the first node A may be prevented by the second transistor T2.

The third transistor T3 may be connected between the first voltage input terminal V1 and the third node QB. A gate of the third transistor T3 may be connected to the first node A. The third transistor T3 may be turned on when a start signal transmitted to the first node A is at a low level, and may be configured to transmit, to the third node QB, the first voltage VGH input to the first voltage input terminal V1. Due to the third transistor T3, a voltage of the third node QB may be at a voltage level obtained by inverting the voltage level of the first node A. In other words, when the voltage of first node A is at the low level, the voltage of the third node QB may become at a high level due to the third transistor T3.

The fourth transistor T4 may be connected between the third node QB and the second voltage input terminal V2. A gate of the fourth transistor T4 may be connected to the second node Q. The fourth transistor T4 may be turned on when a start signal transmitted to the second node Q is at a high level, and may be configured to transmit, to the third node QB, the second voltage VGL input to the second voltage input terminal V2. Due to the fourth transistor T4, a voltage of the third node QB may be at a voltage level obtained by inverting the voltage level of the second node Q. In other words, when the voltage of second node Q is at the high level, the voltage of the third node QB may become at a low level due to the fourth transistor T4.

The third transistor T3 and the fourth transistor T4 may be configured to control the voltage level of the third node QB according to the voltage level of the first node A or the second node Q, and may thus function as an "inverter" or a level shifter.

The output circuit 135 may be connected between the first voltage input terminal V1 and the second voltage input terminal V2. The output circuit 135 may be configured to output the output signal OUT having a high-level voltage or a low-level voltage according to the voltage levels of the second node Q and the third node QB. The output circuit 135 may include the fifth transistor T5 and a sixth transistor T6. The output circuit 135 may further include a first capacitor C1 and a second capacitor C2.

The fifth transistor T5 may be connected between the output terminal GOUT and the second voltage input terminal V2. A gate of the fifth transistor T5 may be connected to the second node Q. The fifth transistor T5 may be a "pull-down transistor" configured to transmit a low-level voltage to the output terminal GOUT. The fifth transistor T5 may be turned on when a voltage of the second node Q is at a low level, and may be configured to transmit, to the output terminal GOUT, the second voltage VGL that is a low-level voltage input to the second voltage input terminal V2.

The sixth transistor T6 may be connected between the first voltage input terminal V1 and the output terminal GOUT. A gate of the sixth transistor T6 may be connected to the third node QB. The sixth transistor T6 may be a "pull-up transistor" configured to transmit a high-level voltage to the output terminal GOUT. The sixth transistor T6 may be turned on when a voltage of the third node QB is at a low level, and may be configured to transmit, to the output terminal GOUT, the first voltage VGH that is a high-level voltage input to the first voltage input terminal V1.

The first capacitor C1 may be connected between the output terminal GOUT and the second node Q. The second capacitor C2 may be connected between the first voltage input terminal V1 and the third node QB. The first capacitor C1 may be configured to maintain a voltage of the second node Q, and the second capacitor C2 may be configured to maintain a voltage of the third node QB.

Hereinafter, the operation of the stage group shown in FIG. 3 will be described with reference to FIG. 6.

FIG. 6 shows the first clock signal CLK1, the second clock signal CLK2, output signals OUT[k-3], OUT[k-2], OUT[k-1], and OUT[k] of the (k-3)-th stage STk-3 to the k-th stage STk, the previous output signal OUT[k-4], which is a start signal of the (k-3)-th stage STk-3, and voltages VQ[k-3], VQ[k-2], VQ[k-1], and VQ[k] of second nodes Q and voltages VQB[k-3], VQB[k-2], VQB[k-1], and VQB[k] of third nodes QB of the (k-3)-th stage STk-3 to the k-th stage STk. The previous output signal OUT[k-4] of the (k-3)-th stage STk-3 may be an output signal of a (k-4)-th stage.

During a first period P1 to an eighth period P8, the previous output signal OUT[k-4] of high level, which is a start signal, may be supplied to the input terminal IN of the (k-3)-th stage STk-3.

In the first period P1, the first clock signal CLK1 of high level may be supplied to a clock terminal CK of an odd-numbered stage, and the second clock signal CLK2 of high level may be supplied to a clock terminal CK of an even-numbered stage.

Due to the first clock signal CLK1 of high level, the first transistor T1 of the (k-3)-th stage STk-3 may remain turned off, the first node A and the second node Q may maintain the same low-level voltage as in a previous period, and the (k-3)-th output signal OUT[k-3] of low level may be output through the fifth transistor T5. The voltage of the third node QB may be a high-level voltage due to the turned-on third transistor T3.

In a second period P2, the first clock signal CLK1 of low level may be supplied to the clock terminal CK of the odd-numbered stage, and the second clock signal CLK2 of high level may be supplied to the clock terminal CK of the even-numbered stage.

The first transistor T1 of the (k-3)-th stage STk-3 may be turned on by the first clock signal CLK1 of low level. The second transistor T2 may be in a state being turned on by the second voltage VGL of low level. Due to the turned-on first transistor T1 and the second transistor T2, the previous output signal OUT[k-4] of high level may be transmitted to the first node A and the second node Q of the (k-3)-th stage STk-3, and the fifth transistor T5 may be turned off. The third transistor T3 whose gate is connected to the first node A may be turned off and the fourth transistor T4 whose gate is connected to the second node Q may be turned on, and thus, the voltage of the third node QB may be the second voltage VGL of low level. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In a third period P3, the first clock signal CLK1 of low level may be supplied to the clock terminal CK of the odd-numbered stage, and the second clock signal CLK2 of low level may be supplied to the clock terminal CK of the even-numbered stage.

The first transistor T1 of the (k-3)-th stage STk-3 may remain turned on by the first clock signal CLK1 of low level. Due to the turned-on first transistor T1 and the second transistor T2, the previous output signal OUT[k-4] of high level may be transmitted to the first node A and the second node Q of the (k-3)-th stage STk-3, and the fifth transistor T5 may remain turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In a fourth period P4, the first clock signal CLK1 of high level may be supplied to the clock terminal CK of the odd-numbered stage, and the second clock signal CLK2 of low level may be supplied to the clock terminal CK of the even-numbered stage.

The first transistor T1 of the (k-3)-th stage STk-3 may be turned off by the first clock signal CLK1 of high level. The second transistor T2 may be in a state being turned on by the second voltage VGL of low level. Because the first node A and the second node Q of the (k-3)-th stage STk-3 maintain a high-level voltage in the third period P3 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In a fifth period P5, the first clock signal CLK1 of high level may be supplied to the clock terminal CK of the odd-numbered stage, and the second clock signal CLK2 of high level may be supplied to the clock terminal CK of the even-numbered stage.

The first transistor T1 of the (k-3)-th stage STk-3 may be turned off by the first clock signal CLK1 of high level. The second transistor T2 may be in a state being turned on by the second voltage VGL of low level. Because the first node A and the second node Q of the (k-3)-th stage STk-3 maintain a high-level voltage in the fourth period P4 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In a sixth period P6, a seventh period P7, and the eighth period P8, the (k-3)-th stage STk-3 may operate the same as in the second period P2, the third period P3, and the fourth period P4, and the output signal OUT[k-3] of high level may be output from the output terminal GOUT.

In a ninth period P9, the previous output signal OUT[k-4] may transition from high level to low level and be supplied to the input terminal IN of the (k-3)-th stage STk-3. The first clock signal CLK1 of high level may be supplied to the clock terminal CK of the odd-numbered stage, and the second clock signal CLK2 of high level may be supplied to the clock terminal CK of the even-numbered stage.

In the ninth period P9, the start signal transitions from high level to low level, but the first clock signal CLK1 of high level is input to the clock terminal CK of the (k-3)-th stage STk-3 such that the first transistor T1 is turned off. Thus, regardless of the voltage level of the start signal, the operation of the (k-3)-th stage STk-3 may be the same as the operation of the (k-3)-th stage STk-3 during the fifth period P5. Accordingly, the output signal OUT[k-3] of high level may be output from the output terminal GOUT of the (k-3)-th stage STk-3.

In a tenth period P10, the previous output signal OUT[k-4] of low level may be supplied to the input terminal IN of the (k-3)-th stage STk-3. The first clock signal CLK1 of low level may be supplied to the clock terminal CK of the odd-numbered stage, and the second clock signal CLK2 of high level may be supplied to the clock terminal CK of the even-numbered stage.

The first transistor T1 of the (k-3)-th stage STk-3 may be turned on by the first clock signal CLK1 of low level. The second transistor T2 may be in a state being turned on by the second voltage VGL of low level. Due to the turned-on first transistor T1 and the second transistor T2, the previous output signal OUT[k-4] of low level may be transmitted to the first node A and the second node Q of the (k-3)-th stage STk-3, and voltages of the first node A and the second node Q are low-level voltages such that the fifth transistor T5 may be turned on. Accordingly, the second voltage VGL of low level may be output as the output signal OUT[k-3] from the output terminal GOUT of the (k-3)-th stage STk-3. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the second period P2 to the ninth period P9, the previous output signal OUT[k-3] of high level, which is a start signal from the (k-3)-th stage STk-3, may be supplied to the input terminal IN of the (k-2)-th stage STk-2.

In the second period P2, the second clock signal CLK2 of high level is input to the clock terminal CK of the (k-2)-th stage STk-2, and accordingly, the first transistor T1 of the (k-2)-th stage STk-2 remains turned off, the first node A and the second node Q maintain the same low-level voltage as in a previous period, and the fifth transistor T5 is turned on. Thus, the second voltage VGL of low level may be output as the (k-2)-th output signal OUT[k-2] from the output terminal GOUT. The voltage of the third node QB may be a high-level voltage due to the turned-on third transistor T3.

In the third period P3 and the fourth period P4, the second clock signal CLK2 of low level is input to the clock terminal CK of the (k-2)-th stage STk-2, and thus, the first transistor T1 may be turned on. Due to the turned-on first transistor T1 and the second transistor T2, the previous output signal OUT[k-3] of high level may be transmitted to the first node A and the second node Q of the (k-2)-th stage STk-2, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-2] of high level may be output from the output terminal GOUT of the (k-2)-th stage STk-2.

Because the operation of the (k-2)-th stage STk-2 during the fifth period P5 to an eleventh period P11 is the same as the operation of the (k-3)-th stage STk-3 during the fourth period P4 to the tenth period P10, a detailed description thereof is omitted.

During the third period P3 to the tenth period P10, the previous output signal OUT[k-2] of high level, which is a start signal from the (k-2)-th stage STk-2, may be supplied to the input terminal IN of the (k-1)-th stage STk-1.

In the third period P3, the first clock signal CLK1 of low level is input to the clock terminal CK of the (k-1)-th stage STk-1, and accordingly, the first transistor T1 of the (k-1)-th stage STk-1 remains turned off, the first node A and the second node Q maintain the same low-level voltage as in a previous period, and the fifth transistor T5 is turned on. Thus, the second voltage VGL of low level may be output as the (k-1)-th output signal OUT[k-1] from the output terminal GOUT. The voltage of the third node QB may be a high-level voltage due to the turned-on third transistor T3.

In the fourth period P4 and the fifth period P5, the first clock signal CLK1 of high level is input to the clock terminal CK of the (k-1)-th stage STk-1, and thus, the first transistor T1 may be turned on. Due to the turned-on first transistor T1 and the second transistor T2, the previous output signal OUT[k-2] of high level may be transmitted to the first node A and the second node Q of the (k-1)-th stage STk-1, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-1] of high level may be output from the output terminal GOUT of the (k-1)-th stage STk-1.

In the sixth period P6 and the seventh period P7, the first clock signal CLK1 of low level is input to the clock terminal CK of the (k-1)-th stage STk-1, and thus, the first transistor T1 may be turned off. Because the first node A and the second node Q maintain a high-level voltage in the fifth period P5 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-1] of high level may be output from the output terminal GOUT of the (k-1)-th stage STk-1.

In the eighth period P8, the ninth period P9, and the tenth period P10, the (k-1)-th stage STk-1 may operate the same as in the fourth period P4, the fifth period P5, and the sixth period P6, and the output signal OUT[k-1] of high level may be output from the output terminal GOUT.

In the eleventh period P11, the previous output signal OUT[k-2] transitions from high level to low level and is supplied to the input terminal IN of the (k-1)-th stage STk-1, but the first clock signal CLK1 of low level is input to the clock terminal CK of the (k-1)-th stage STk-1 such that the first transistor T1 is turned off. Thus, regardless of the voltage level of the start signal, the operation of the (k-1)-th stage STk-1 may be the same as the operation of the (k-1)-th stage STk-1 during the sixth period P6. Accordingly, the output signal OUT[k-1] of high level may be output from the output terminal GOUT of the (k-1)-th stage STk-1.

In a twelfth period P12, the previous output signal OUT[k-2] of low level may be supplied to the input terminal IN of the (k-1)-th stage STk-1. The first transistor T1 of the (k-1)-th stage STk-1 may be turned on by the first clock signal CLK1 of high level. The second transistor T2 may be in a state being turned on by the second voltage VGL of low level. Due to the turned-on first transistor T1 and the second transistor T2, the previous output signal OUT[k-2] of low level may be transmitted to the first node A and the second node Q of the (k-1)-th stage STk-1, and the fifth transistor T5 may be turned on. Accordingly, the second voltage VGL of low level may be output as the output signal OUT[k-1] from the output terminal GOUT of the (k-1)-th stage STk-1. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the fourth period P4 to the eleventh period P11, the previous output signal OUT[k-1] of high level, which is a start signal from the (k-1)-th stage STk-1, may be supplied to the input terminal IN of the k-th stage STk.

In the fourth period P4, the second clock signal CLK2 of low level is input to the clock terminal CK of the k-th stage STk, and accordingly, the first transistor T1 of the k-th stage STk remains turned off, the first node A and the second node Q maintain the same low-level voltage as in a previous period, and the fifth transistor T5 is turned on. Thus, the second voltage VGL of low level may be output as the k-th output signal OUT[k] from the output terminal GOUT. The voltage of the third node QB may be a high-level voltage due to the turned-on third transistor T3.

In the fifth period P5 and the sixth period P6, the second clock signal CLK2 of high level is input to the clock terminal CK of the k-th stage STk, and thus, the first transistor T1 may be turned on. Due to the turned-on first transistor T1 and the second transistor T2, the previous output signal OUT[k-1] of high level may be transmitted to the first node A and the second node Q of the k-th stage STk, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k] of high level may be output from the output terminal GOUT of the k-th stage STk.

Because the operation of the k-th stage STk during the seventh period P7 to a thirteenth period P13 is the same as the operation of the (k-1)-th stage STk-1 during the sixth period P6 to the twelfth period P12, a detailed description thereof is omitted.

By alternately arranging a plurality of stages that constitute the driving circuit DRV into a pair of P stages and a pair of N stages, errors in which adjacent stages simultaneously operate in an arrangement where one P stage and one N stage alternate with each other may be significantly reduced.

The P stage PST and the N stage NST are not limited to FIGS. 4 and 5, and various modifications may be made. Hereinafter, various examples of the P stage PST and the N stage NST will be described, mainly focusing on differences from the stages shown in FIGS. 3 to 5.

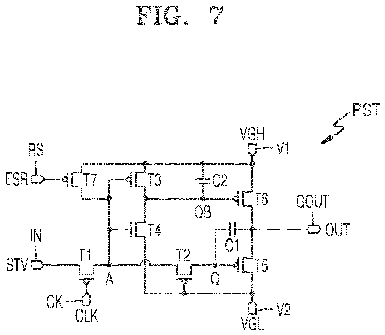

FIG. 7 is a diagram of a P stage PST according to another example.

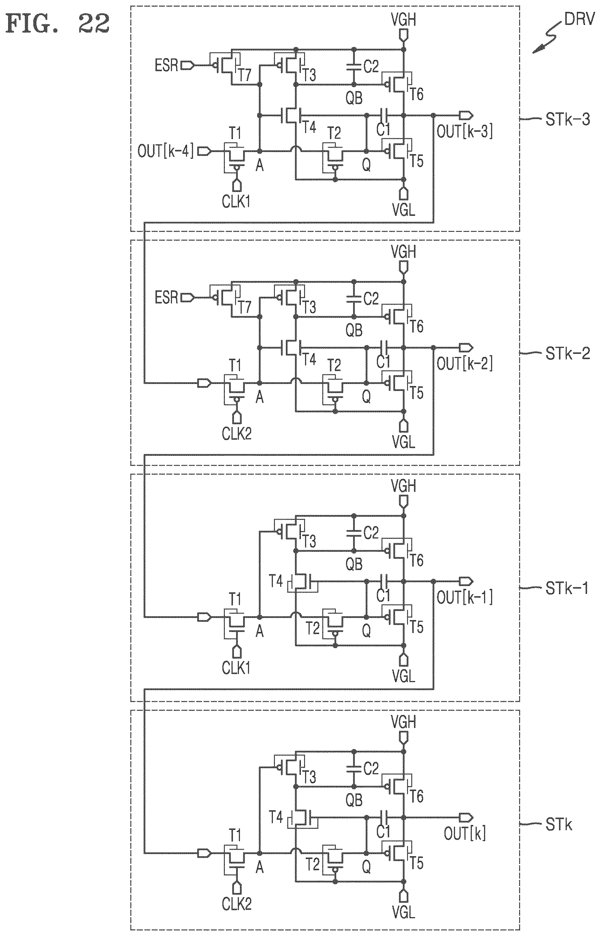

Referring to FIG. 7, the fourth transistor T4 of the P stage PST may be connected between the third node QB and the second voltage input terminal V2, and the gate of the fourth transistor T4 may be connected to the first node A. The fourth transistor T4 may be turned on when a start signal transmitted to the first node A is at a high level, and may be configured to transmit, to the third node QB, the second voltage VGL input to the second voltage input terminal V2. The fourth transistor T4 may be a dual gate transistor further including a back gate connected to the second node Q (refer to FIG. 22).

When a start signal STV is at a low level, the voltage of the second node Q may be lower than the voltage of the first node A due to the second transistor T2. Accordingly, the turn-off reliability of the fourth transistor T4 when the gate of the fourth transistor T4 is connected to the first node A may be improved over the turn-off reliability of the fourth transistor T4 when the gate of the fourth transistor T4 is connected to the second node Q.

The P stage PST may further include a seventh transistor T7 as a reset circuit. The seventh transistor T7 may be configured to reset a voltage of the first node A and a voltage of the second node Q based on a reset signal ESR supplied to a reset terminal RS. The seventh transistor T7 may be connected between the first voltage input terminal V1 and the first node A, and a gate of the seventh transistor T7 may be connected to the reset terminal RS. The seventh transistor T7 may be turned on when the reset signal ESR is supplied to the reset terminal RS at a low level, and may be configured to reset (initialize) a voltage of the first node A and a voltage of the second node Q to the first voltage VGH.

The reset signal ESR may be supplied to the first to n-th stages ST1 to STn at a low level at a specific time point (timing). The reset signal ESR may be supplied in the form of a pulse having a low level of the second voltage VGL at a certain time point (timing) or may be supplied as the first voltage VGH at other time point (timing). For example, the reset signal ESR may be supplied to initialize (reset) the voltages of the first node A and the second node Q such as when an operation error occurs in a device.

In the P stage PST, when the start signal STV of low level is input and the clock signal CLK of low level is supplied, the second transistor T2 may be gradually turned off. As a voltage at the output terminal GOUT falls from high level to low level when the second transistor T2 is in a turned-off state, the voltage of the second node Q may drop to a voltage (e.g., about -15 V to about -20 V, which is approximately 2×VGL (two times of second voltage VGL)) lower than the second voltage VGL due to coupling of the first capacitor C1. In contrast, the voltage of the first node A may be a voltage (e.g., about -8 V to about -10 V, which is approximately VGL+ | Vth | ) higher than the second voltage VGL due to threshold voltage loss of the first transistor T1. Here, Vth is a threshold voltage of the first transistor T1, and VGL represents a voltage value of the second voltage VGL. Compared to an example in which the gate of the fourth transistor T4 is connected to the second node Q, in an example in which the gate of the fourth transistor T4 is connected to the first node A, a gate-off bias of the N-channel transistor may be reduced, thereby improving device reliability.

The configuration and operation of the P stage PST shown in FIG. 7 other than the fourth transistor T4 and the seventh transistor T7 are the same as the configuration and operation of the P stage PST shown in FIG. 4. The seventh transistor T7 may be omitted in the P stage PST shown in FIG. 7.

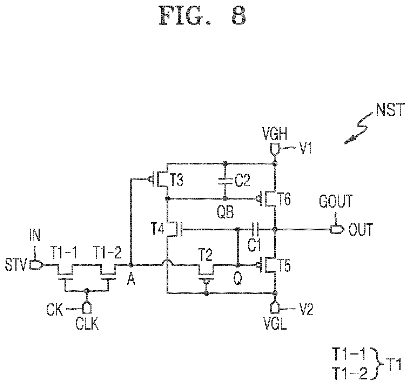

FIGS. 8 to 10 are diagrams of an N stage NST according to other examples.

The N stage NST shown in FIG. 8 differs from the N stage NST shown in FIG. 5 in that the first transistor T1 has a structure in which a plurality of sub-transistors are connected in series, and the configuration and operation of the N stage NST shown in FIG. 8 other than the above difference are the same as the configuration and operation of the N stage NST shown in FIG. 5.

The first transistor T1 may include a plurality of sub-transistors connected in series between the input terminal IN and the first node A. The plurality of sub-transistors may include a pair of a first sub-transistor T1-1 and a second sub-transistor T1-2. Gates of the first sub-transistor T1-1 and the second sub-transistor T1-2 may be connected to the clock terminal CK. The first sub-transistor T1-1 and the second sub-transistor T1-2 may be turned on when the clock signal CLK input to the clock terminal CK is at a high level, and may be configured to transmit, to the first node A, a start signal input to the input terminal IN. The clock signal CLK may be the first clock signal CLK1 or the second clock signal CLK2.

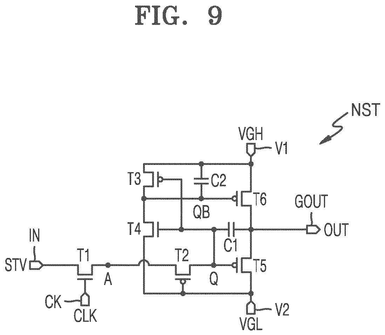

The N stage NST shown in FIG. 9 differs from the N stage NST shown in FIG. 5 in that the gate of the third transistor T3 is connected to the second node Q, and the configuration and operation of the N stage NST shown in FIG. 9 other than the above difference are the same as the configuration and operation of the N stage NST shown in FIG. 5.

The third transistor T3 may be connected between the first voltage input terminal V1 and the third node QB, and the gate of the third transistor T3 may be connected to the second node Q. The third transistor T3 may be turned on when a start signal transmitted to the second node Q is at a low level, and may be configured to transmit, to the third node QB, the first voltage VGH input to the first voltage input terminal V1.

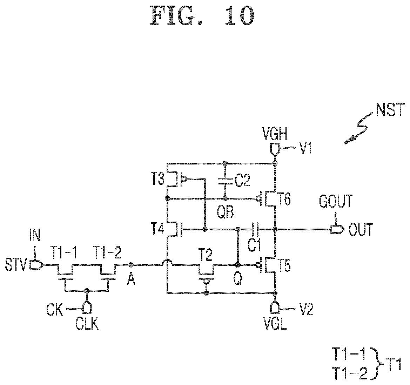

The N stage NST shown in FIG. 10 differs from the N stage NST shown in FIG. 9 in that the first transistor T1 has a structure in which a plurality of sub-transistors are connected in series, and the configuration and operation of the N stage NST shown in FIG. 10 other than the above difference are the same as the configuration and operation of the N stage NST shown in FIG. 9. The first transistor T1 is implemented in a structure in which a plurality of sub-transistors are connected in series, and thus, leakage current may be significantly reduced.

The first transistor T1 may include a plurality of sub-transistors connected in series between the input terminal IN and the first node A. The plurality of sub-transistors may include a pair of a first sub-transistor T1-1 and a second sub-transistor T1-2. Gates of the first sub-transistor T1-1 and the second sub-transistor T1-2 may be connected to the clock terminal CK. The first sub-transistor T1-1 and the second sub-transistor T1-2 may be turned on when the clock signal CLK input to the clock terminal CK is at a high level, and may be configured to transmit, to the first node A, a start signal input to the input terminal IN. The clock signal CLK may be the first clock signal CLK1 or the second clock signal CLK2.

The stage group of the driving circuit DRV shown in FIG. 1 is not limited to the stage group shown in FIG. 3. For example, the stage group of the driving circuit DRV may be composed of a combination of one of the P stages PST shown in FIGS. 4 and 7 and one of the N stages NST shown in FIGS. 5 and 8 to 10.

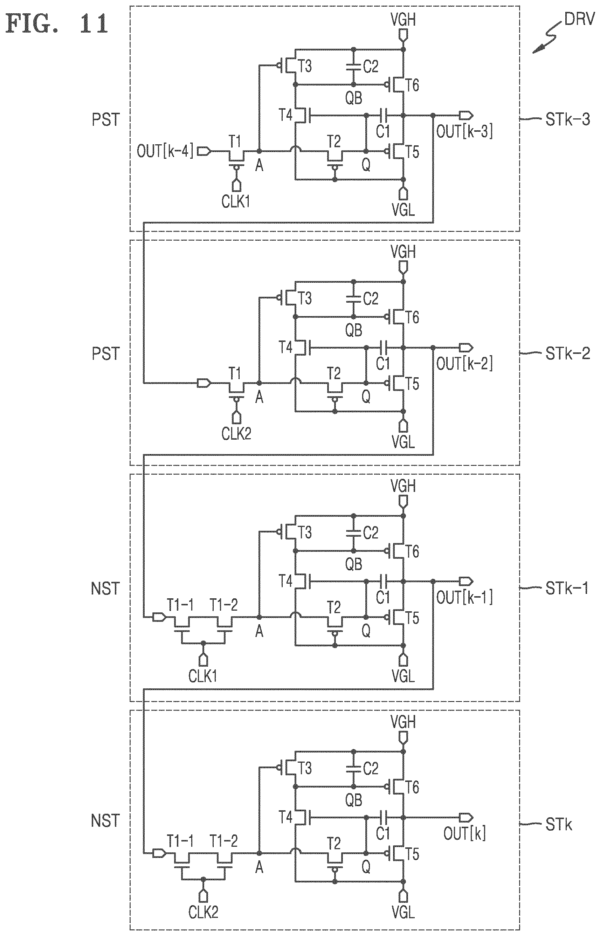

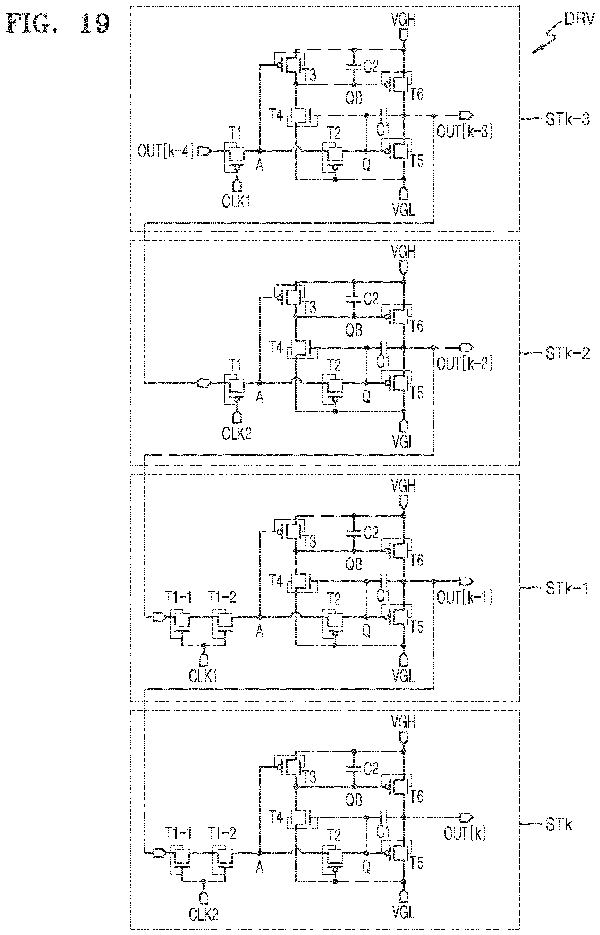

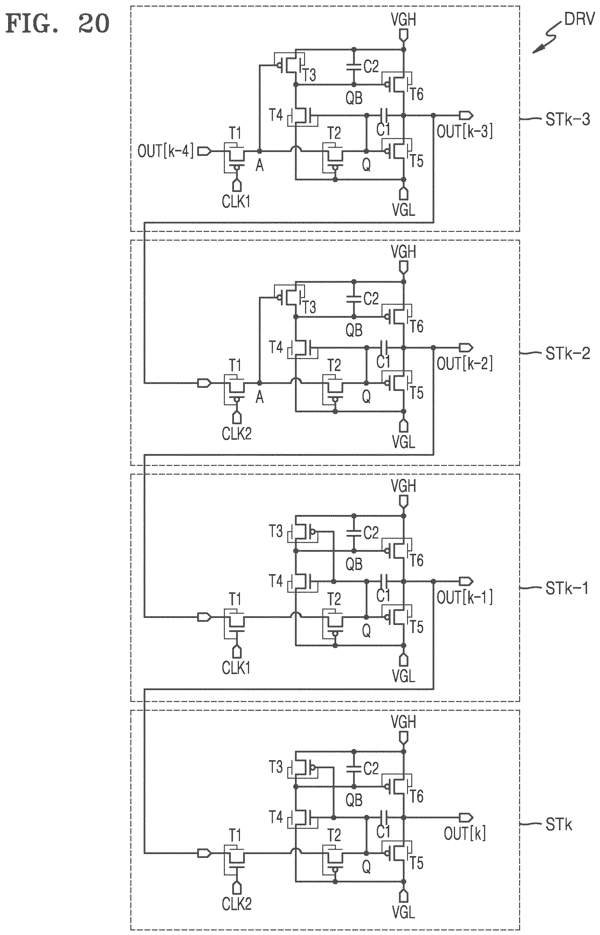

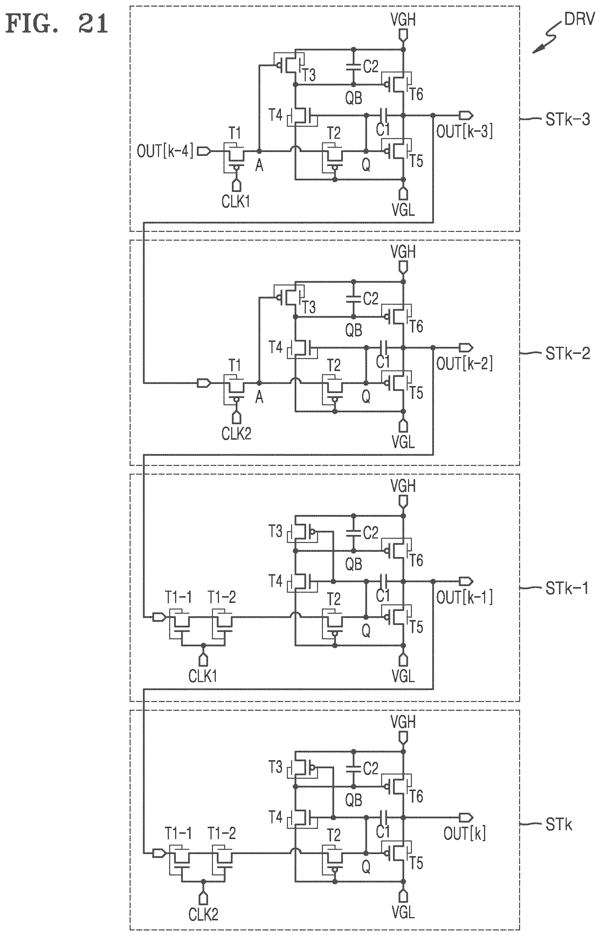

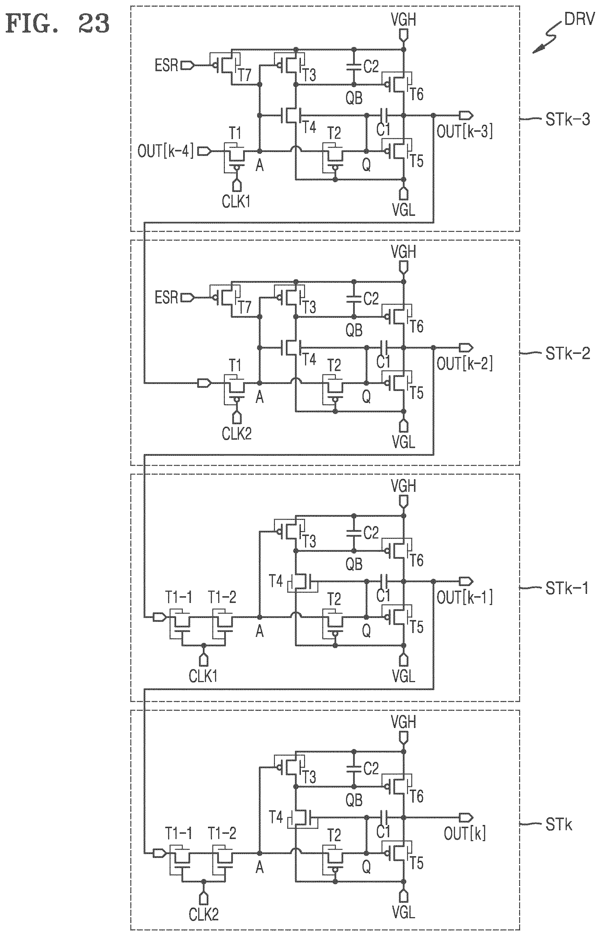

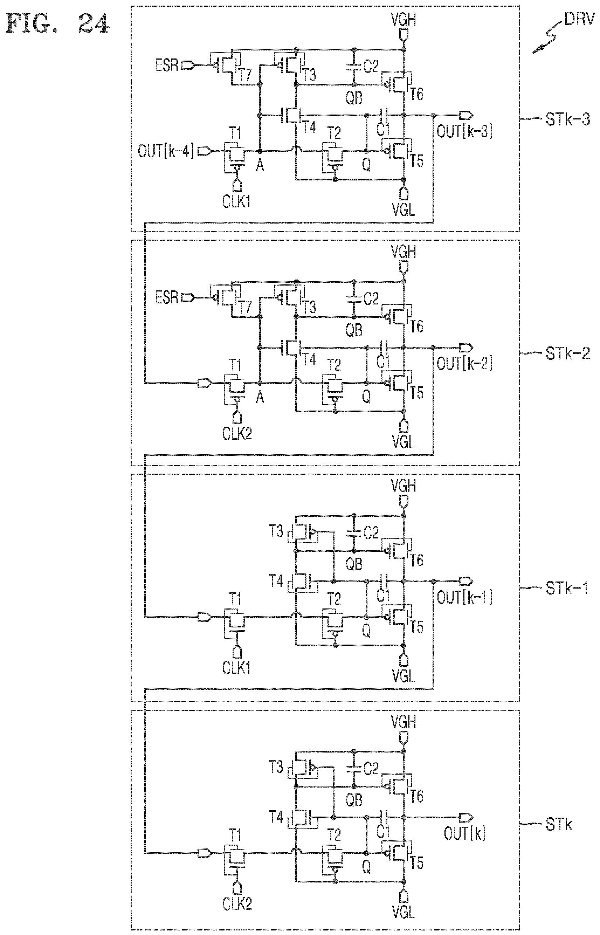

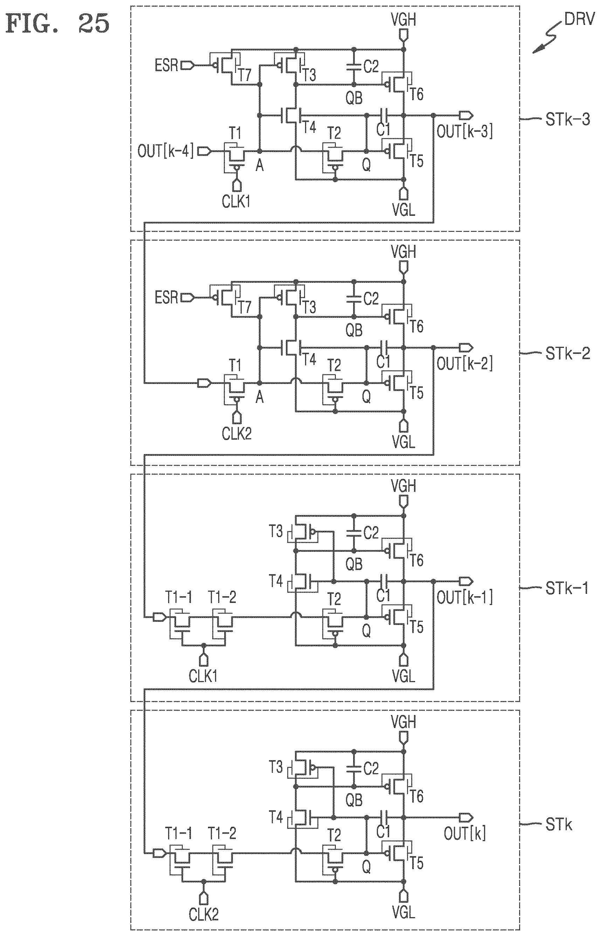

FIGS. 11 to 25 are diagrams of a stage group of a driving circuit DRV, according to other examples. The driving circuit DRV shown in FIGS. 11 to 25 may have a structure in which a stage group including a pair of P stages PST and a pair of N stages NST is repeatedly arranged.

As shown in FIG. 11, the stage group may include the P stage PST shown in FIG. 4 and the N stage NST shown in FIG. 8.

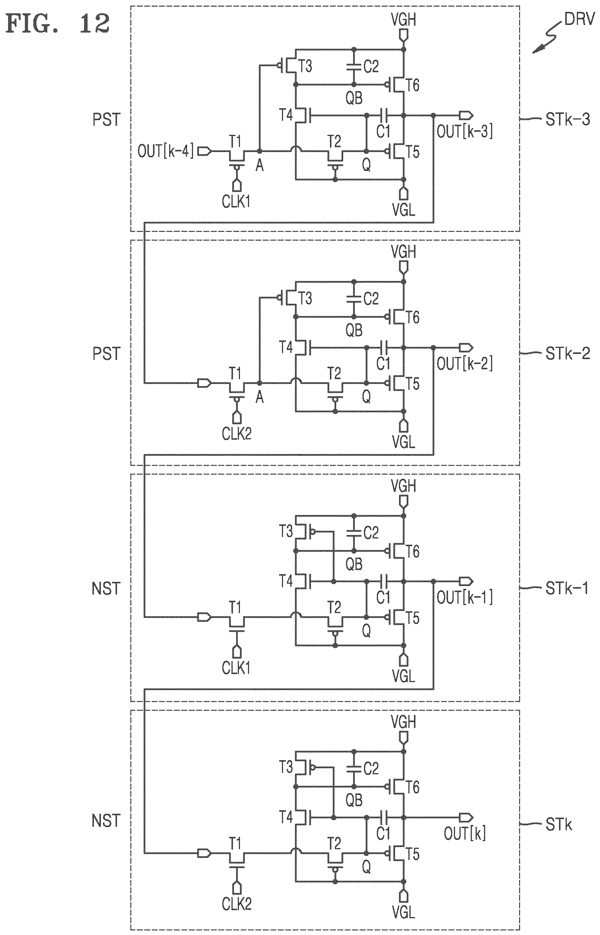

As shown in FIG. 12, the stage group may include the P stage PST shown in FIG. 4 and the N stage NST shown in FIG. 9.

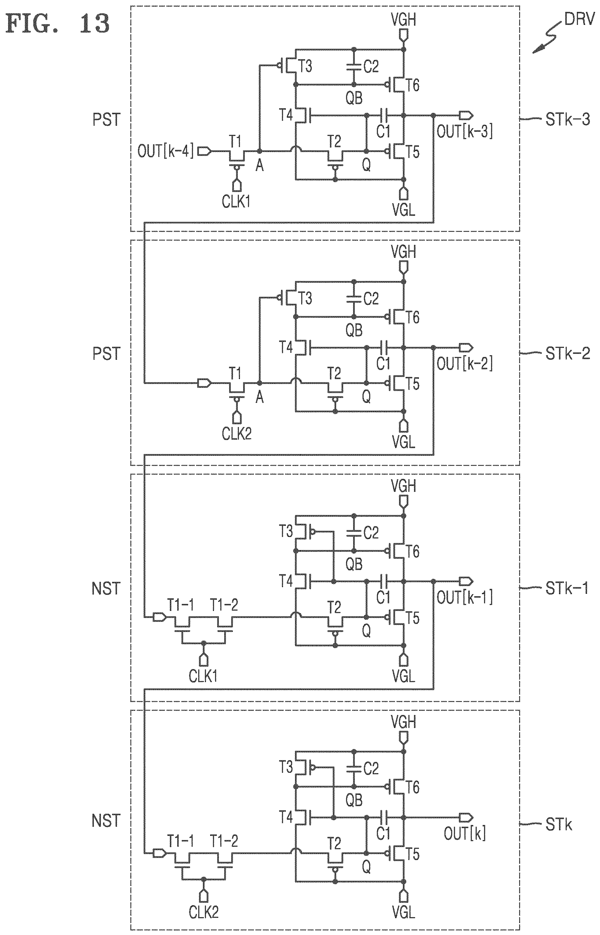

As shown in FIG. 13, the stage group may include the P stage PST shown in FIG. 4 and the N stage NST shown in FIG. 10.

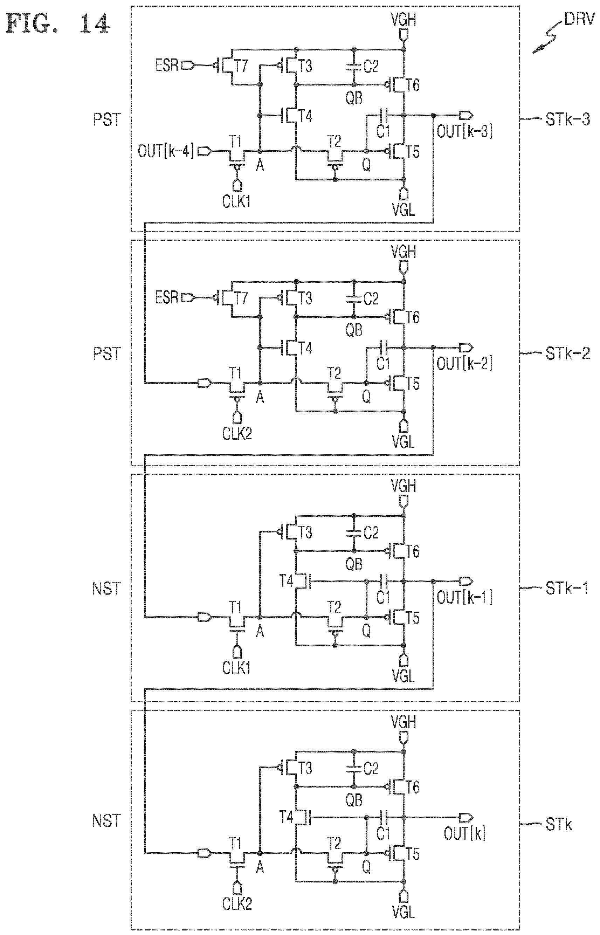

As shown in FIG. 14, the stage group may include the P stage PST shown in FIG. 7 and the N stage NST shown in FIG. 5.

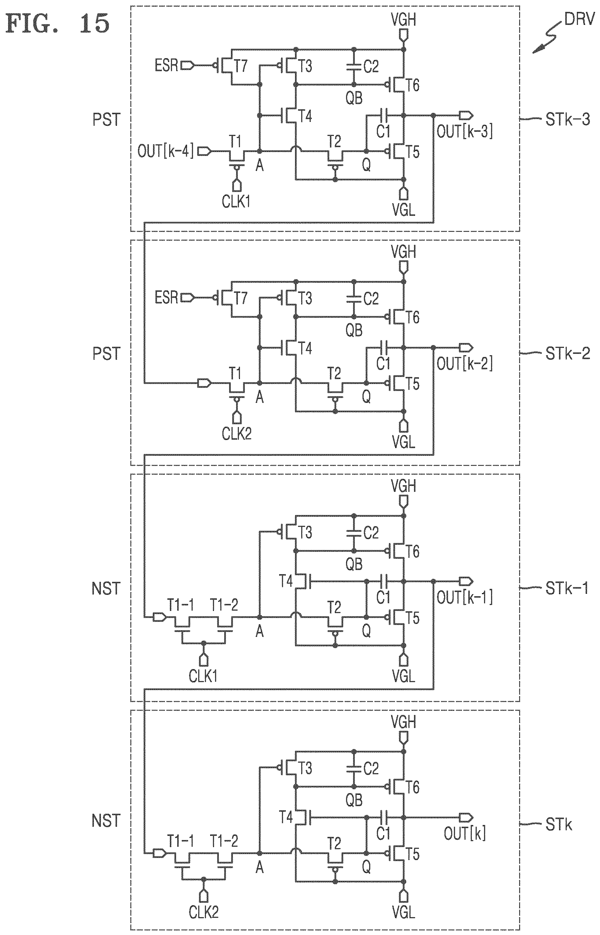

As shown in FIG. 15, the stage group may include the P stage PST shown in FIG. 7 and the N stage NST shown in FIG. 8.

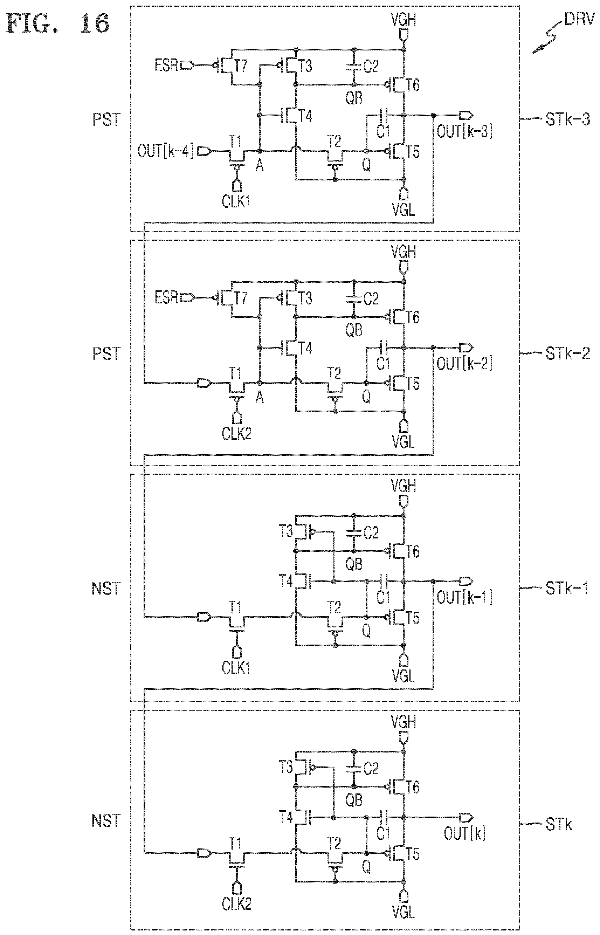

As shown in FIG. 16, the stage group may include the P stage PST shown in FIG. 7 and the N stage NST shown in FIG. 9.

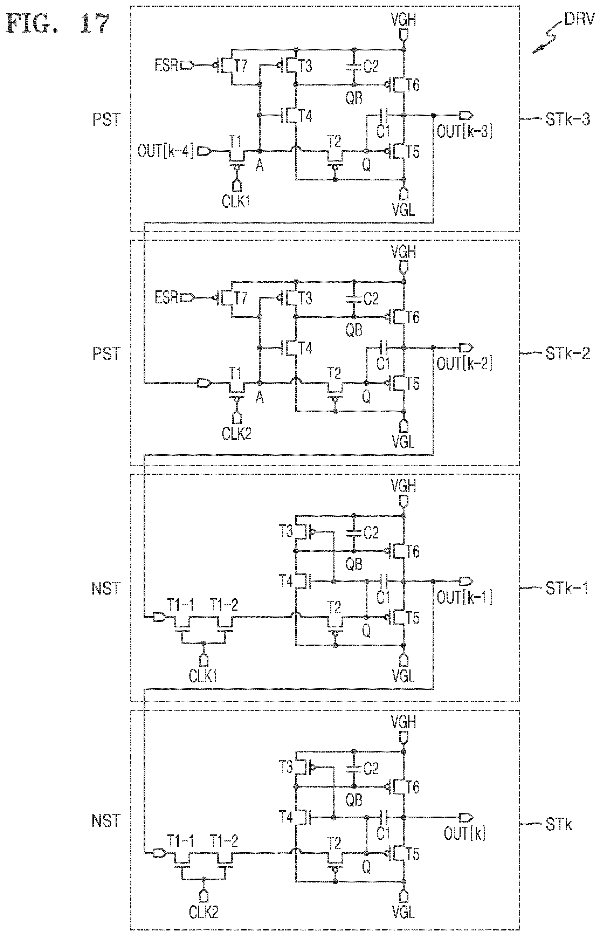

As shown in FIG. 17, the stage group may include the P stage PST shown in FIG. 7 and the N stage NST shown in FIG. 10.

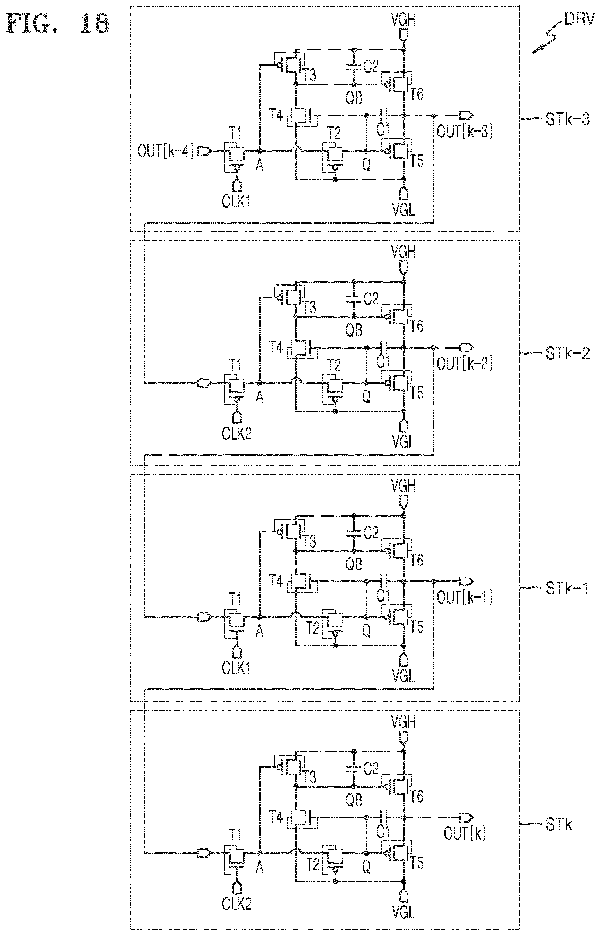

Transistors of the P stage PST and the N stage NST may each further include a back gate. First to sixth transistors T1 to T6 of the P stage PST and the N stage NST may each be a dual gate transistor including a first gate, which is a top gate arranged over a semiconductor, and a second gate, which is a bottom gate (back gate) arranged under the semiconductor. FIGS. 18 to 25 are diagrams of a stage group of a driving circuit DRV in which the first to seventh transistors T1 to T7 in FIGS. 3 and 11 to 17 are dual gate transistors, respectively.

In FIGS. 18 to 21, a first gate and a second gate of each of the first to sixth transistors T1 to T6 of each of the P stage PST and the N stage NST may be electrically connected to each other and supplied with the same voltage. In FIGS. 22 to 25, a first gate and a second gate of each of the first to sixth transistors T1 to T6 of the N stage NST may be electrically connected to each other and supplied with the same voltage. The first gate and the second gate of the first transistor T1 may be connected to the clock terminal CK. The first gate and the second gate of the second transistor T2 may be connected to the second voltage input terminal V2. The first gate and the second gate of the third transistor T3 may be connected to the first node A. The first gate and the second gate of the fourth transistor T4 may be connected to the second node Q. The first gate and the second gate of the fifth transistor T5 may be connected to the second node Q. The first gate and the second gate of the sixth transistor T6 may be connected to the third node QB.

In FIGS. 22 to 25, a first gate and a second gate of each of the first to third transistors T1 to T3 and the fifth to seventh transistors T5 to T7 of the P stage PST may be electrically connected to each other and supplied with the same voltage. The first gate and the second gate of the seventh transistor T7 may be connected to the reset terminal RS. The first gate and the second gate of the fourth transistor T4 may be connected to different nodes. The first gate of the fourth transistor T4 may be connected to the first node A, and the second gate of the fourth transistor T4 may be connected to the second node Q. Due to the second transistor T2, the voltage of the first node A and the voltage of the second node Q may be voltages at substantially the same level.

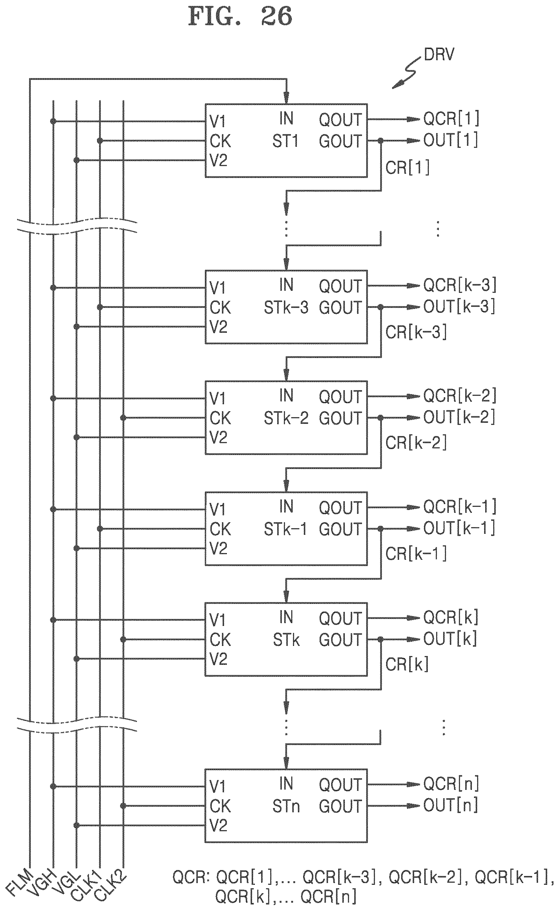

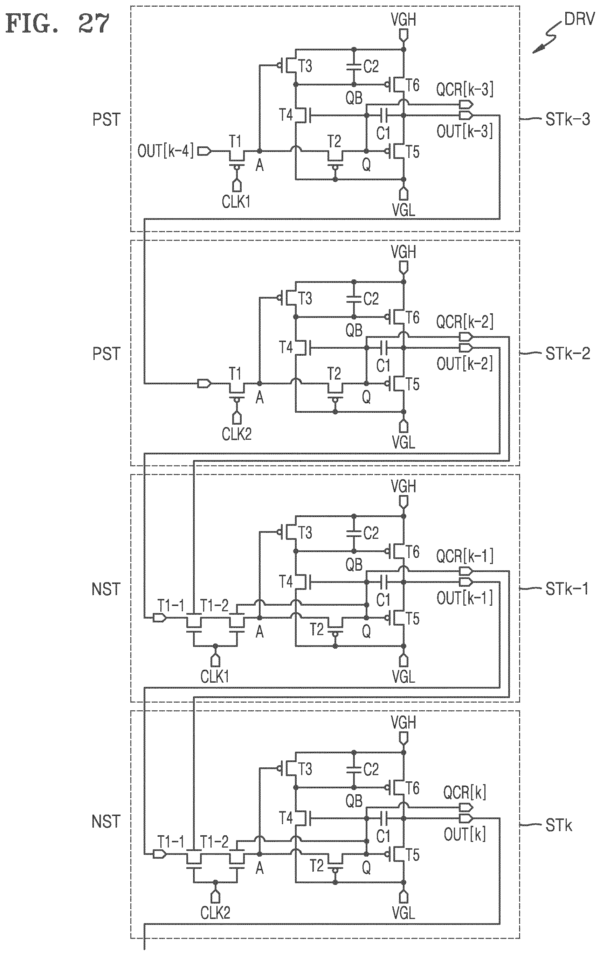

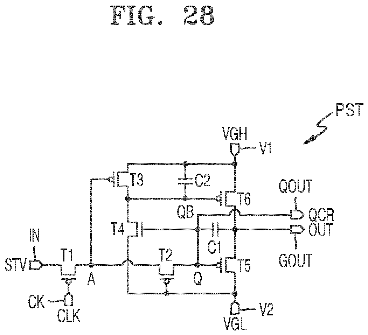

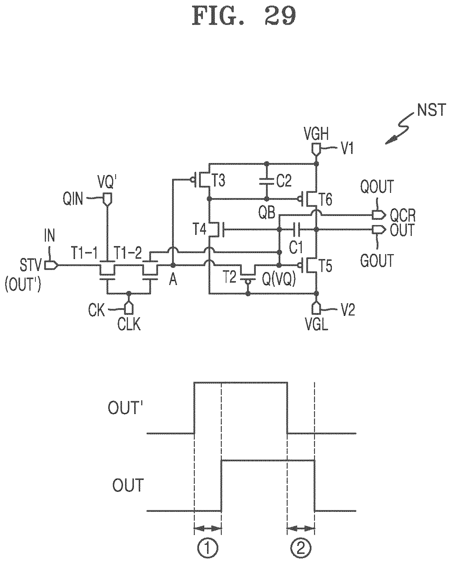

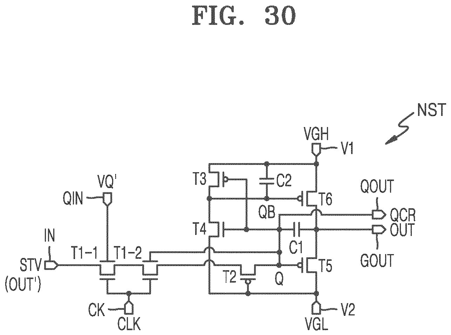

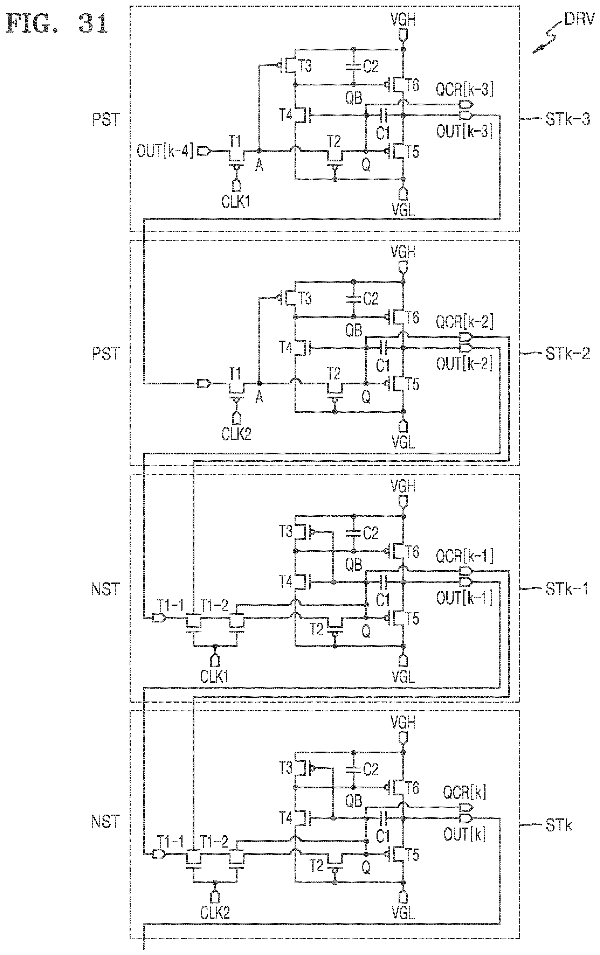

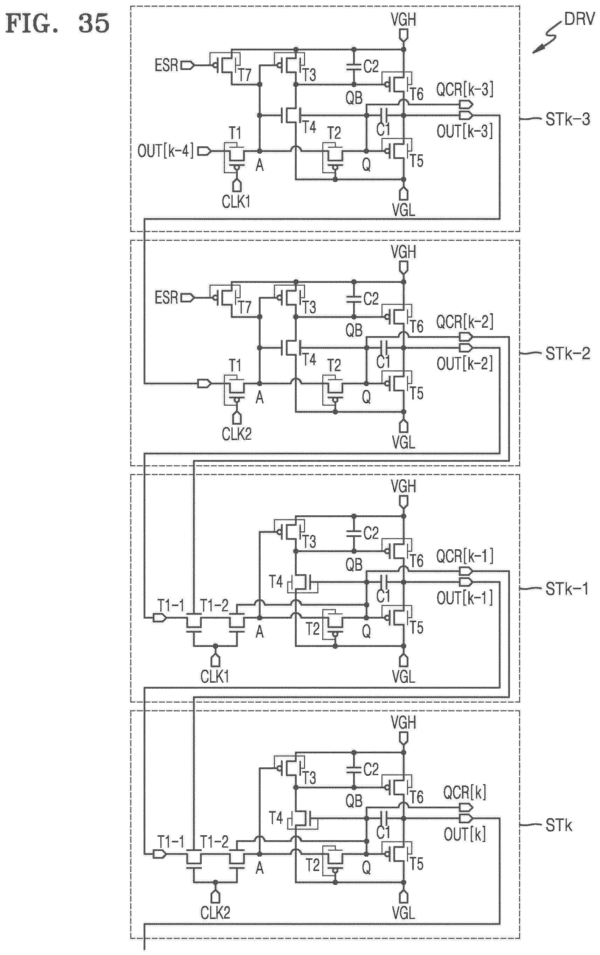

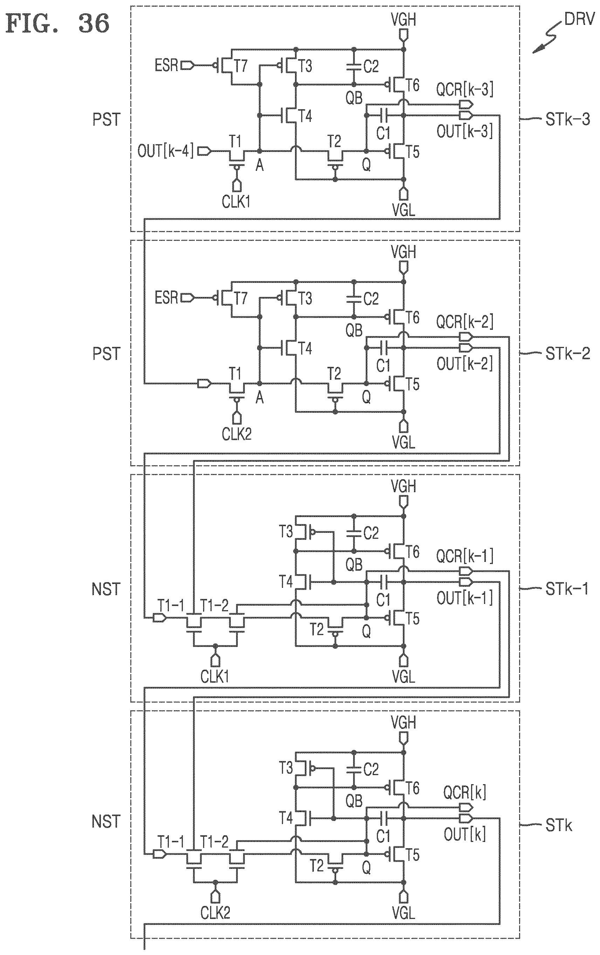

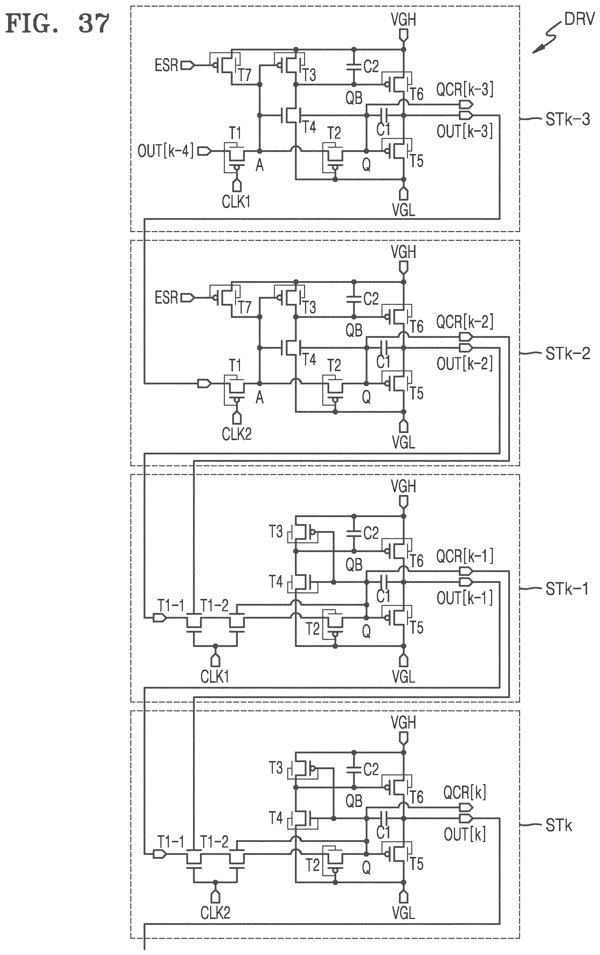

FIG. 26 is a schematic diagram of a driving circuit DRV according to another example. FIG. 27 is a diagram of an arbitrary stage group among a plurality of stages included in the driving circuit DRV of FIG. 26. FIG. 28 is a circuit diagram showing an example of a P stage PST among the stage group in FIG. 26. FIGS. 29 and 30 are circuit diagrams showing as an example of an N stage NST among the stage group in FIG. 27. FIGS. 31 to 37 are diagrams of a stage group of a driving circuit DRV, according to other examples. Hereinafter, the description will mainly focus on configurations different from those described with reference to FIGS. 3 to 6.

Referring to FIGS. 26 to 37, the driving circuit DRV may include a plurality of stages ST1 to STn. Each stage of the driving circuit DRV shown in FIG. 26 differs from the stage shown in FIG. 3 in that each stage further includes a node voltage output terminal QOUT configured to output a voltage of the second node Q as a second carry signal QCR, and other configurations are the same.

In response to a start signal, each of the plurality of stages ST1 to STn may be configured to output, to a signal line, the output signal OUT from the output terminal GOUT. The output signals OUT[1], ..., OUT[k-3], OUT[k-2], OUT[k-1], OUT[k], ..., and OUT[n-1] may be start signals STV input to input terminals IN of the second stage to the n-th stage STn, which are subsequent stages, respectively. The external signal FLM may be input as a start signal STV to the input terminal IN of the first stage ST1.

Each of the plurality of stages ST1 to STn may be configured to output, through the node voltage output terminal QOUT, the voltage of the second node Q as the second carry signal QCR.

As shown in FIG. 27, the stage group may include the P stage PST shown in FIG. 28 and the N stage NST shown in FIG. 29. The P stage PST shown in FIG. 28 differs from the P stage PST shown in FIG. 4 in that the P stage PST shown in FIG. 28 includes the node voltage output terminal QOUT configured to output the voltage of the second node Q as the second carry signal QCR, and other configurations and operations are the same. The N stage NST shown in FIG. 29 differs from the N stage NST shown in FIG. 5 in that the first transistor T1 includes a plurality of sub-transistors, and the N stage NST shown in FIG. 29 includes the node voltage output terminal QOUT configured to output the voltage of the second node Q as the second carry signal QCR and a node voltage input terminal QIN configured to receive the voltage of the second node Q from a previous stage, and other configurations and operations are the same.

In the N stage NST shown in FIG. 29, the first transistor T1 may include a plurality of sub-transistors connected in series between the input terminal IN and the first node A. The plurality of sub-transistors may include a pair of a first sub-transistor T1-1 and a second sub-transistor T1-2. Each of the first sub-transistor T1-1 and the second sub-transistor T1-2 may be a dual gate transistor including a first gate, which is a top gate arranged over a semiconductor, and a second gate, which is a bottom gate (back gate) arranged under the semiconductor. The first transistor T1 is implemented such that a plurality of N-type sub-transistors are connected in series and each sub-transistor is configured as a dual gate transistor, and thus, leakage current may be significantly reduced.

The first gate of the first sub-transistor T1-1 may be connected to the clock terminal CK, and the second gate of the first sub-transistor T1-1 may be connected to the node voltage input terminal QIN. The first gate of the second sub-transistor T1-2 may be connected to the clock terminal CK, and the second gate of the second sub-transistor T1-2 may be connected to the second node Q.

The first sub-transistor T1-1 and the second sub-transistor T1-2 may be turned on when the clock signal CLK input to the clock terminal CK is at a high level, and may be configured to transmit, to the first node A, a start signal input to the input terminal IN.

When a (-) voltage is supplied to a bottom gate of an oxide transistor, a threshold voltage increases and may be positively shifted, and when a (+) voltage is supplied, the threshold voltage decreases and may be negatively shifted.

For example, when a previous output signal OUT' of low level is input to an input terminal IN of an arbitrary N stage NST (or "current stage") and an output signal OUT of low level is output, a voltage VQ' (or "previous second node voltage") of a second node Q of low level of a previous stage may be input to the second gate of the first sub-transistor T1-1, and a voltage VQ of a second node Q of low level of the current stage may be input to the second gate of the second sub-transistor T1-2. In this case, the threshold voltages of the first sub-transistor T1-1 and the second sub-transistor T1-2 are positively shifted such that leakage current may be reduced.

In addition, when a previous output signal OUT' of high level is input to the input terminal IN of the current stage and an output signal OUT of high level is output, a previous second node voltage VQ' of high level may be input to the second gate of the first sub-transistor T1-1, and a voltage VQ of a second node Q of high level of the current stage may be input to the second gate of the second sub-transistor T1-2. In this case, the threshold voltages of the first sub-transistor T1-1 and the second sub-transistor T1-2 are negatively shifted such that a current transmitted through the first transistor T1 may increase, thereby increasing the charging ability of the second node Q.

Also, in a period ①, when the previous output signal OUT' of high level is input to the input terminal IN of the current stage and the output signal OUT of low level is output, the previous second node voltage VQ' of high level may be input to the second gate of the first sub-transistor T1-1, and the voltage VQ of the second node Q of low level of the current stage may be input to the second gate of the second sub-transistor T1-2. In this case, the threshold voltage of the first sub-transistor T1-1 may be negatively shifted, and the threshold voltage of the second sub-transistor T1-2 may be positively shifted.

Also, in a period ②, when the previous output signal OUT' of low level is input to the input terminal IN of the current stage and the output signal OUT of high level is output, a previous second node voltage VQ' of low level may be input to the second gate of the first sub-transistor T1-1, and the voltage VQ of the second node Q of high level of the current stage may be input to the second gate of the second sub-transistor T1-2. In this case, the threshold voltage of the first sub-transistor T1-1 may be positively shifted, and the threshold voltage of the second sub-transistor T1-2 may be negatively shifted.

In the periods ① and ②, voltages of different levels are input to the second gate of the first sub-transistor T1-1 and the second gate of the second sub-transistor T1-2, and thus, leakage current may be reduced.

As shown in FIGS. 30 and 31, in the N stage NST, the gate of the third transistor T3 may be connected to the second node Q. The third transistor T3 may be turned on when a voltage of the second node Q is at a low level, and may be configured to transmit the first voltage VGH to the third node QB.

Only some of second carry signals QCR[1], ..., QCR[k-3], QCR[k-2], QCR[k-1], QCR[k], ..., and QCR[n] output from the plurality of stages ST1 to STn may be input to a subsequent stage. For example, only N stages NST among the plurality of stages ST1 to STn may include the node voltage input terminal QIN and be configured to receive the previous second node voltage VQ' as the second carry signal QCR.

The stage group shown in each of FIGS. 27 to 31 may operate according to the timing diagram shown in FIG. 6.

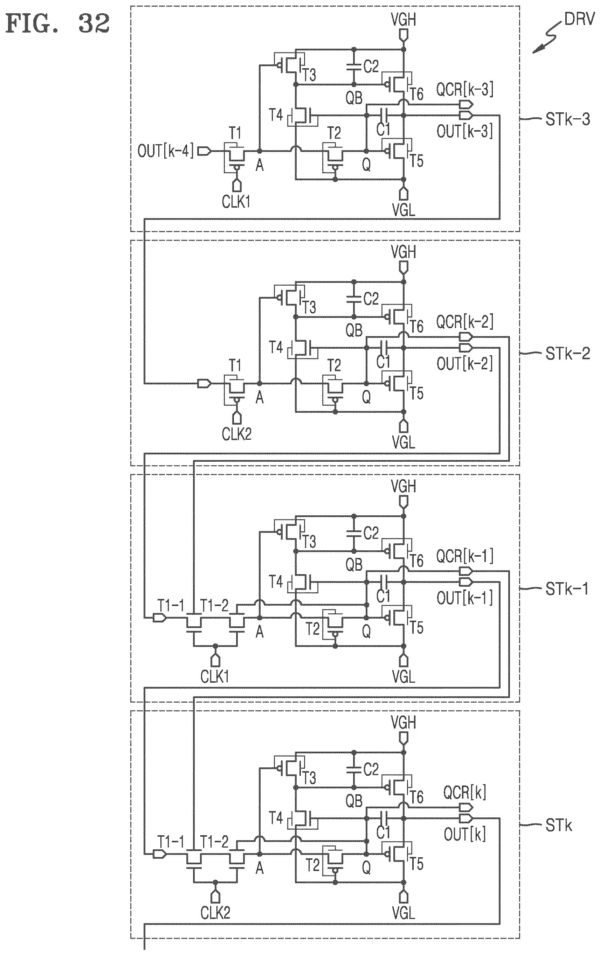

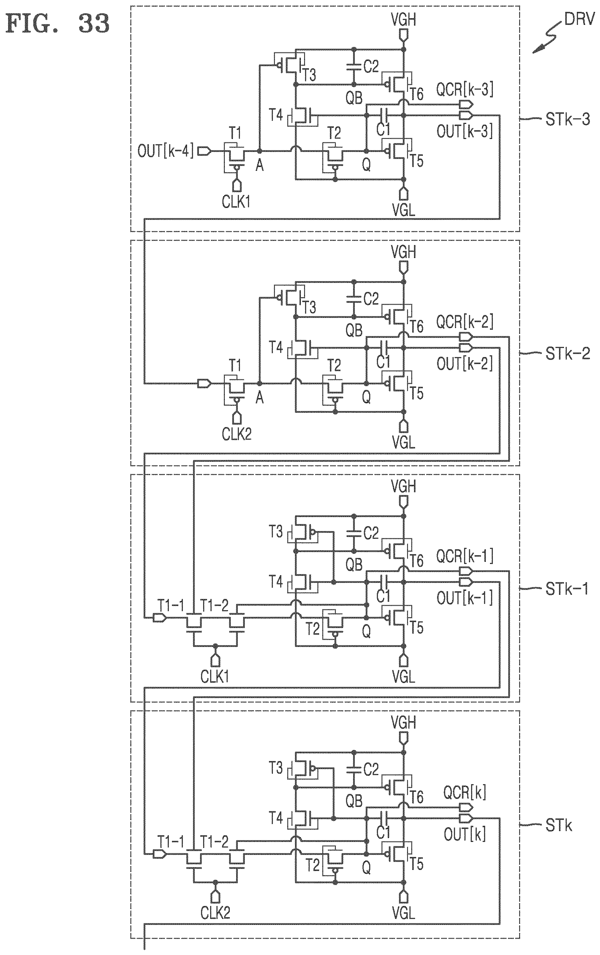

The transistors of each of the P stage PST and the N stage NST may each be a dual gate transistor including a first gate, which is a top gate arranged over a semiconductor, and a second gate, which is a bottom gate (back gate) arranged under the semiconductor. FIGS. 32 and 33 are diagrams of a stage group of the driving circuit DRV in which transistors in FIGS. 27 and 31 are dual gate transistors, respectively.

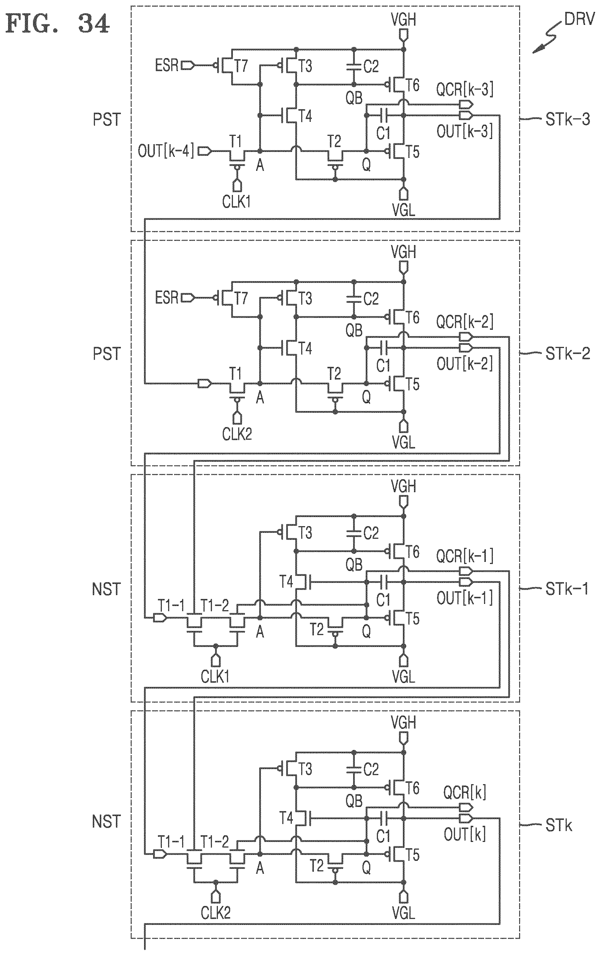

The stage group of the driving circuit DRV shown in FIG. 26 is not limited to the stage group shown in FIGS. 27 and 31 to 33. For example, as shown in FIGS. 34 to 37, the stage group of the driving circuit DRV may include the P stage PST shown in FIG. 7.

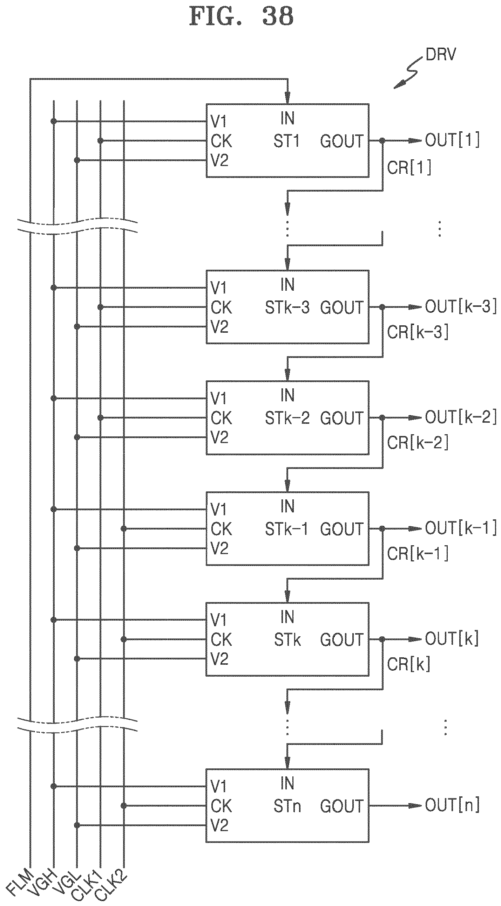

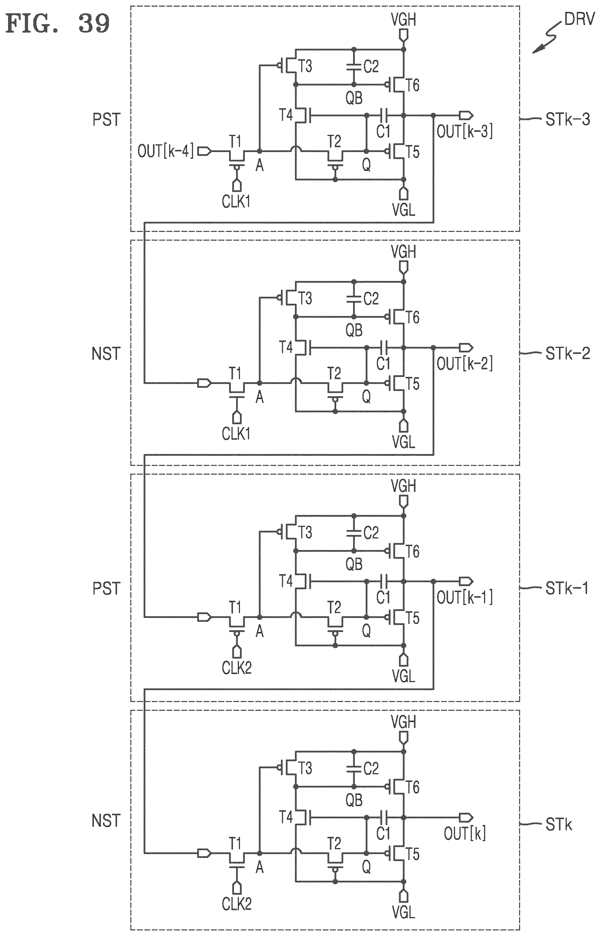

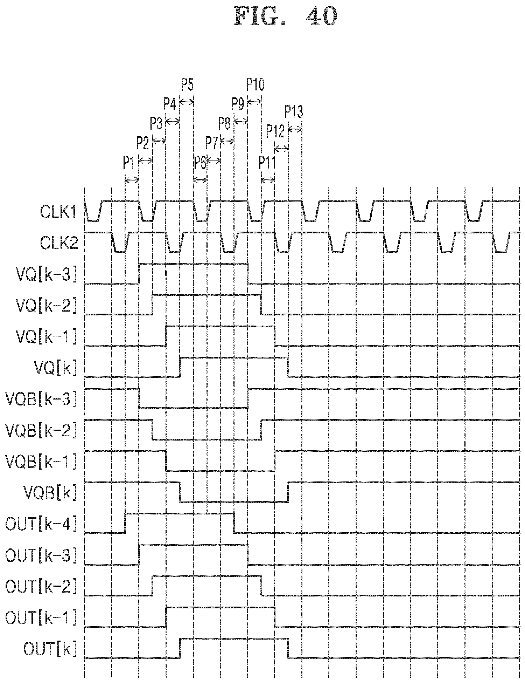

FIG. 38 is a schematic diagram of a driving circuit DRV according to still another example. FIG. 39 is a diagram of an arbitrary stage group among a plurality of stages included in the driving circuit DRV of FIG. 38. FIG. 40 is a timing diagram for describing driving of the stage group of FIG. 39. Hereinafter, the description will mainly focus on configurations different from those described in the aforementioned examples.

Referring to FIGS. 38 to 40, the driving circuit DRV may include a plurality of stages ST1 to STn. As shown in FIG. 39, the driving circuit DRV shown in FIG. 38 may be a shift register in which the P stage PST shown in FIG. 4 and the N stage NST shown in FIG. 5 are alternately arranged and are cascade-connected.

The stage groups may include a first stage group and a second stage group arranged consecutively to the first stage group. The first stage group and the second stage group may each include an odd-numbered P stage PST and an even-numbered N stage NST.

By alternately arranging a plurality of stages that constitute the driving circuit DRV into P stages and N stages, compared to a driving circuit including only P stages, the clock frequency may be reduced, thereby reducing power consumption.

The first clock signal CLK1 or the second clock signal CLK2 may be input to the clock terminal CK of each of the plurality of stages ST1 to STn. The first clock signal CLK1 or the second clock signal CLK2 may be input to clock terminals CK of consecutive odd-numbered stages and even-numbered stages in the stage group. For example, the first clock signal CLK1 may be input to clock terminals CK of a first P stage PST and a second N stage NST, and the second clock signal CLK2 may be input to clock terminals CK of a third P stage PST and a fourth N stage NST.

As shown in FIG. 40, the first clock signal CLK1 and the second clock signal CLK2 may be square wave signals that repeat a high-level voltage and a low-level voltage. The first clock signal CLK1 and the second clock signal CLK2 may be square wave signals that repeat the first voltage VGH and the second voltage VGL. The first clock signal CLK1 and the second clock signal CLK2 may be signals that have the same waveform and are phase-shifted. For example, the second clock signal CLK2 may have the same waveform as the first clock signal CLK1 and may be input by being phase-shifted (phase-delayed) at certain intervals. The second clock signal CLK2 may be shifted by a 1/2 cycle from the first clock signal CLK1. In the first clock signal CLK1 and the second clock signal CLK2, a period during which a high-level voltage is maintained may be longer than a period during which a low-level voltage is maintained.

The stages ST1 to STn may be configured to shift the output signals OUT[1], ..., OUT[k-3], OUT[k-2], OUT[k-1], OUT[k], ..., and OUT[n] having a high-level voltage by a 1/4 cycle of the clock signal and sequentially output the same.

Hereinafter, the operation of the stage group shown in FIG. 39 will be described with reference to FIG. 40.

During a first period P1 to an eighth period P8, the previous output signal OUT[k-4] of high level, which is a start signal, may be supplied to the input terminal IN of the (k-3)-th stage STk-3.

In the first period P1, the first clock signal CLK1 of high level is input to the clock terminal CK of the (k-3)-th stage STk-3, and accordingly, the first transistor T1 of the (k-3)-th stage STk-3 remains turned off, the first node A and the second node Q maintain the same low-level voltage as in a previous period, and the fifth transistor T5 is turned on. Thus, the second voltage VGL of low level may be output as the (k-3)-th output signal OUT[k-3] from the output terminal GOUT. The voltage of the third node QB may be a high-level voltage due to the turned-on third transistor T3.

In the second period P2, the first clock signal CLK1 of low level is input to the clock terminal CK of the (k-3)-th stage STk-3, and accordingly, the first transistor T1 of the (k-3)-th stage STk-3 may be turned on. Due to the turned-on first transistor T1 and the second transistor T2, the previous output signal OUT[k-4] of high level may be transmitted to the first node A and the second node Q of the (k-3)-th stage STk-3, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In the third period P3, the fourth period P4, and the fifth period P5, the first clock signal CLK1 of high level is input to the clock terminal CK of the (k-3)-th stage STk-3, and accordingly, the first transistor T1 may be turned off. Because the first node A and the second node Q maintain a high-level voltage in the second period P2 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

Because the operation of the (k-3)-th stage STk-3 during the sixth period P6 to the ninth period P9 is the same as the operation of the (k-3)-th stage STk-3 during the second period P2 to the fifth period P5, a detailed description thereof is omitted.

In the ninth period P9, the previous output signal OUT[k-4] transitions from high level to low level and is supplied to the input terminal IN of the (k-3)-th stage STk-3, but the first clock signal CLK1 of high level is input to the clock terminal CK of the (k-3)-th stage STk-3 such that the first transistor T1 is turned off. Thus, regardless of the voltage level of the start signal, the operation of the (k-3)-th stage STk-3 may be the same as the operation of the (k-3)-th stage STk-3 during the fifth period P5. Accordingly, the output signal OUT[k-3] of high level may be output from the output terminal GOUT of the (k-3)-th stage STk-3.

In a tenth period P10, the previous output signal OUT[k-4] of low level may be supplied to the input terminal IN of the (k-3)-th stage STk-3. The first transistor T1 of the (k-3)-th stage STk-3 may be turned on by the first clock signal CLK1 of low level. The second transistor T2 may be in a state being turned on by the second voltage VGL of low level. Due to the turned-on first transistor T1 and the second transistor T2, the previous output signal OUT[k-4] of low level may be transmitted to the first node A and the second node Q of the (k-3)-th stage STk-3, and the fifth transistor T5 may be turned on. Accordingly, the second voltage VGL of low level may be output as the output signal OUT[k-3] from the output terminal GOUT of the (k-3)-th stage STk-3. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the second period P2 to the ninth period P9, the previous output signal OUT[k-3] of high level, which is a start signal from the (k-3)-th stage STk-3, may be supplied to the input terminal IN of the (k-2)-th stage STk-2.

In the second period P2, the first clock signal CLK1 of low level is input to the clock terminal CK of the (k-2)-th stage STk-2, and accordingly, the first transistor T1 is turned off, the first node A and the second node Q maintain the same low-level voltage as in a previous period, and the fifth transistor T5 is turned on. Thus, the second voltage VGL of low level may be output as the (k-2)-th output signal OUT[k-2] from the output terminal GOUT. The voltage of the third node QB may be a high-level voltage due to the turned-on third transistor T3.

In the third period P3, the fourth period P4, and the fifth period P5, the first clock signal CLK1 of high level is input to the clock terminal CK of the (k-2)-th stage STk-2, and accordingly, the first transistor T1 may be turned on. Due to the turned-on first transistor T1 and the second transistor T2, the previous output signal OUT[k-3] of high level may be transmitted to the first node A and the second node Q of the (k-2)-th stage STk-2, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-2] of high level may be output from the output terminal GOUT of the (k-2)-th stage STk-2.

In the sixth period P6, the first clock signal CLK1 of low level is input to the clock terminal CK of the (k-2)-th stage STk-2, and thus, the first transistor T1 may be turned off. Because the first node A and the second node Q maintain a high-level voltage in the fifth period P5 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-2] of high level may be output from the output terminal GOUT of the (k-2)-th stage STk-2.

Because the operation of the (k-2)-th stage STk-2 during the seventh period P7 to the ninth period P9 is the same as the operation of the (k-2)-th stage STk-2 during the third period P3 to the fifth period P5, a detailed description thereof is omitted.

In the tenth period P10, the previous output signal OUT[k-3] transitions from high level to low level and is supplied to the input terminal IN of the (k-2)-th stage STk-2, but the first clock signal CLK1 of low level is input to the clock terminal CK of the (k-2)-th stage STk-2 such that the first transistor T1 is turned off. Thus, regardless of the voltage level of the start signal, the operation of the (k-2)-th stage STk-2 may be the same as the operation of the (k-2)-th stage STk-2 during the sixth period P6. Accordingly, the output signal OUT[k-2] of high level may be output from the output terminal GOUT of the (k-2)-th stage STk-2.

In the eleventh period P11, the previous output signal OUT[k-3] of low level may be supplied to the input terminal IN of the (k-2)-th stage STk-2, and the first clock signal CLK1 of high level may be input to the clock terminal CK. Due to the first clock signal CLK1 of high level, the first transistor T1 may be turned on, and due to the turned-on first transistor T1 and second transistor T2, the previous output signal OUT[k-3] of low level may be transmitted to the first node A and the second node Q of the (k-2)-th stage STk-2, and the fifth transistor T5 may be turned on. Accordingly, the second voltage VGL of low level may be output as the output signal OUT[k-2] from the output terminal GOUT of the (k-2)-th stage STk-2. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the third period P3 to the tenth period P10, the previous output signal OUT[k-2] of high level, which is a start signal from the (k-2)-th stage STk-2, may be supplied to the input terminal IN of the (k-1)-th stage STk-1. Because the operation of the (k-1)-th stage STk-1 during the third period P3 to the twelfth period P12 is the same as the operation of the (k-3)-th stage STk-3 during the first period P1 to the tenth period P10, a detailed description thereof is omitted.

During the fourth period P4 to the eleventh period P11, the previous output signal OUT[k-1] of high level, which is a start signal from the (k-1)-th stage STk-1, may be supplied to the input terminal IN of the k-th stage STk. Because the operation of k-th stage STk during the fourth period P4 to the thirteenth period P13 is the same as the operation of the (k-2)-th stage STk-2 during the second period P2 to the eleventh period P11, a detailed description thereof is omitted.

The stage group of the driving circuit DRV shown in FIG. 38 is not limited to the stage group shown in FIG. 39. For example, the stage group of the driving circuit DRV shown in FIG. 38 may be composed of a combination of one of the P stages PST shown in FIGS. 4 and 7 and one of the N stages NST shown in FIGS. 5 and 8 to 10.

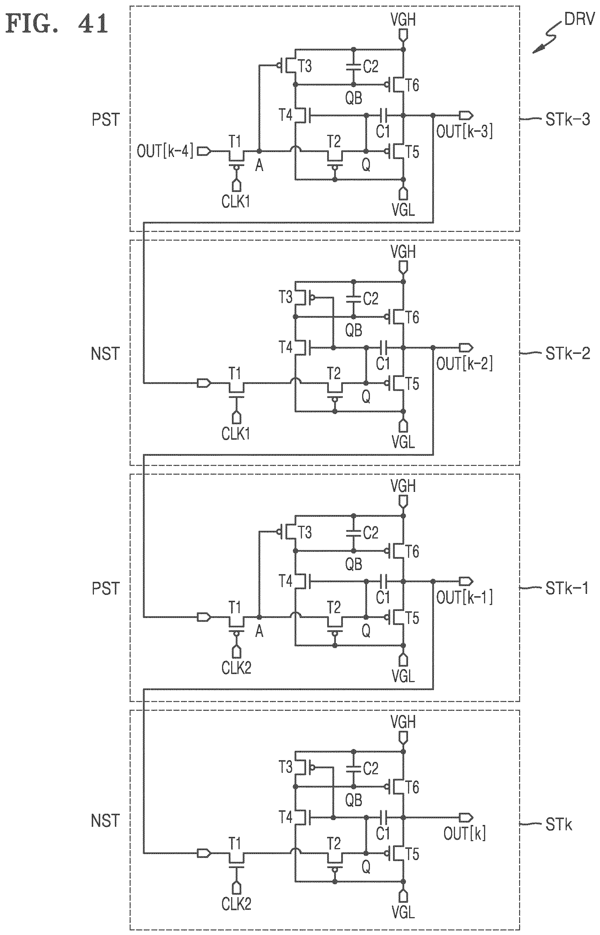

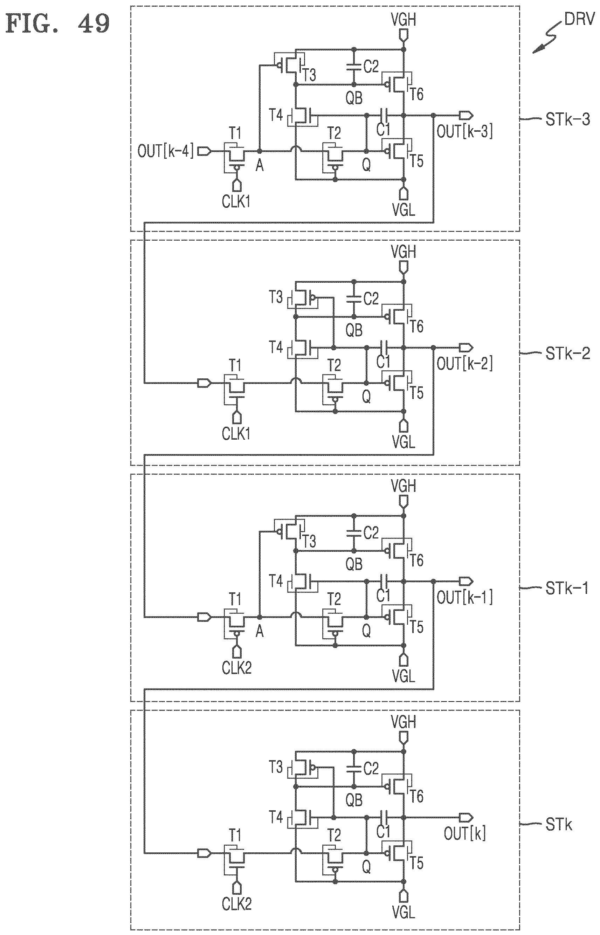

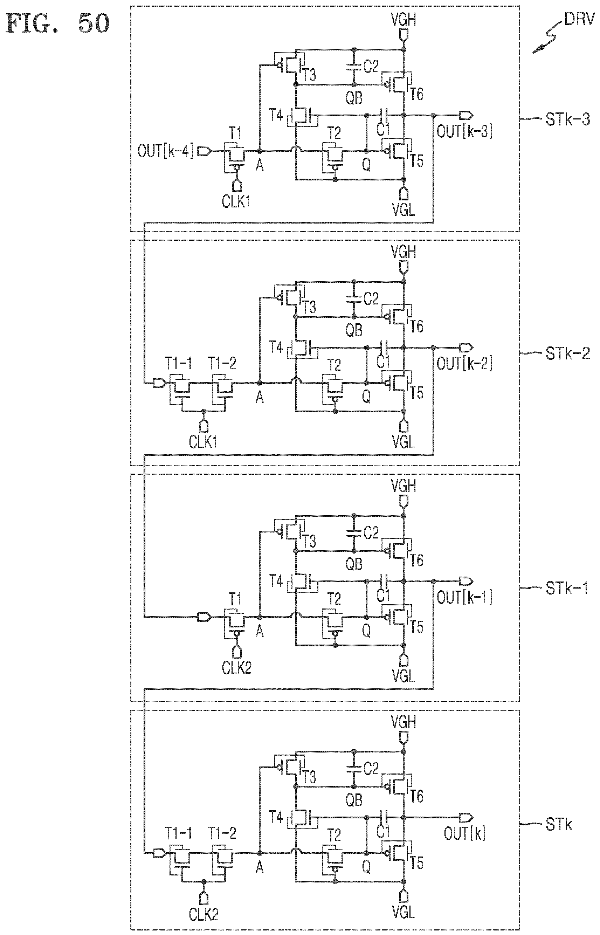

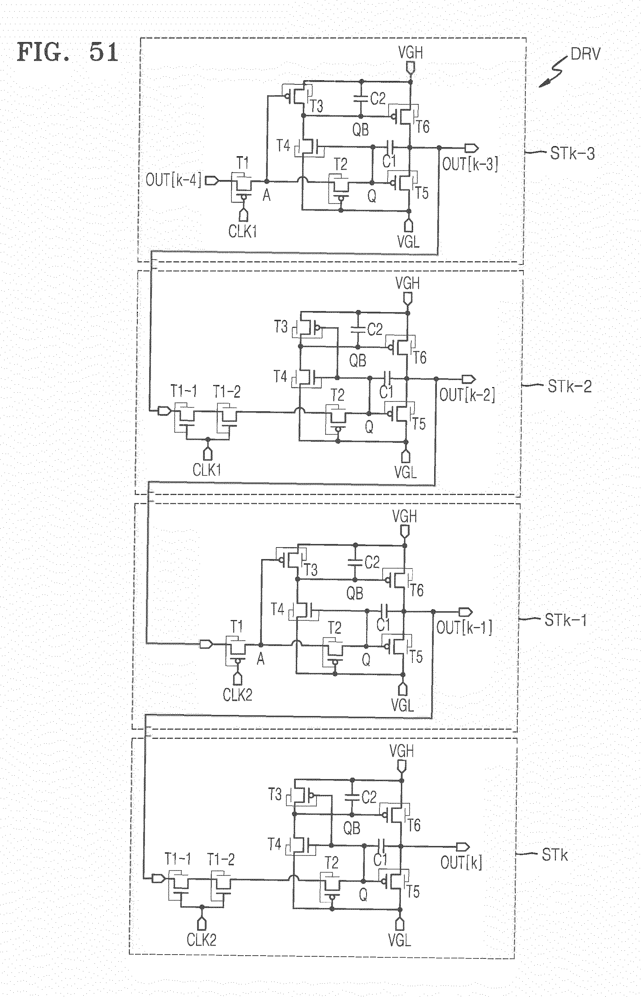

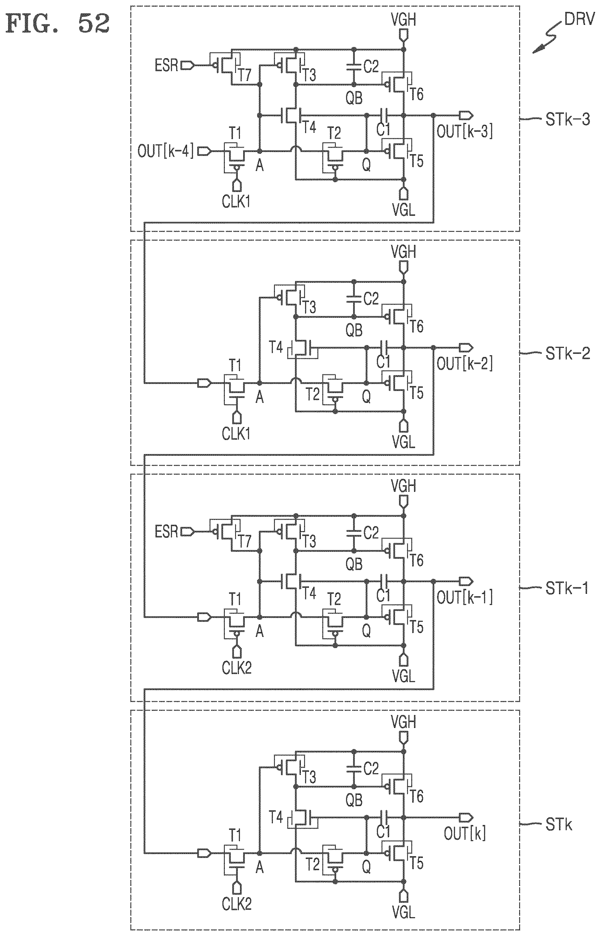

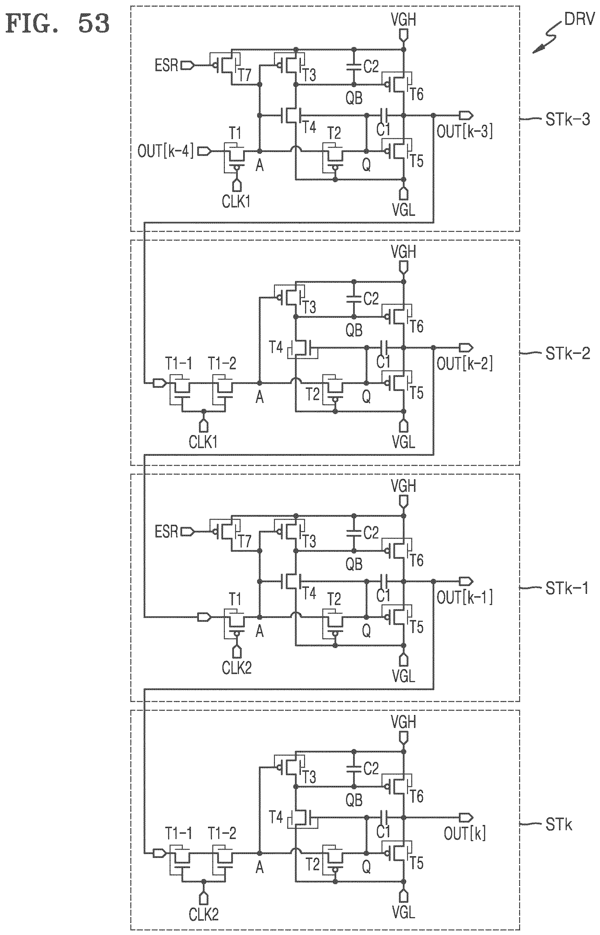

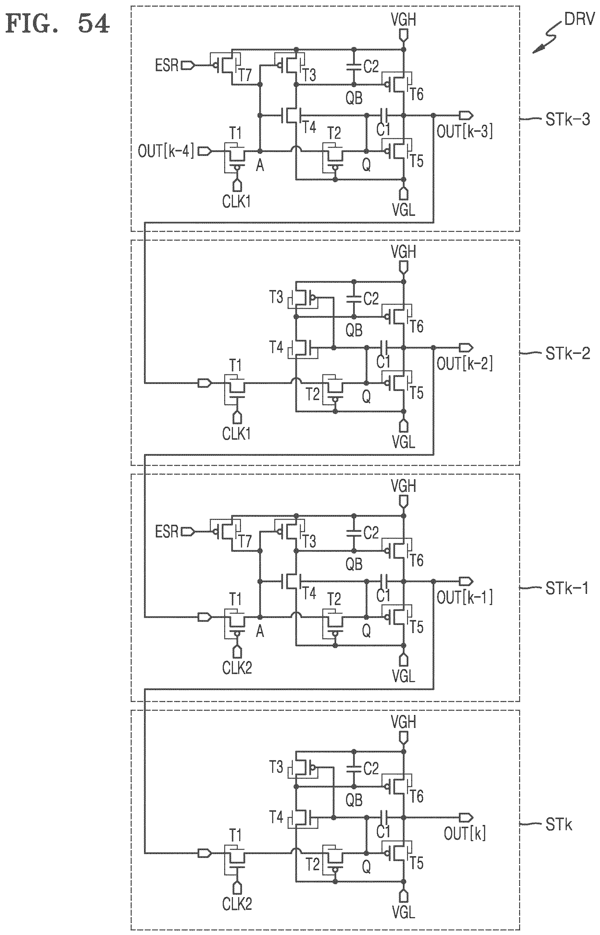

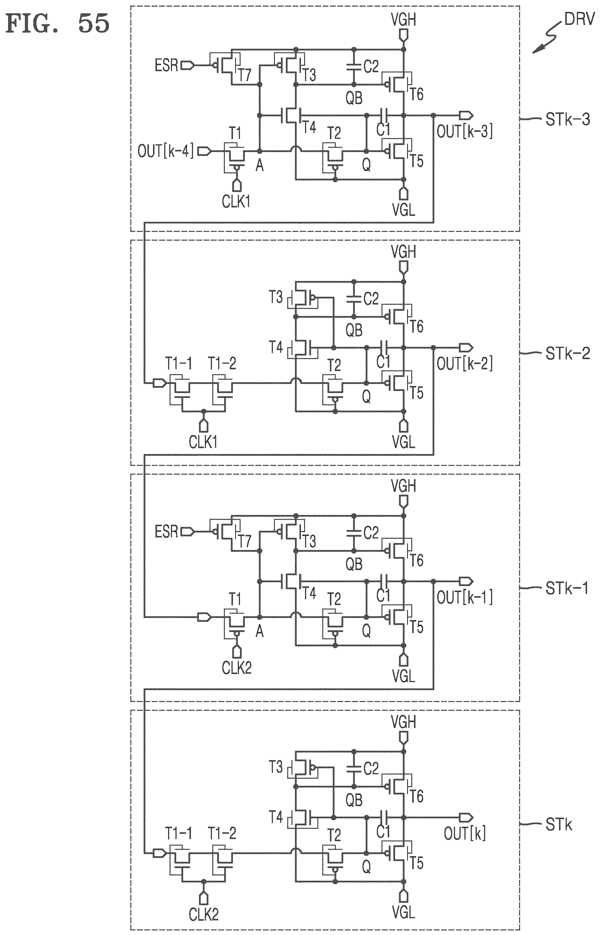

FIGS. 41 to 55 are diagrams of a stage group of a driving circuit DRV, according to other examples. The driving circuit DRV shown in FIGS. 41 to 55 may have a structure in which a stage group in which P stages PST and N stages NST are alternately arranged is repeatedly arranged.

As shown in FIG. 41, the stage group may include the P stage PST shown in FIG. 4 and the N stage NST shown in FIG. 9.

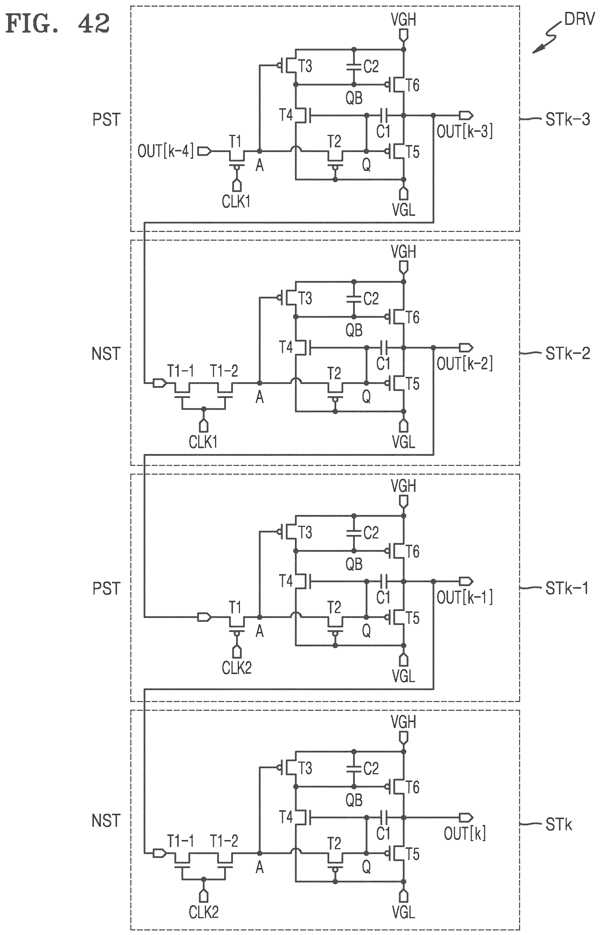

As shown in FIG. 42, the stage group may include the P stage PST shown in FIG. 4 and the N stage NST shown in FIG. 8.

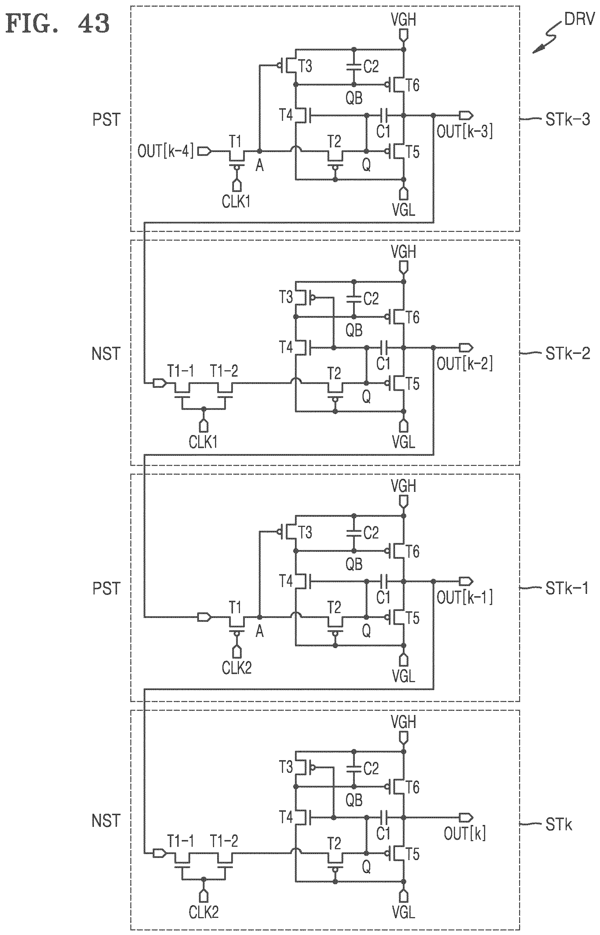

As shown in FIG. 43, the stage group may include the P stage PST shown in FIG. 4 and the N stage NST shown in FIG. 10.

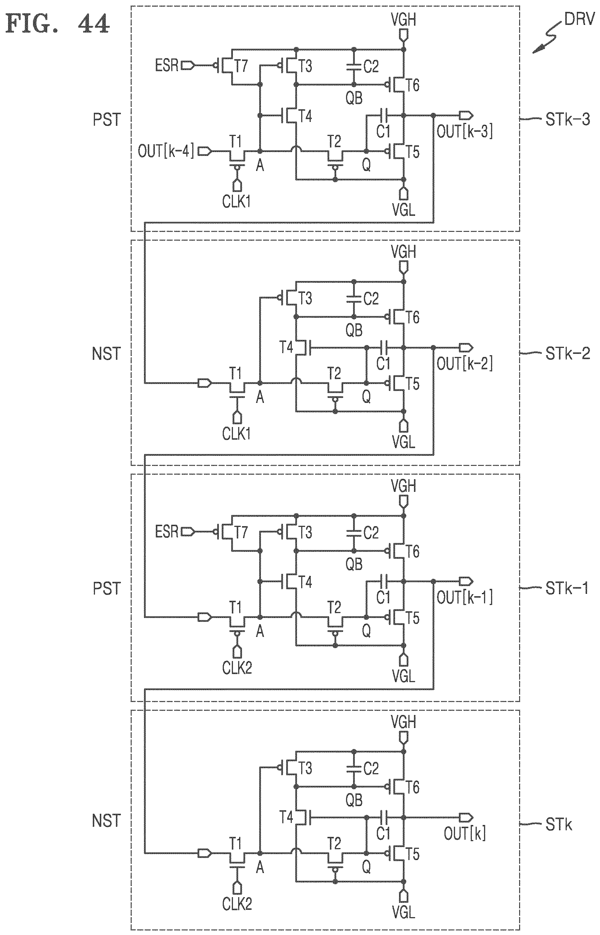

As shown in FIG. 44, the stage group may include the P stage PST shown in FIG. 7 and the N stage NST shown in FIG. 5.

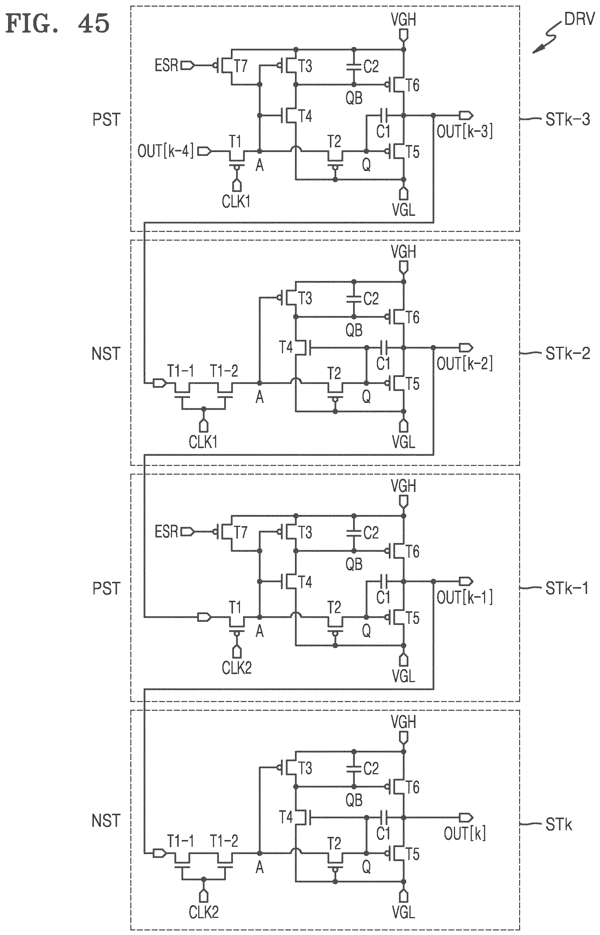

As shown in FIG. 45, the stage group may include the P stage PST shown in FIG. 7 and the N stage NST shown in FIG. 8.

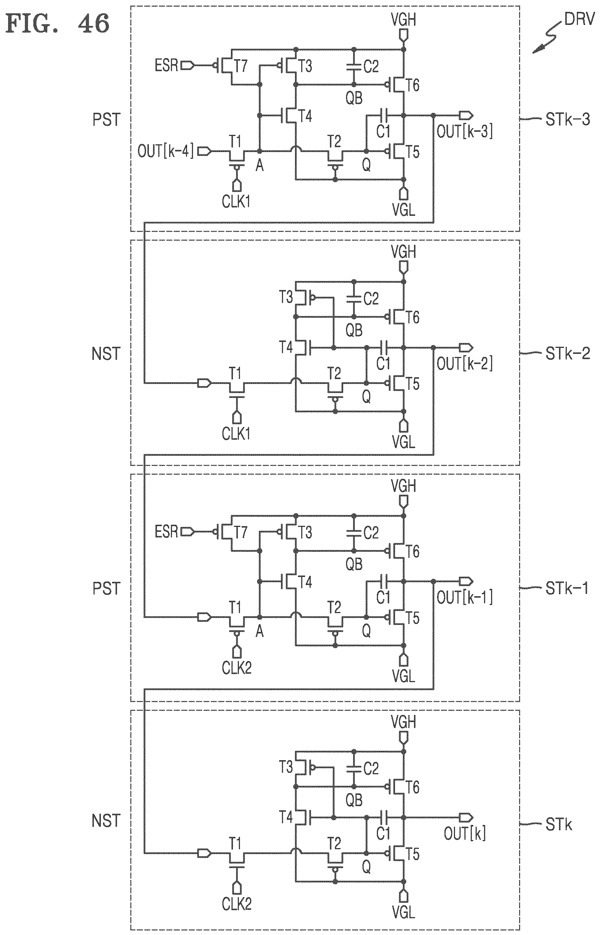

As shown in FIG. 46, the stage group may include the P stage PST shown in FIG. 7 and the N stage NST shown in FIG. 9.

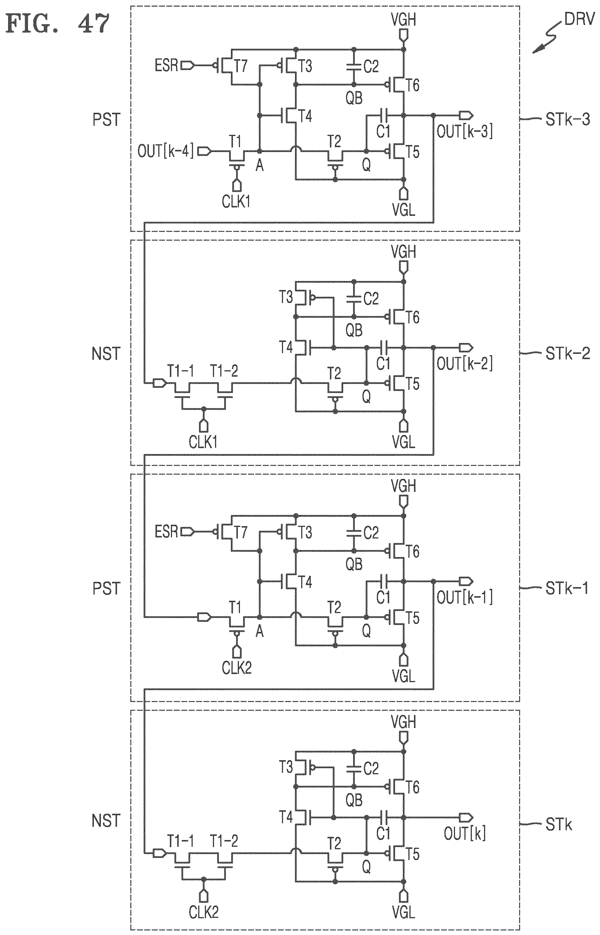

As shown in FIG. 47, the stage group may include the P stage PST shown in FIG. 7 and the N stage NST shown in FIG. 10.

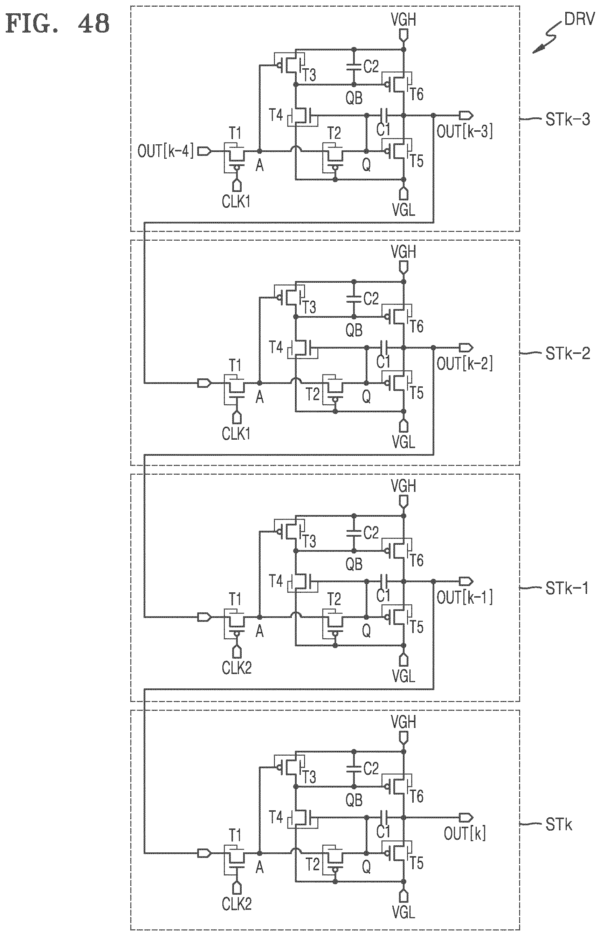

FIGS. 48 to 55 are diagrams of a stage group of the driving circuit DRV in which transistors in FIGS. 39 and 41 to 47 are dual gate transistors, respectively.

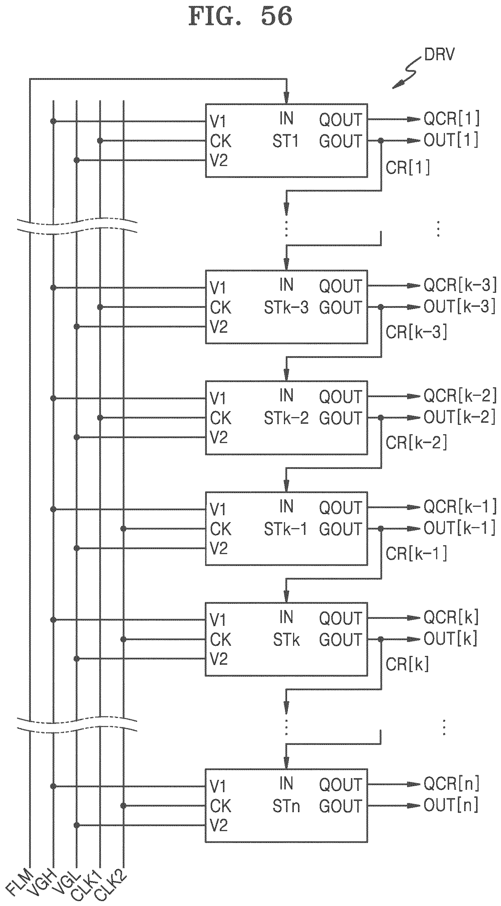

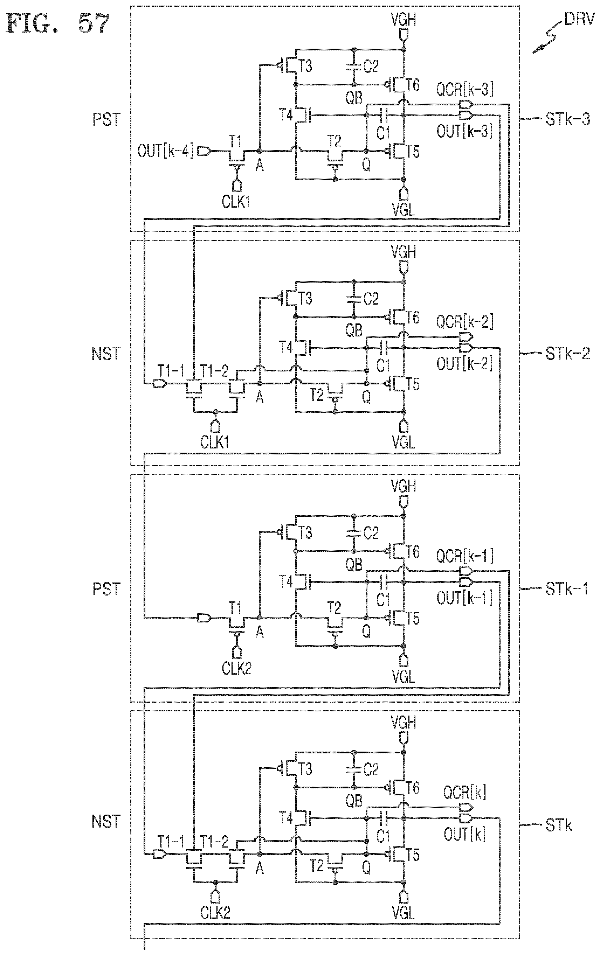

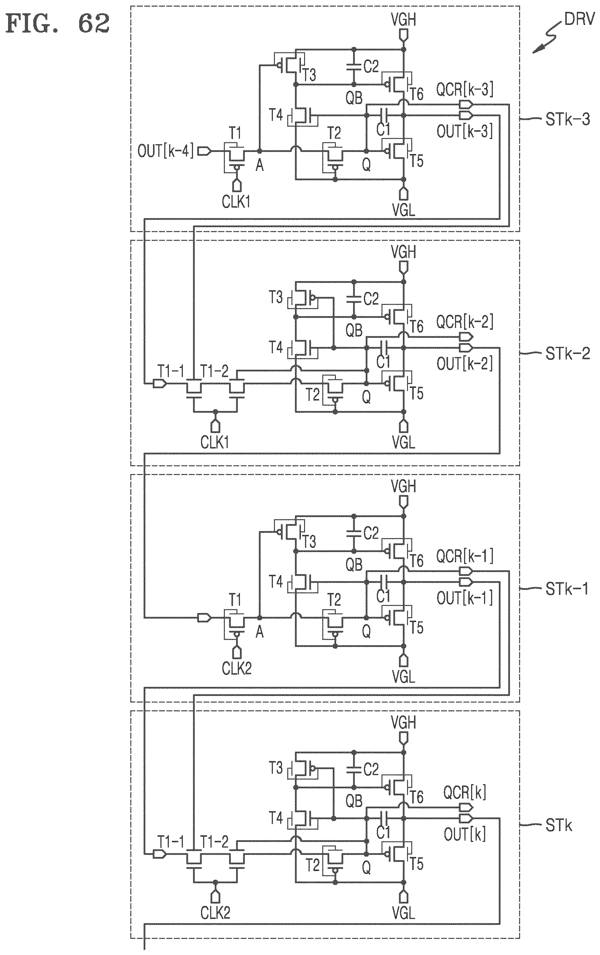

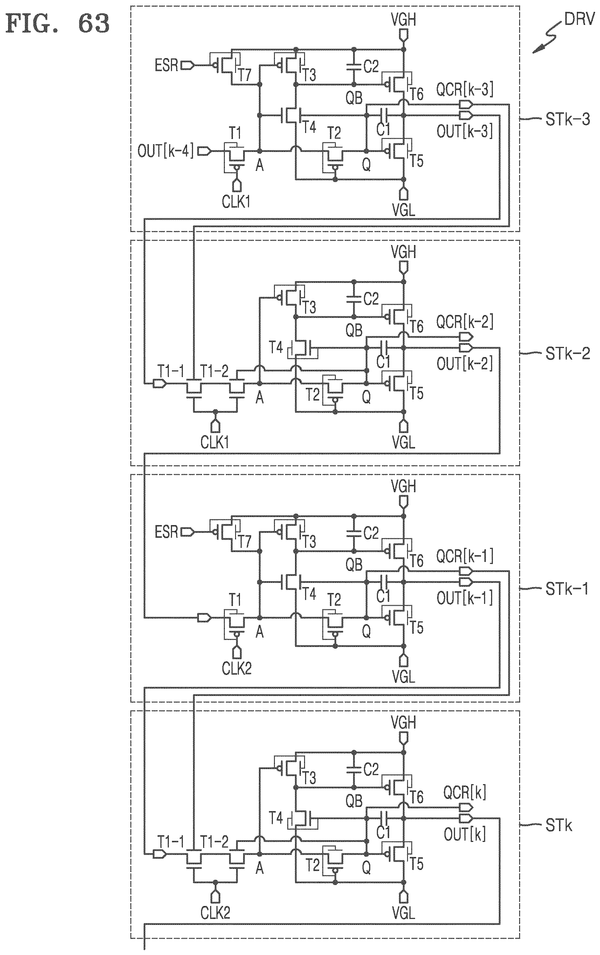

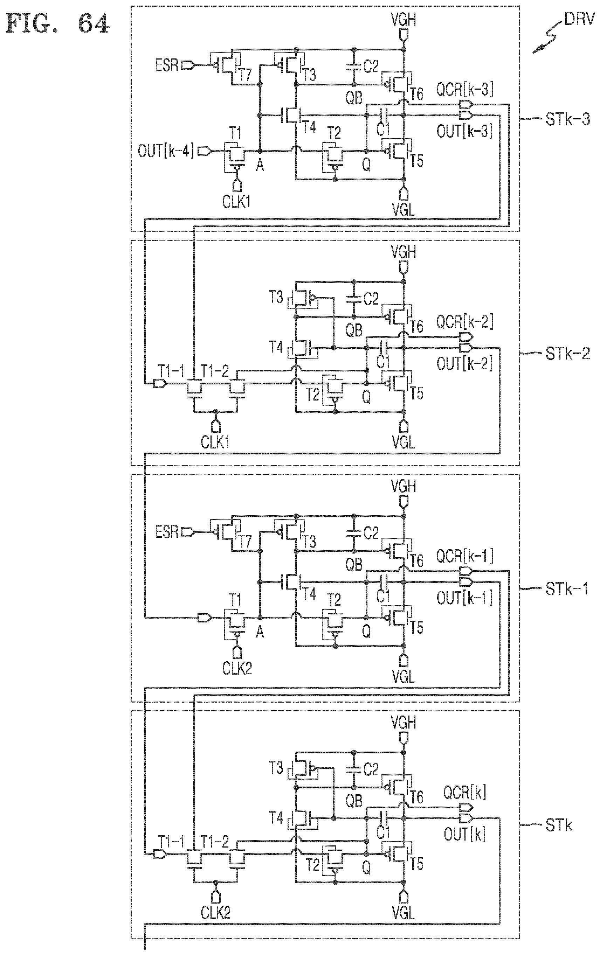

FIG. 56 is a schematic diagram of a driving circuit DRV according to yet another example. FIGS. 57 to 64 are diagrams of an arbitrary stage group among a plurality of stages included in the driving circuit DRV of FIG. 56.

The driving circuit DRV shown in FIG. 56 differs from the driving circuit DRV shown in FIG. 38 in that each stage further includes the node voltage output terminal QOUT configured to output the voltage of the second node Q as a corresponding one of the second carry signals QCR[1] to QCR[n], and other configurations are the same.

For example, the stage group of the driving circuit DRV shown in FIG. 56 may be composed of a combination of one of the P stages PST shown in FIGS. 4 and 7 and one of the N stages NST shown in FIGS. 29 and 30.

As shown in FIG. 57, the stage group may include the P stage PST shown in FIG. 4 and the N stage NST shown in FIG. 29.

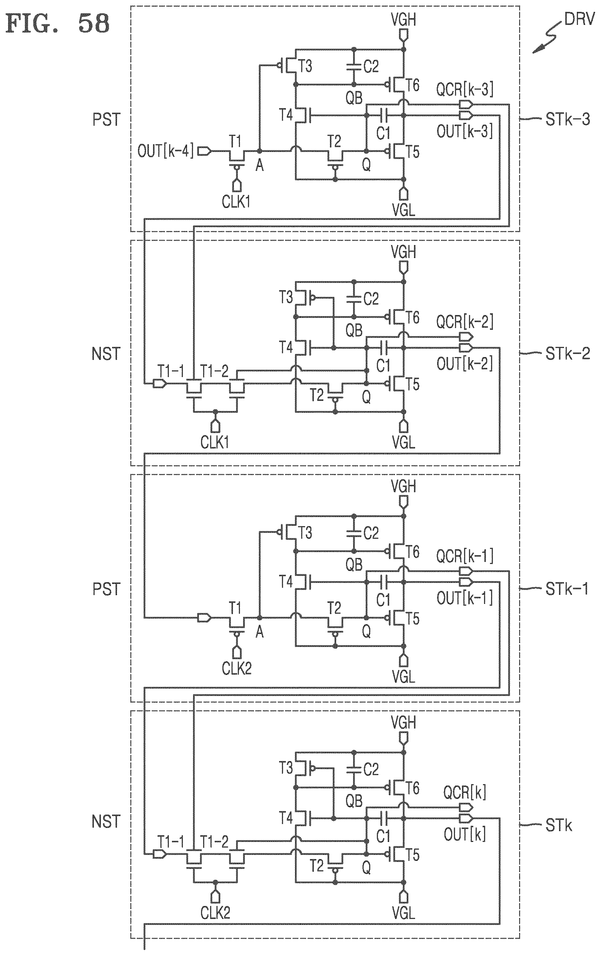

As shown in FIG. 58, the stage group may include the P stage PST shown in FIG. 4 and the N stage NST shown in FIG. 30.

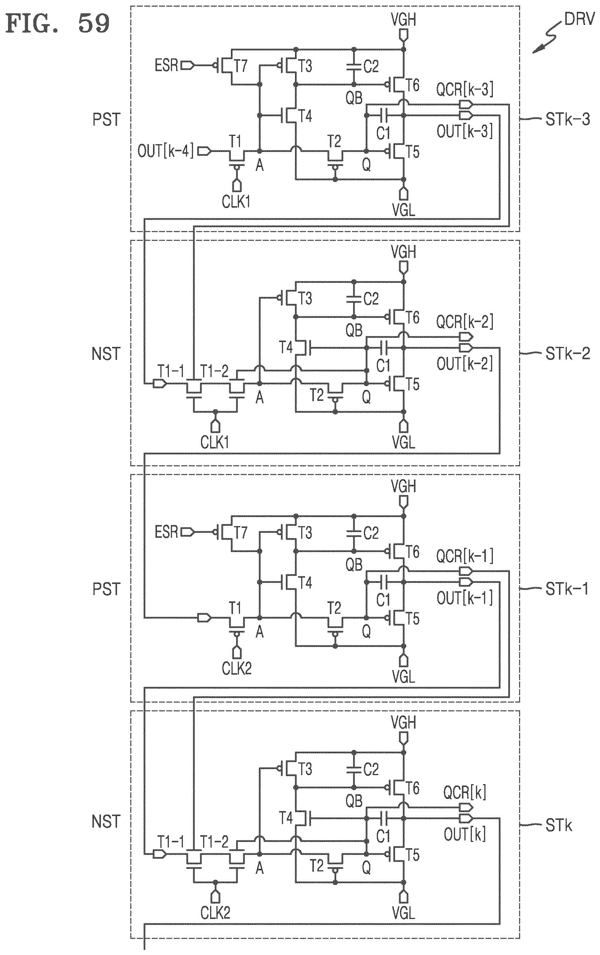

As shown in FIG. 59, the stage group may include the P stage PST shown in FIG. 7 and the N stage NST shown in FIG. 29.

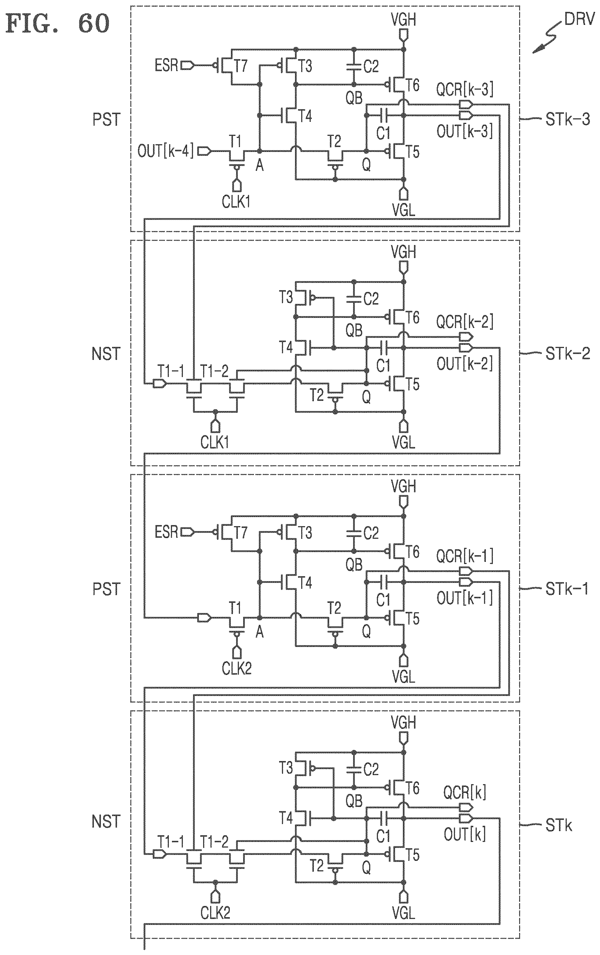

As shown in FIG. 60, the stage group may include the P stage PST shown in FIG. 7 and the N stage NST shown in FIG. 30.

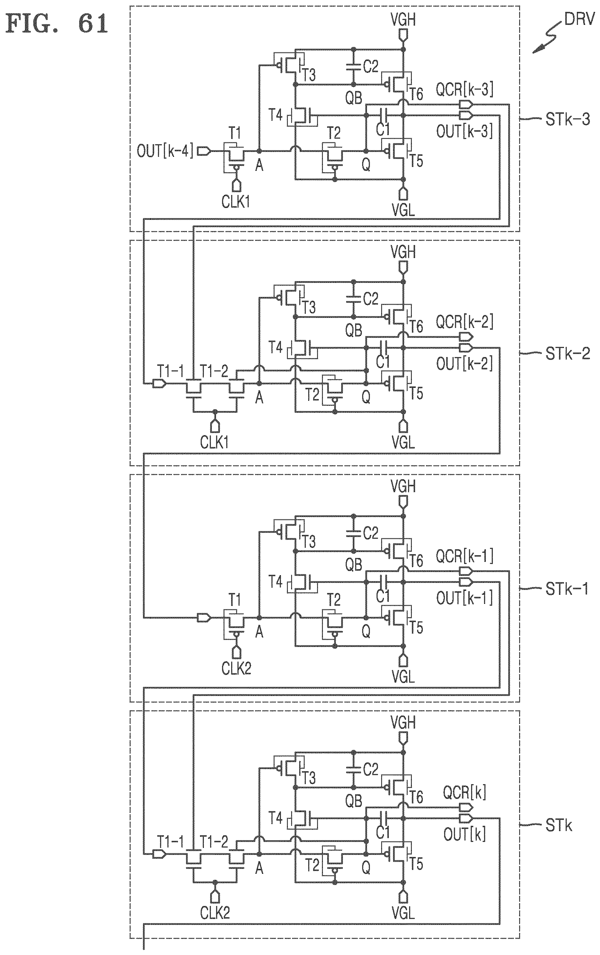

The transistors of the P stage PST and the N stage NST of the stage group may each be a dual gate transistor including a first gate, which is a top gate arranged over a semiconductor, and a second gate, which is a bottom gate (back gate) arranged under the semiconductor. FIGS. 61 to 64 are diagrams of a stage group of the driving circuit DRV in which transistors in FIGS. 57 to 60 are dual gate transistors, respectively.

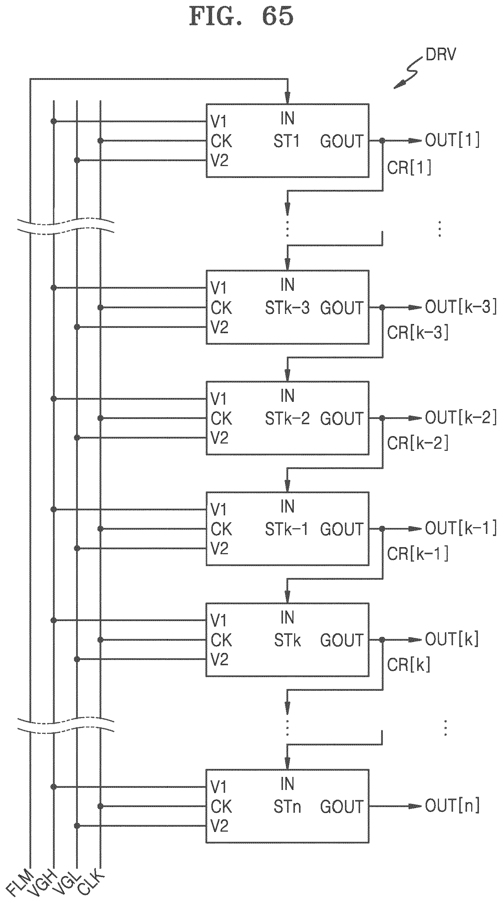

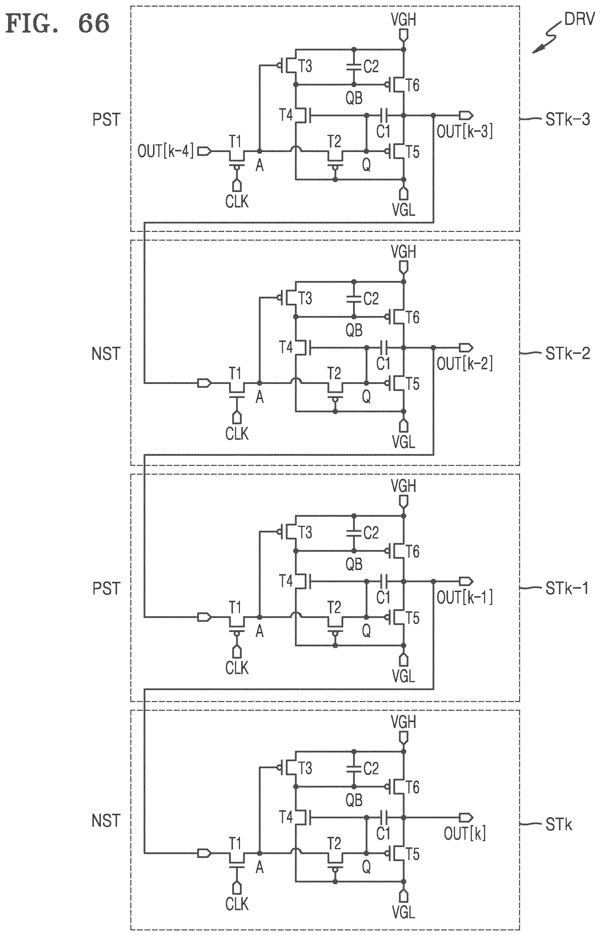

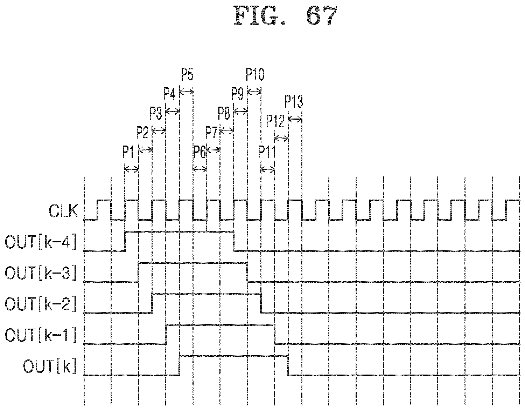

FIG. 65 is a schematic diagram of a driving circuit DRV according to still another example. FIG. 66 is a diagram of an arbitrary stage group among a plurality of stages included in the driving circuit DRV of FIG. 65. FIG. 67 is a timing diagram for describing driving of the stage group DRV of FIG. 66. Hereinafter, the description will mainly focus on configurations different from those described in the aforementioned examples.

Referring to FIGS. 65 to 67, the driving circuit DRV may include a plurality of stages ST1 to STn. As shown in FIG. 66, the driving circuit DRV shown in FIG. 65 may be a shift register in which the P stage PST shown in FIG. 4 and the N stage NST shown in FIG. 5 are alternately arranged and are cascade-connected.

The clock signal CLK may be input to the clock terminal CK of each of the plurality of stages ST1 to STn. As shown in FIG. 67, the clock signal CLK may be a square wave signal that repeats a high-level voltage and a low-level voltage. The clock signal CLK may be a square wave signal that repeats the first voltage VGH and the second voltage VGL. The frequency of the clock signal CLK shown in FIG. 66 may be twice the frequency of the clock signal (such as a first clock signal CLK1 or a second clock signal CLK2) shown in FIG. 40. In the clock signal CLK, a period during which a low-level voltage is maintained and a period during which a high-level voltage is maintained for one cycle may be the same. Compared to the aforementioned examples, the driving circuit DRV shown in FIG. 65 may reduce the number of wires by using only one clock signal CLK, thereby reducing a wire arrangement area.

The stages ST1 to STn may be configured to shift the output signals OUT[1], ..., OUT[k-3], OUT[k-2], OUT[k-1], OUT[k], ..., and OUT[n] having a high-level voltage by a 1/2 cycle of the clock signal and sequentially output the same.

Hereinafter, the operation of the stage group shown in FIG. 66 will be described with reference to FIG. 67.

During a first period P1 to an eighth period P8, the previous output signal OUT[k-4] of high level, which is a start signal, may be supplied to the input terminal IN of the (k-3)-th stage STk-3.

In the first period P1, the clock signal CLK of high level is input to the clock terminal CK of the (k-3)-th stage STk-3, and accordingly, the first transistor T1 of the (k-3)-th stage STk-3 remains turned off, the first node A and the second node Q maintain the same low-level voltage as in a previous period, and the fifth transistor T5 is turned on. Thus, the second voltage VGL of low level may be output as the (k-3)-th output signal OUT[k-3] from the output terminal GOUT. The voltage of the third node QB may be a high-level voltage due to the turned-on third transistor T3.

In the second period P2, the clock signal CLK of low level is input to the clock terminal CK of the (k-3)-th stage STk-3, and accordingly, the first transistor T1 of the (k-3)-th stage STk-3 may be turned on. Due to the turned-on first transistor T1 and the second transistor T2, the previous output signal OUT[k-4] of high level may be transmitted to the first node A and the second node Q of the (k-3)-th stage STk-3, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

In the third period P3, the clock signal CLK of high level is input to the clock terminal CK of the (k-3)-th stage STk-3, and accordingly, the first transistor T1 may be turned off. Because the first node A and the second node Q maintain a high-level voltage in the second period P2 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-3] of high level may be output from the output terminal GOUT of the (k-3)-th stage STk-3.

Because the operation of the (k-3)-th stage STk-3 during the fourth period P4 to the ninth period P9 is the same as the repetition of the operation of the (k-3)-th stage STk-3 during the second period P2 and the third period P3, a detailed description thereof is omitted.

In the ninth period P9, the previous output signal OUT[k-4] transitions from high level to low level and is supplied to the input terminal IN of the (k-3)-th stage STk-3, but the clock signal CLK of high level is input to the clock terminal CK of the (k-3)-th stage STk-3 such that the first transistor T1 is turned off. Thus, regardless of the voltage level of the start signal, the operation of the (k-3)-th stage STk-3 may be the same as the operation of the (k-3)-th stage STk-3 during the third period P3. Accordingly, the output signal OUT[k-3] of high level may be output from the output terminal GOUT of the (k-3)-th stage STk-3.

In a tenth period P10, the previous output signal OUT[k-4] of low level may be supplied to the input terminal IN of the (k-3)-th stage STk-3. The first transistor T1 of the (k-3)-th stage STk-3 may be turned on by the clock signal CLK of low level. The second transistor T2 may be in a state being turned on by the second voltage VGL of low level. Due to the turned-on first transistor T1 and the second transistor T2, the previous output signal OUT[k-4] of low level may be transmitted to the first node A and the second node Q of the (k-3)-th stage STk-3, and the fifth transistor T5 may be turned on. Accordingly, the second voltage VGL of low level may be output as the output signal OUT[k-3] from the output terminal GOUT of the (k-3)-th stage STk-3. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the second period P2 to the ninth period P9, the previous output signal OUT[k-3] of high level, which is a start signal from the (k-3)-th stage STk-3, may be supplied to the input terminal IN of the (k-2)-th stage STk-2.

In the second period P2, the clock signal CLK of low level is input to the clock terminal CK of the (k-2)-th stage STk-2, and accordingly, the first transistor T1 is turned off, the first node A and the second node Q maintain the same low-level voltage as in a previous period, and the fifth transistor T5 is turned on. Thus, the second voltage VGL of low level may be output as the (k-2)-th output signal OUT[k-2] from the output terminal GOUT. The voltage of the third node QB may be a high-level voltage due to the turned-on third transistor T3.

In the third period P3, the clock signal CLK of high level is input to the clock terminal CK of the (k-2)-th stage STk-2, and accordingly, the first transistor T1 may be turned on. Due to the turned-on first transistor T1 and the second transistor T2, the previous output signal OUT[k-3] of high level may be transmitted to the first node A and the second node Q of the (k-2)-th stage STk-2, and the fifth transistor T5 may be turned off. The third transistor T3 whose gate is connected to the first node A may be turned off, the fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-2] of high level may be output from the output terminal GOUT of the (k-2)-th stage STk-2.

In the fourth period P4, the clock signal CLK of low level is input to the clock terminal CK of the (k-2)-th stage STk-2, and thus, the first transistor T1 may be turned off. Because the first node A and the second node Q maintain a high-level voltage in the third period P3 by the first capacitor C1, the fifth transistor T5 may remain turned off. The fourth transistor T4 whose gate is connected to the second node Q may be turned on, and the second voltage VGL of low level may be transmitted to the third node QB. The sixth transistor T6 whose gate is connected to the third node QB may be turned on, and the first voltage VGH of high level may be transmitted to the output terminal GOUT. Accordingly, the output signal OUT[k-2] of high level may be output from the output terminal GOUT of the (k-2)-th stage STk-2.

Because the operation of the (k-2)-th stage STk-2 during the fifth period P5 to the tenth period P10 is the same as the repetition of the operation of the (k-2)-th stage STk-2 during the third period P3 and the fourth period P4, a detailed description thereof is omitted.

In the tenth period P10, the previous output signal OUT[k-3] transitions from high level to low level and is supplied to the input terminal IN of the (k-2)-th stage STk-2, but the clock signal CLK of low level is input to the clock terminal CK of the (k-2)-th stage STk-2 such that the first transistor T1 is turned off. Thus, regardless of the voltage level of the start signal, the operation of the (k-2)-th stage STk-2 may be the same as the operation of the (k-2)-th stage STk-2 during the fourth period P4. Accordingly, the output signal OUT[k-2] of high level may be output from the output terminal GOUT of the (k-2)-th stage STk-2.

In the eleventh period P11, the previous output signal OUT[k-3] of low level may be supplied to the input terminal IN of the (k-2)-th stage STk-2, and the clock signal CLK of high level may be input to the clock terminal CK. Due to the clock signal CLK of high level, the first transistor T1 may be turned on, and due to the turned-on first transistor T1 and second transistor T2, the previous output signal OUT[k-3] of low level may be transmitted to the first node A and the second node Q of the (k-2)-th stage STk-2, and the fifth transistor T5 may be turned on. Accordingly, the second voltage VGL of low level may be output as the output signal OUT[k-2] from the output terminal GOUT of the (k-2)-th stage STk-2. The third transistor T3 whose gate is connected to the first node A may be turned on, the fourth transistor T4 whose gate is connected to the second node Q may be turned off, and the first voltage VGH of high level may be transmitted to the third node QB. The sixth transistor T6 whose gate is connected to the third node QB may be turned off.

During the third period P3 to the tenth period P10, the previous output signal OUT[k-2] of high level, which is a start signal from the (k-2)-th stage STk-2, may be supplied to the input terminal IN of the (k-1)-th stage STk-1. Because the operation of the (k-1)-th stage STk-1 during the third period P3 to the twelfth period P12 is the same as the operation of the (k-3)-th stage STk-3 during the first period P1 to the tenth period P10, a detailed description thereof is omitted.

During the fourth period P4 to the eleventh period P11, the previous output signal OUT[k-1] of high level, which is a start signal from the (k-1)-th stage STk-1, may be supplied to the input terminal IN of the k-th stage STk. Because the operation of k-th stage STk during the fourth period P4 to the thirteenth period P13 is the same as the operation of the (k-2)-th stage STk-2 during the second period P2 to the eleventh period P11, a detailed description thereof is omitted.

The stage group of the driving circuit DRV shown in FIG. 65 is not limited to the stage group shown in FIG. 66. For example, the stage group of the driving circuit DRV shown in FIG. 65 may be composed of a combination of one of the P stages PST shown in FIGS. 4 and 7 and one of the N stages NST shown in FIGS. 5 and 8 to 10.

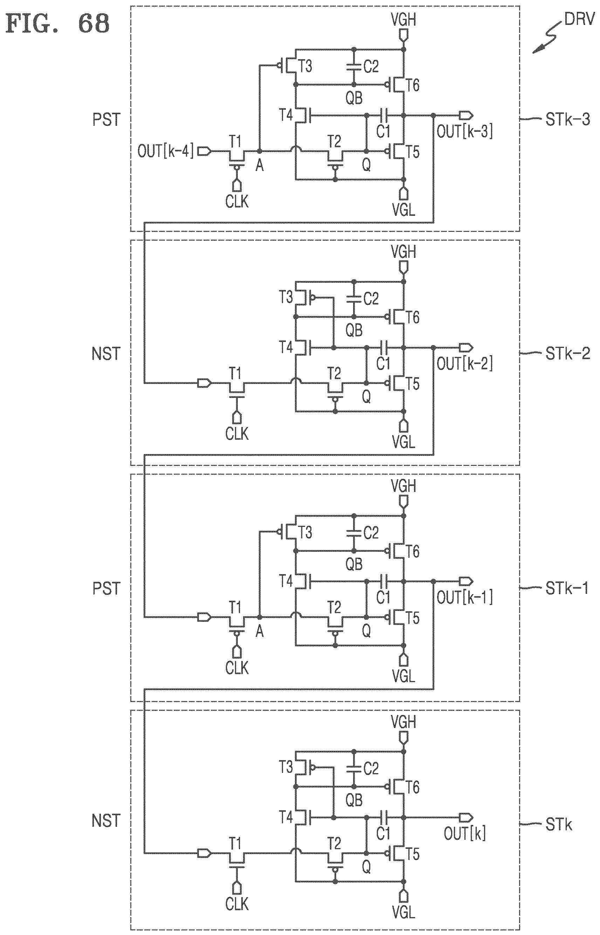

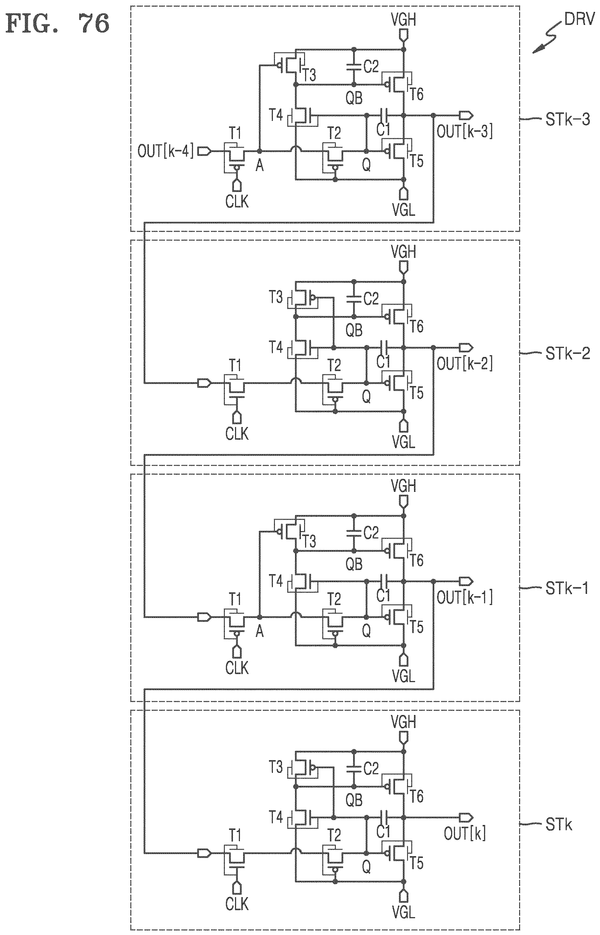

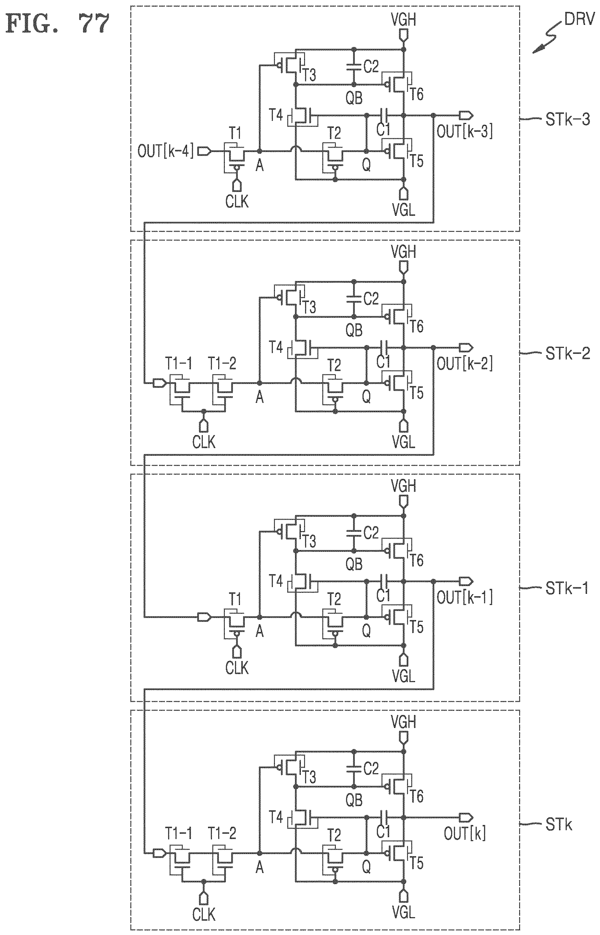

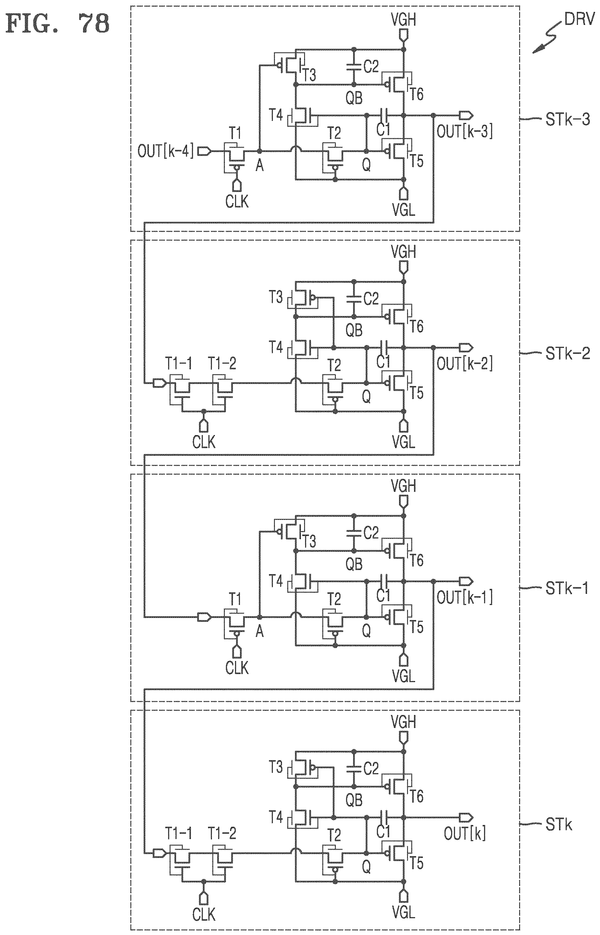

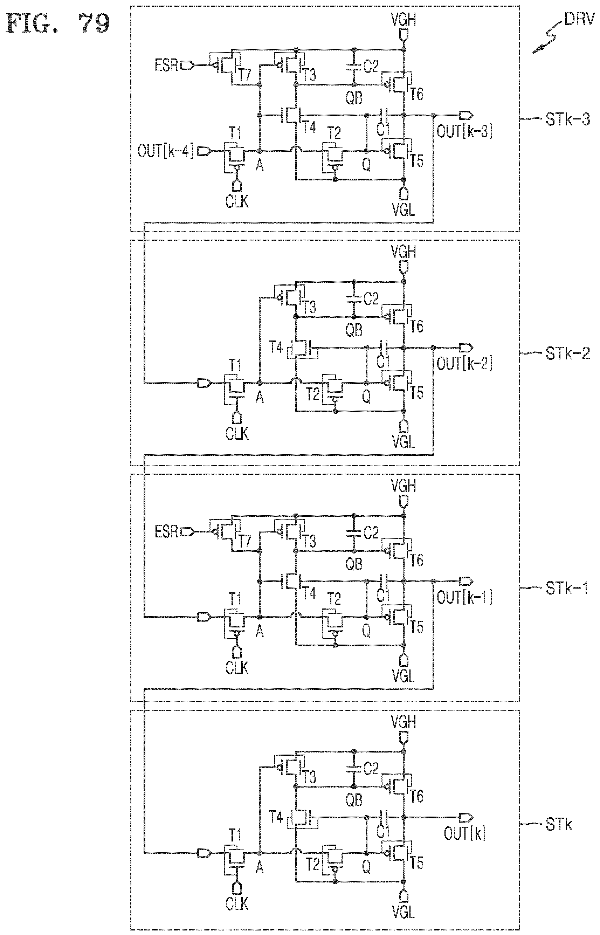

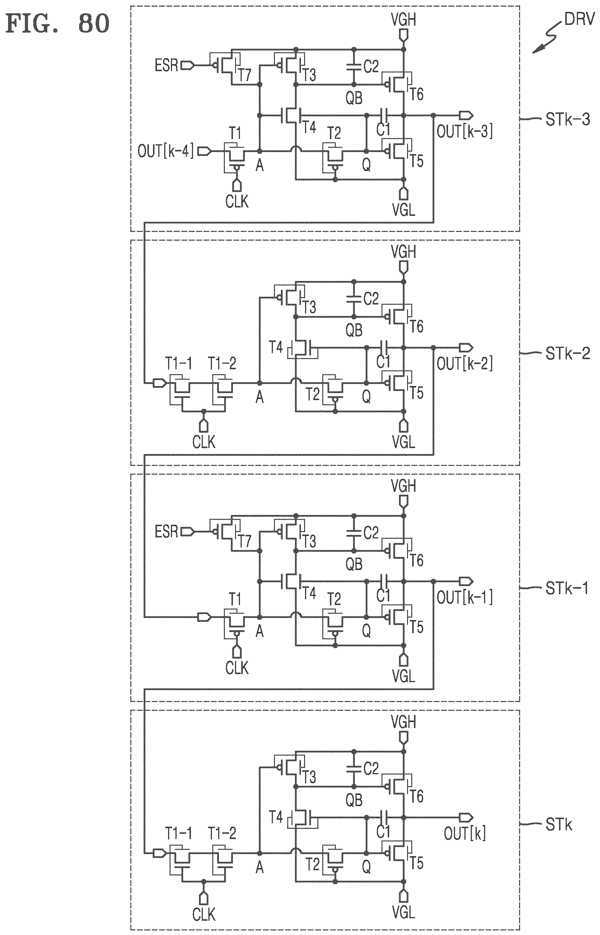

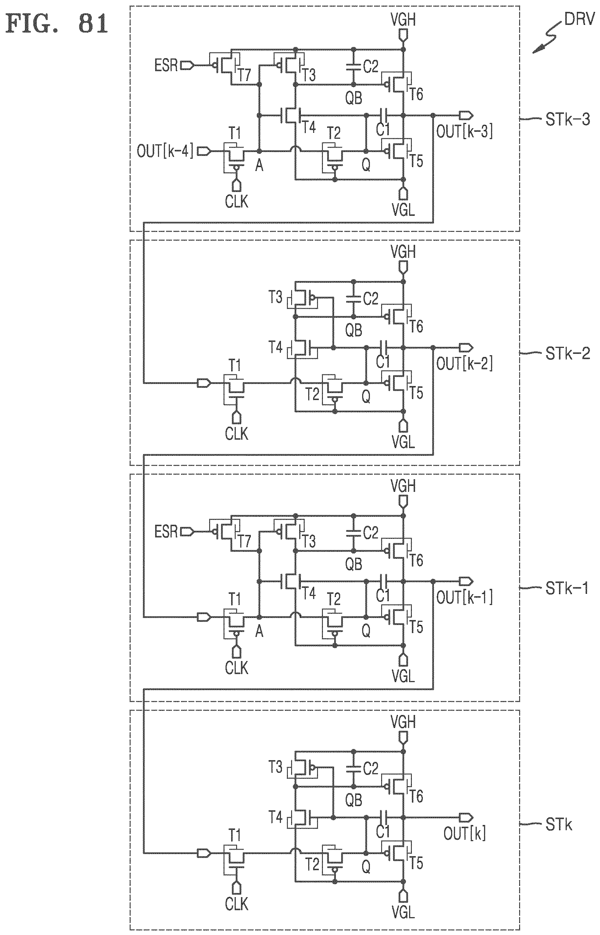

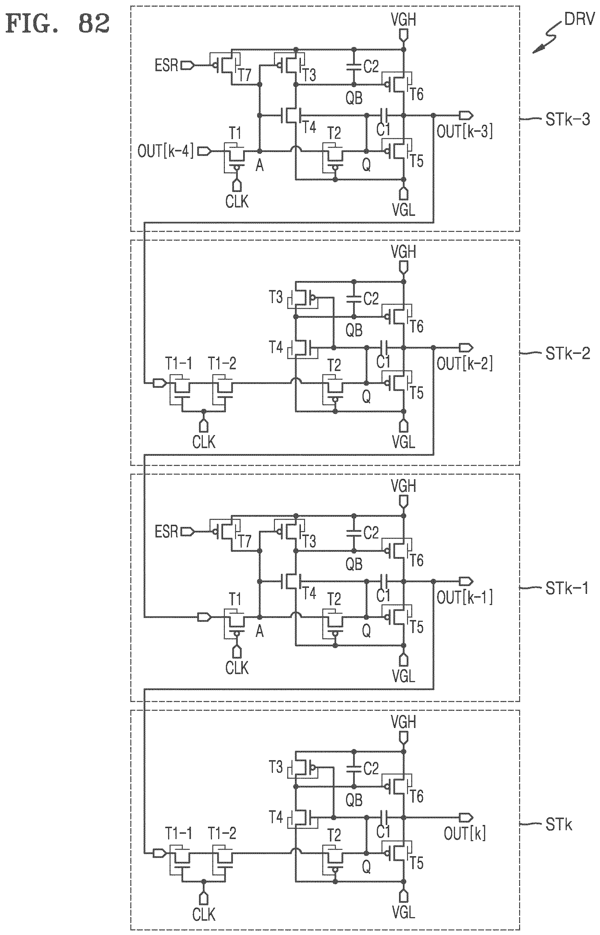

FIGS. 68 to 82 are diagrams of a stage group of a driving circuit DRV, according to other examples. The driving circuit DRV shown in FIGS. 66 to 74 may have a structure in which a stage group in which P stages PST and N stages NST are alternately arranged is repeatedly arranged.

As shown in FIG. 68, the stage group may include the P stage PST shown in FIG. 4 and the N stage NST shown in FIG. 9.

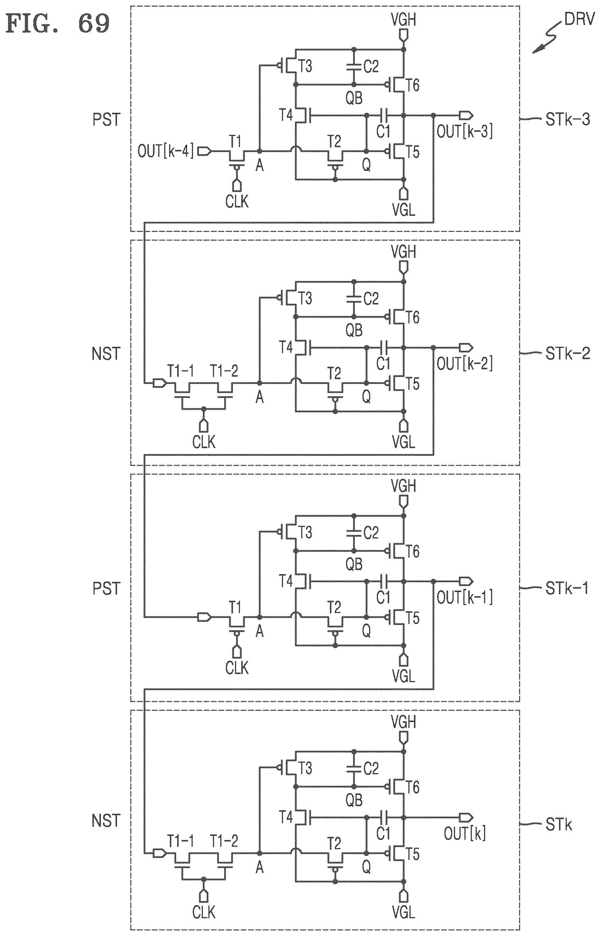

As shown in FIG. 69, the stage group may include the P stage PST shown in FIG. 4 and the N stage NST shown in FIG. 8.

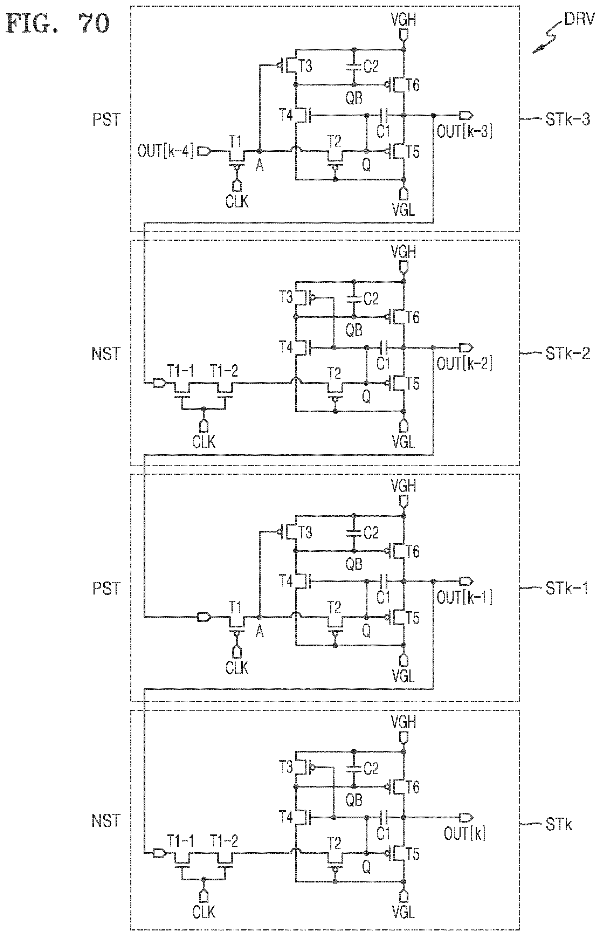

As shown in FIG. 70, the stage group may include the P stage PST shown in FIG. 4 and the N stage NST shown in FIG. 10.

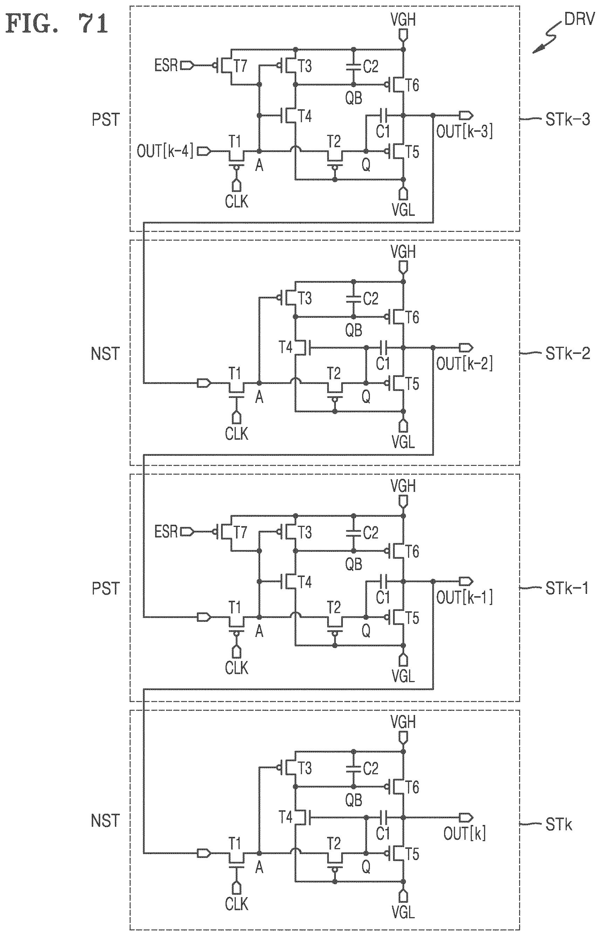

As shown in FIG. 71, the stage group may include the P stage PST shown in FIG. 7 and the N stage NST shown in FIG. 5.

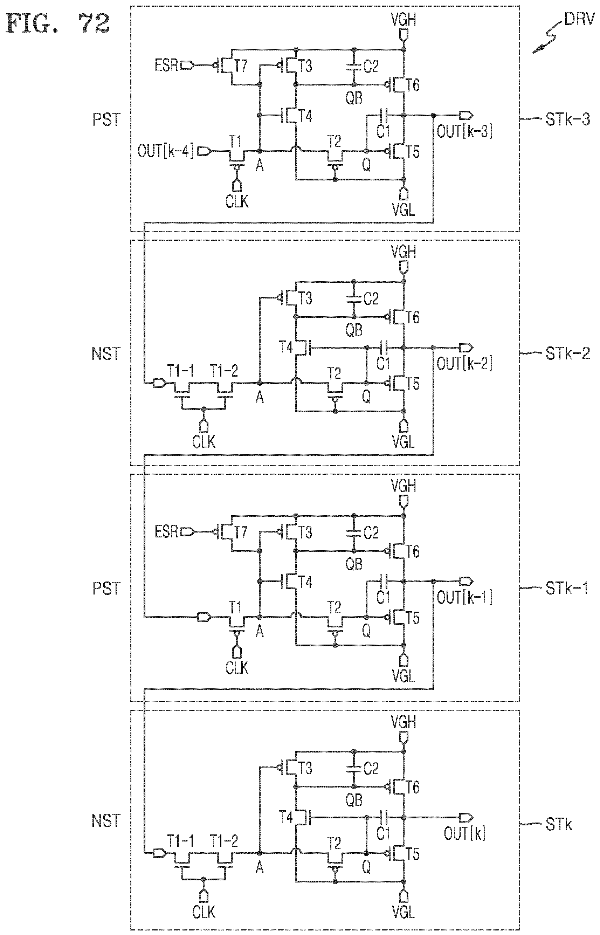

As shown in FIG. 72, the stage group may include the P stage PST shown in FIG. 7 and the N stage NST shown in FIG. 8.

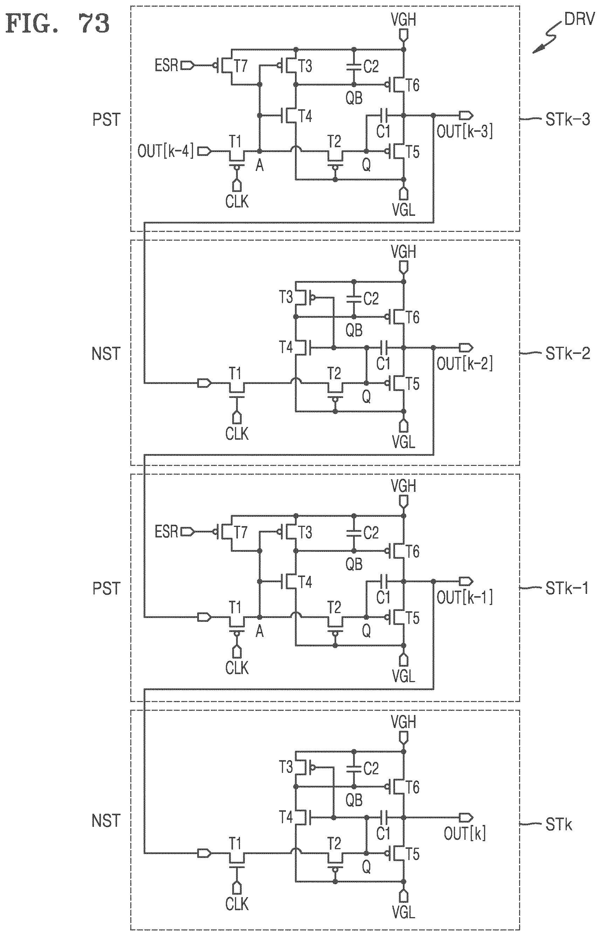

As shown in FIG. 73, the stage group may include the P stage PST shown in FIG. 7 and the N stage NST shown in FIG. 9.

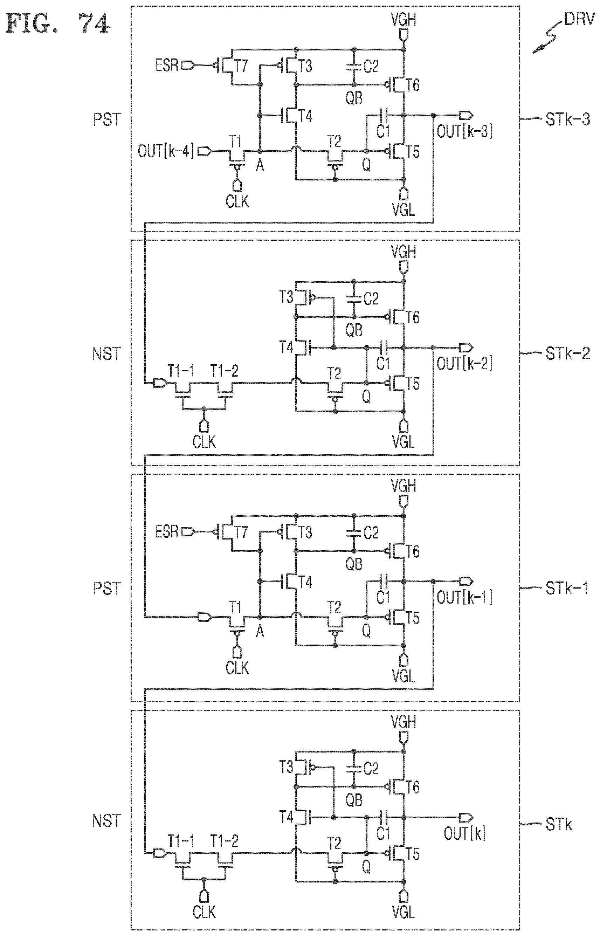

As shown in FIG. 74, the stage group may include the P stage PST shown in FIG. 7 and the N stage NST shown in FIG. 10.

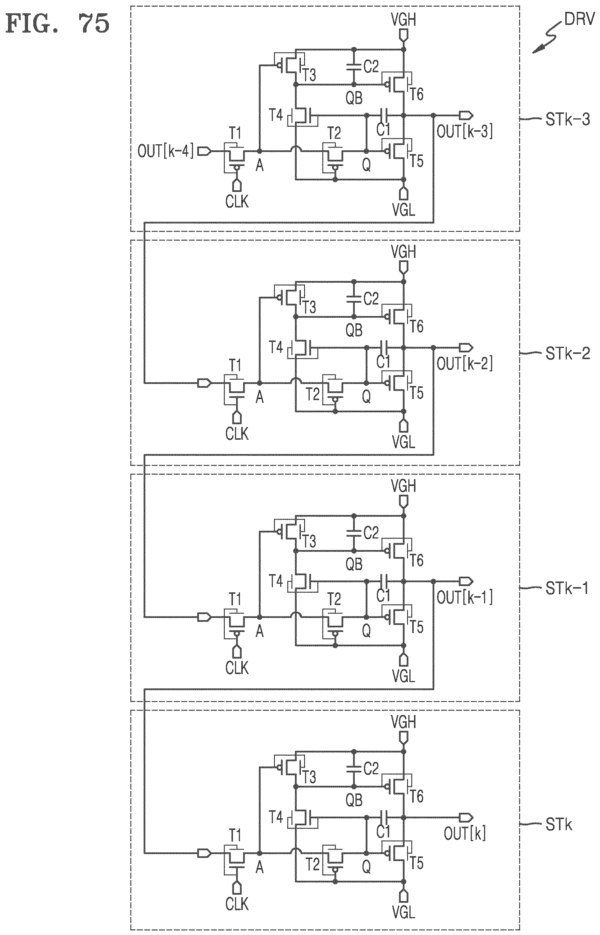

FIGS. 75 to 82 are diagrams of a stage group of the driving circuit DRV in which transistors in FIGS. 66 and 68 to 74 are dual gate transistors, respectively.

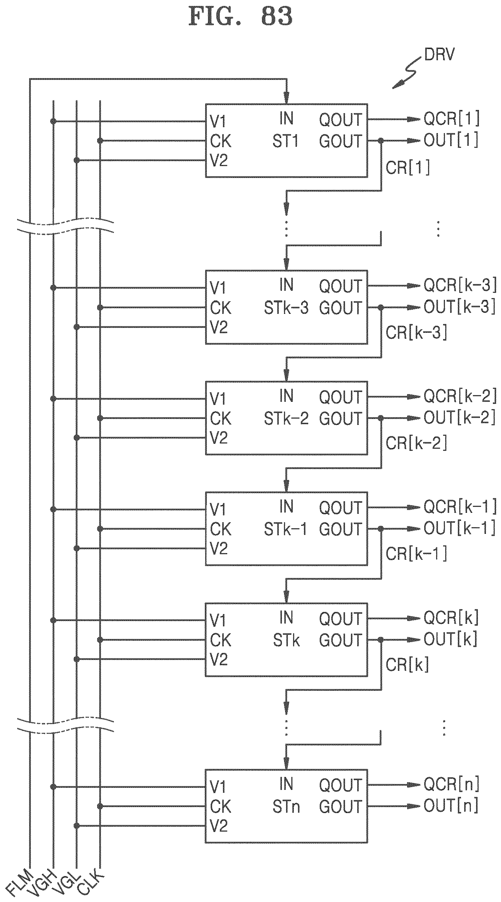

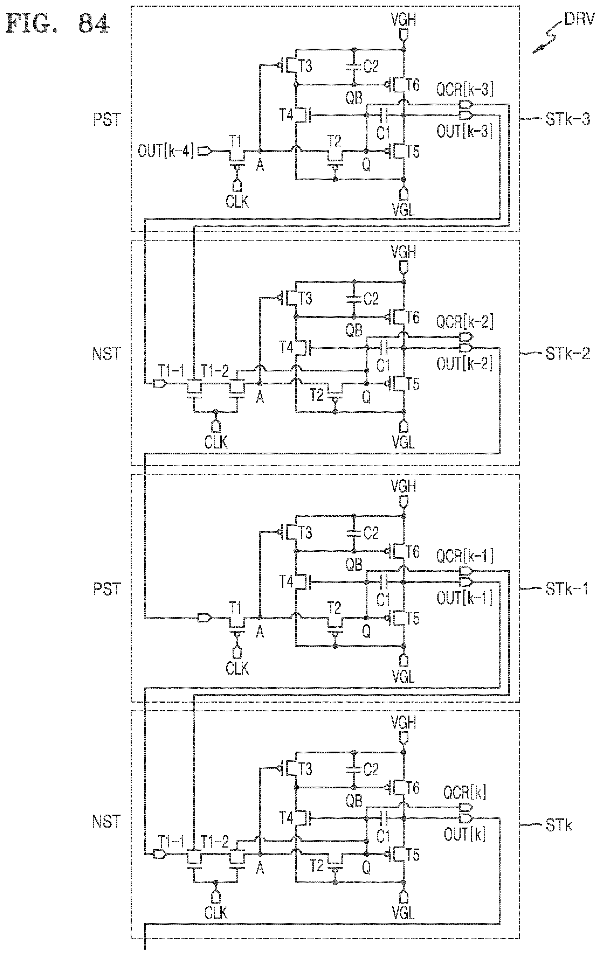

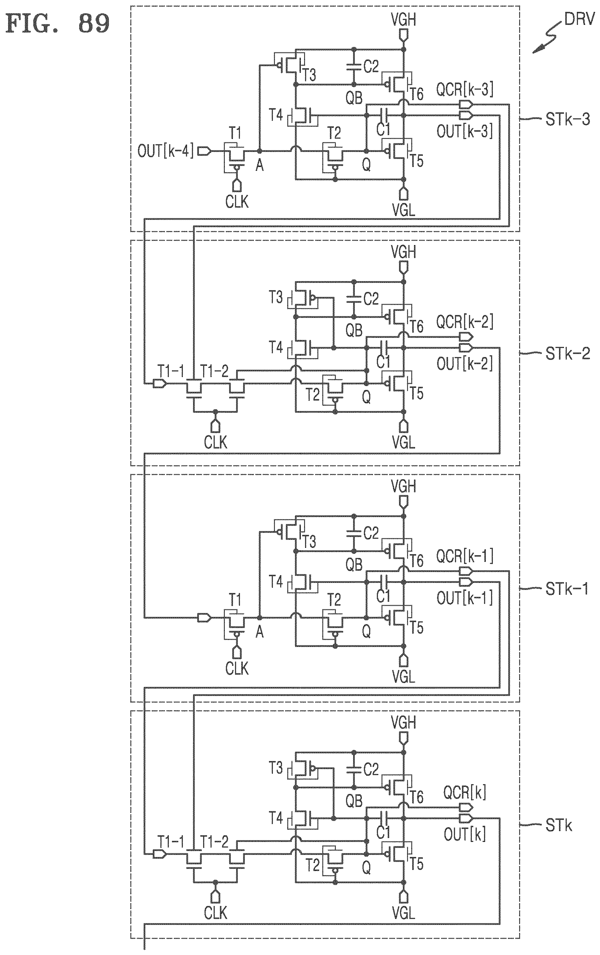

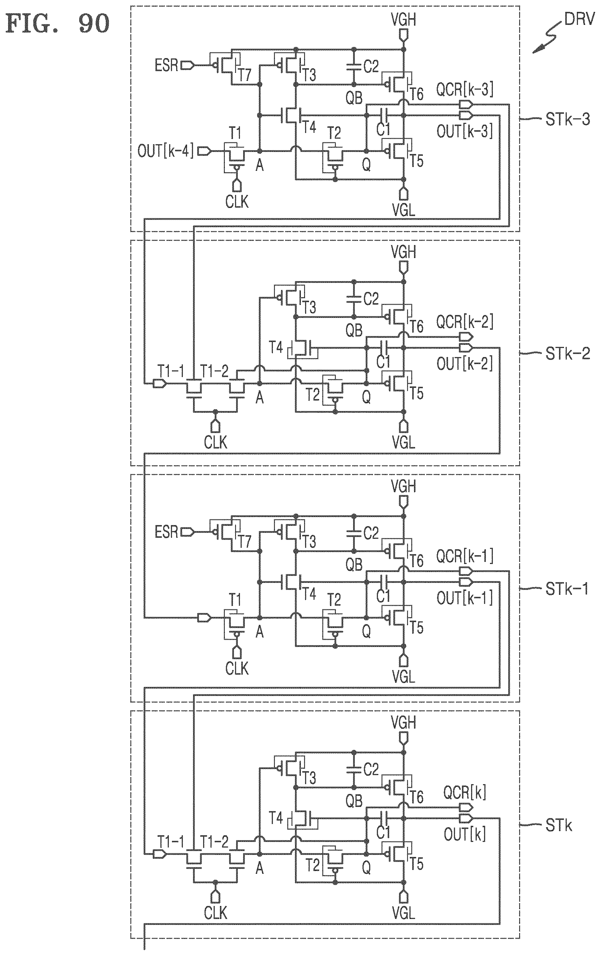

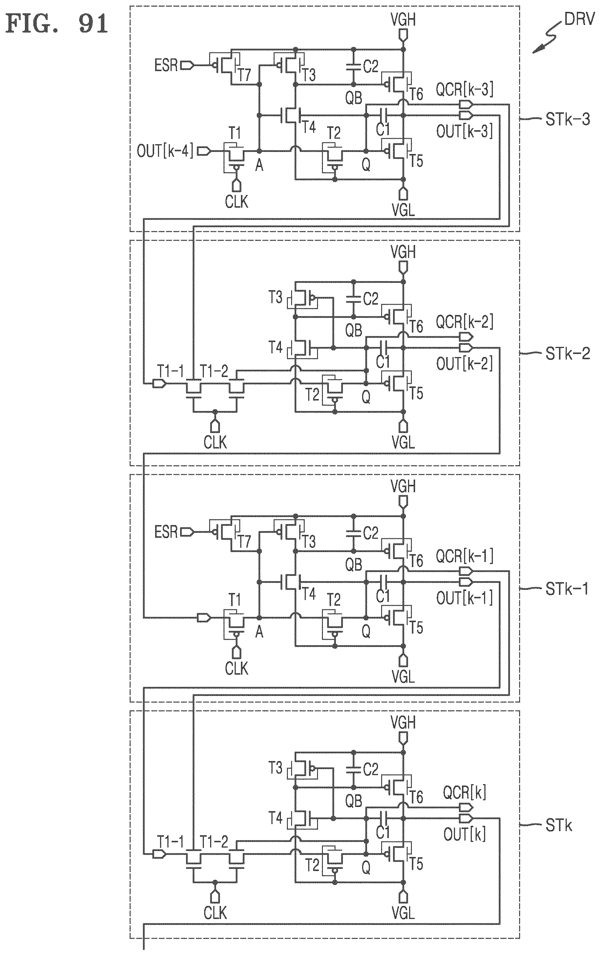

FIG. 83 is a schematic diagram of a driving circuit DRV according to yet another example. FIGS. 84 to 91 are diagrams of an arbitrary stage group among a plurality of stages included in the driving circuit DRV of FIG. 83.

The driving circuit DRV shown in FIG. 83 differs from the driving circuit DRV shown in FIG. 65 in that each stage further includes the node voltage output terminal QOUT configured to output the voltage of the second node Q as a corresponding one of the second carry signals QCR[1] to QCR[n], and other configurations are the same.

For example, the stage group of the driving circuit DRV shown in FIG. 83 may be composed of a combination of one of the P stages PST shown in FIGS. 4 and 7 and one of the N stages NST shown in FIGS. 29 and 30.

As shown in FIG. 84, the stage group may include the P stage PST shown in FIG. 4 and the N stage NST shown in FIG. 29.

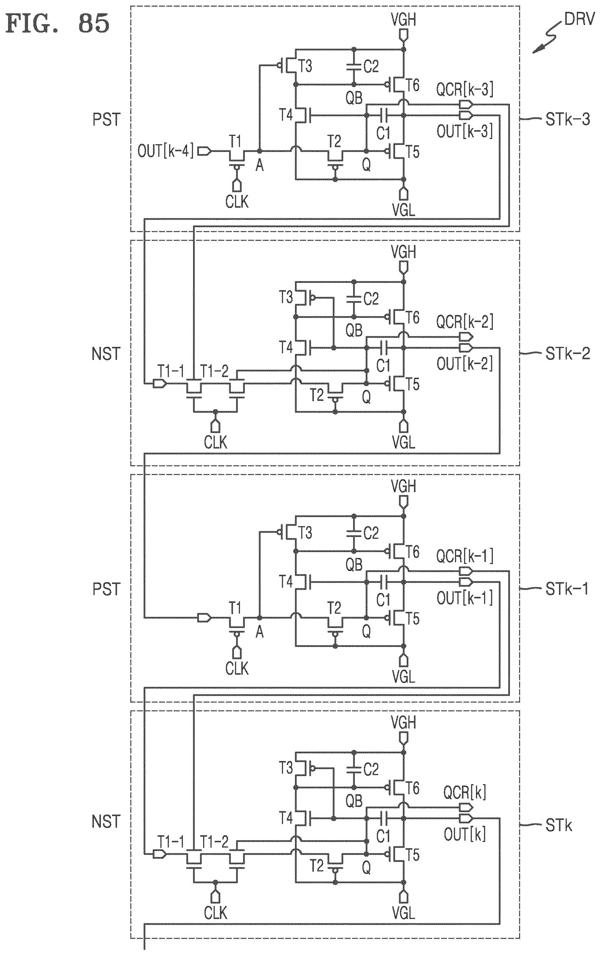

As shown in FIG. 85, the stage group may include the P stage PST shown in FIG. 4 and the N stage NST shown in FIG. 30.

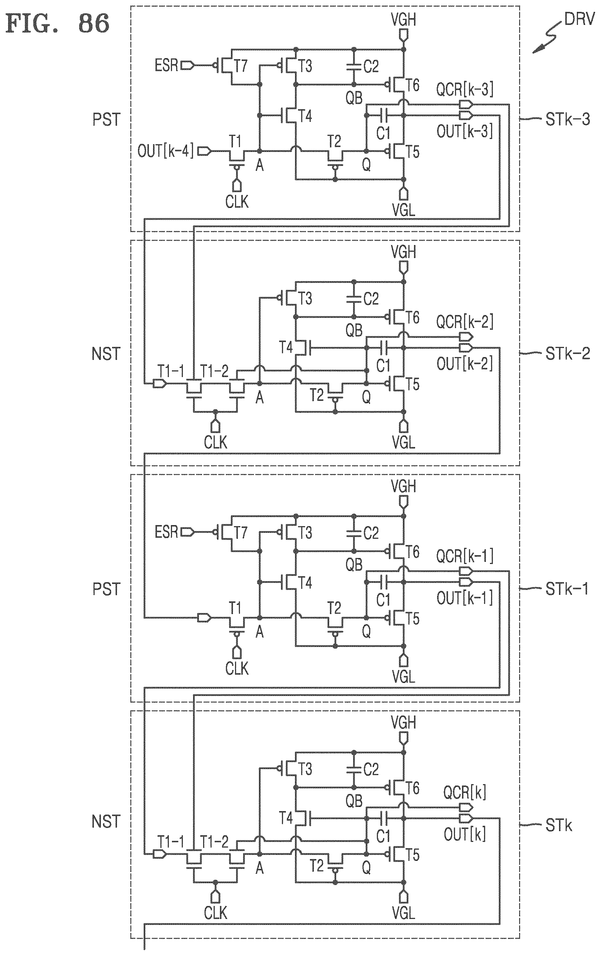

As shown in FIG. 86, the stage group may include the P stage PST shown in FIG. 7 and the N stage NST shown in FIG. 29.

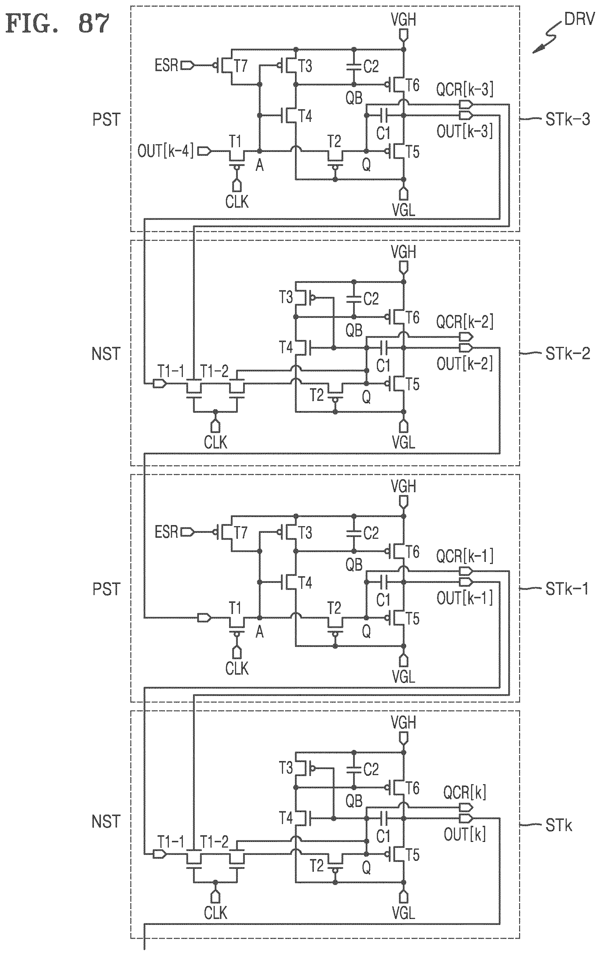

As shown in FIG. 87, the stage group may include the P stage PST shown in FIG. 7 and the N stage NST shown in FIG. 30.

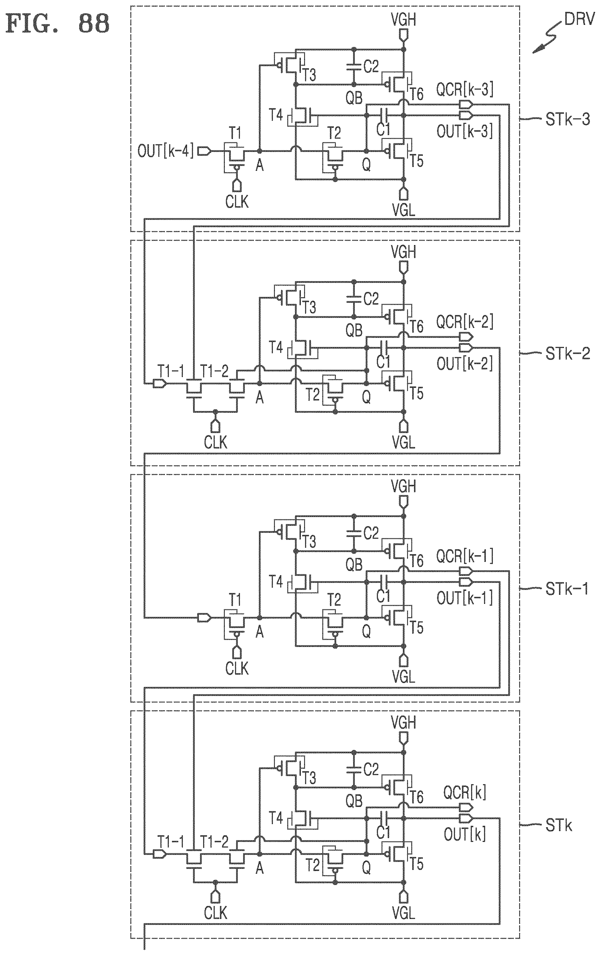

The transistors of the P stage PST and the N stage NST of the stage group may each be a dual gate transistor including a first gate, which is a top gate arranged over a semiconductor, and a second gate, which is a bottom gate (back gate) arranged under the semiconductor. FIGS. 88 to 91 are diagrams of a stage group of the driving circuit DRV in which transistors in FIGS. 84 to 87 are dual gate transistors, respectively.

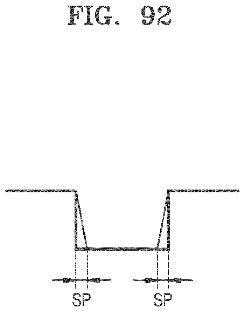

FIG. 92 is a diagram of a clock signal.

As shown in FIG. 92, a slew rate of the clock signal CLK input to the driving circuit DRV may be controlled. By controlling the slew rate, a slope of a rising edge and a falling edge of the clock signal CLK may be controlled within a control period SP.

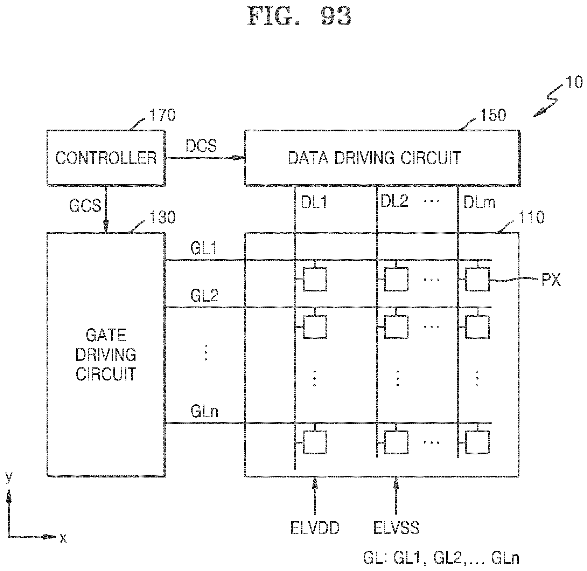

FIG. 93 is a schematic diagram of a display apparatus 10.

Referring to FIG. 93, the display apparatus 10 may include a pixel area 110, a gate driving circuit 130, a data driving circuit 150, and a controller 170.

A plurality of pixels PX and signal lines via which an electrical signal may be input to the plurality of pixels PX may be arranged in the pixel area 110.

The plurality of pixels PX may be repeatedly arranged in a first direction (e.g., an x-direction or row direction) and a second direction (e.g., a y-direction or column direction). The plurality of pixels PX may be arranged in various forms, such as a stripe arrangement, PenTile^{®} arrangement, diamond arrangement, and mosaic arrangement, to create an image. Each of the plurality of pixels PX includes an organic light-emitting diode as a display element, and the organic light-emitting diode may be connected to a pixel circuit. The pixel circuit may include a plurality of transistors and at least one capacitor.

The plurality of transistors included in the pixel circuit may be N-type oxide transistors. The oxide transistor may include an oxide semiconductor, and the oxide semiconductor is a Zn oxide-based material and may include Zn oxide, indium In-Zn oxide, gallium Ga-In-Zn oxide, or the like. The oxide semiconductor may include an IGZO semiconductor. The oxide semiconductor may include an ITGZO semiconductor. For example, the oxide transistor may include an LTPO thin-film transistor.

Some of the plurality of transistors included in the pixel circuit may be N-type oxide transistors, and others thereof may be P-type silicon transistors. The silicon transistor may include a silicon semiconductor, and the silicon semiconductor may include amorphous silicon, polysilicon, or the like. For example, the silicon transistor may include an LTPS thin-film transistor.

The signal lines via which an electrical signal may be input to the plurality of pixels PX may include a plurality of gate lines GL1, GL2, ..., and GLn extending in the first direction and a plurality of data lines DL1, DL2, ..., and DLm extending in the second direction, where n is a positive integer and m is a positive integer. The plurality of gate lines GL1 to GLn may be arranged to be spaced apart in the second direction and may be configured to transmit a gate signal to the pixels PX. The plurality of data lines DL1 to DLm may be arranged to be spaced apart in the first direction and may be configured to transmit a data signal to the pixels PX. Each of the plurality of pixels PX may be connected to at least one corresponding gate line among the plurality of gate lines GL1 to GLn and a corresponding data line among the plurality of data lines DL1 to DLm. Each pixel PX may be configured to receive a data signal from the corresponding data line when a gate signal is supplied through the corresponding gate line.

The gate driving circuit 130 may be connected to the plurality of gate lines GL1 to GLn and may be configured to generate a gate signal in response to a gate driving control signal GCS from the controller 170 and sequentially supply the gate signal to the gate lines GL1 to GLn. The gate lines GL1 to GLn may be connected to a gate of the transistor included in the pixel PX, and the gate signal may be a gate control signal for controlling turn-on and turn-off of the transistor to which a gate line is connected. The gate signal may include a gate-on voltage that may turn on the transistor and a gate-off voltage that may turn off the transistor.

The data driving circuit 150 may be connected to the plurality of data lines DL1 to DLm and may be configured to supply a data signal to the data lines DL1 to DLm in response to a data driving control signal DCS from the controller 170. The data signal supplied to the data lines DL1 to DLm may be supplied to the pixels PX to which the gate signal is supplied.

When the display apparatus is an organic light-emitting display apparatus, a first power voltage ELVDD and a second power voltage ELVSS may be supplied to the pixels PX of the pixel area 110. The first power voltage ELVDD may be a high-level voltage that is provided to one terminal of a driving transistor connected to a first electrode (e.g., a pixel electrode or anode) of an organic light-emitting diode of each pixel PX. The second power voltage ELVSS may be a low-level voltage that is provided to a second electrode (e.g., an opposite electrode or cathode) of an organic light-emitting diode connected to another terminal of the driving transistor. The first power voltage ELVDD and the second power voltage ELVSS may be driving voltages for causing the plurality of pixels PX to emit light.

The controller 170 may be configured to generate the gate driving control signal GCS and the data driving control signal DCS based on signals input from the outside. The controller 170 may be configured to supply the gate driving control signal GCS to the gate driving circuit 130 and supply the data driving control signal DCS to the data driving circuit 150.

The gate driving circuit 130 may be implemented with the driving circuits DRV using a dual-level trigger scheme shown in FIGS. 1 to 91. For example, a gate signal output by the gate driving circuit 130 to each gate line GL may correspond to the output signal OUT output, to a signal line, by each of the plurality of stages ST1 to STn of the driving circuits DRV shown in FIGS. 1 to 91. The number of stages constituting the gate driving circuit 130 to which the driving circuit DRV is applied may be variously modified depending on the number of rows (horizontal lines) provided in the pixel area 110.

Each of the stages ST1 to STn may be connected to a gate line arranged in a corresponding row of the pixel area 110. Each of the stages ST1 to STn may be configured to generate the gate signal and output the gate signal to a connected gate line GL. That is, each of the stages ST1 to STn may be configured to supply the gate signal to the gate line GL provided in a corresponding row.

The display apparatus 10 may include display apparatuses such as an organic light-emitting display apparatus, an inorganic light-emitting display apparatus (or an inorganic electroluminescent ("EL") display apparatus), and a quantum dot light-emitting display apparatus.

By applying, to the gate driving circuit 130, the driving circuit DRV using a dual-level trigger scheme, which operates a plurality of stages by using P-channel transistors and N-channel transistors that are turned on by signals of different voltage levels, the clock frequency may be reduced to approximately 1/2 compared to a driving circuit including only P stages, thereby reducing power consumption of the display apparatus 10.

Also, by applying, to the gate driving circuit 130, the driving circuit DRV in which the plurality of stages are alternately arranged into a pair of P stages and a pair of N stages, errors in which adjacent stages simultaneously operate in an arrangement in which one P stage and one N stage alternate with each other may be significantly reduced.

Moreover, when the driving circuit DRV in which a P stage and an N stage use one clock signal is applied to the gate driving circuit 130, a clock line is reduced such that a non-display area of the display apparatus 10 may be reduced.

In addition, as the first transistor T1 of the N stage is implemented in the gate driving circuit 130 as a dual gate transistor with a plurality of sub-transistors connected in series, a low leakage current effect of the oxide transistor and the reliability of a low-frequency operation of the display apparatus 10 may be secured.

A display apparatus according to some embodiments of the disclosure may be an apparatus displaying a video or a static image, and may visually provide information to a user. The display apparatus be used as a display screen of various electronic apparatus, such as a television, a notebook computer, a monitor, a broadcasting panel, and an Internet of things (IOT) device, as well as portable electronic devices, such as a mobile phone, a smart phone, a tablet personal computer (PC), a mobile communication terminal, an electronic notebook, an electronic book, a portable multimedia player (PMP), a navigation device, and an ultra-mobile PC (UMPC). Also, the display apparatus according to an embodiment may be used in wearable electronic apparatus, such as a smart watch, a watch phone, a glasses-type display, and a head-mounted display (HMD). Also, the display apparatus according to an embodiment may be used as an electronic apparatus, such as a center information display (CID) on a dashboard of a vehicle or a center fascia or a dashboard of the vehicle, a room mirror display substituting a side-view mirror of a vehicle, or a display disposed on a rear surface of a front seat, as an entertainment device for a backseat of a vehicle. Also, the display apparatus may be a flexible apparatus.

As described above, the one or more embodiments have been described with reference to the accompanying drawings, but the embodiments should be considered in a descriptive sense only. Those of ordinary skill in the art will understand that various modifications and changes to the embodiments may be made therefrom. Therefore, the true technical scope of protection of the disclosure should be defined by the appended claims.

A display apparatus to which a driving circuit according to the one or more embodiments is applied may reduce power consumption while reducing the area of a non-display area. The effects of the one or more embodiments are not limited to the effects described above.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the invention as defined by the following claims.

## Claims

1. A driving circuit including a plurality of cascade connected stages (ST1 to STn), each of the stages comprising a first stage (PST) or a second stage (NST), wherein
each of the first stages and the second stages being configured to receive a first voltage (VGH) at a first voltage input terminal (V1) and a second voltage (VGL) at a second voltage input terminal (V2), each of the first stages and second stages comprising:
a first transistor (T1) connected between a first node (A) and a start signal input terminal (IN) to which a start signal is input, the first transistor including a gate connected to a clock terminal (CK) to which a clock signal is input;
a second transistor (T2) connected between the first node (A) and a second node (Q), the second transistor including a gate connected to the second voltage input terminal (V2);
an inverter (T3, T4) connected between the first voltage input terminal (V1) and the second voltage input terminal (V2), the inverter being configured to control a voltage of a third node (QB) to be a voltage obtained by inverting a voltage level of the first node (A) or a voltage level of the second node (Q);
a pull-down transistor (T5) connected between an output terminal (OUT) and the second voltage input terminal (V2), the pull-down transistor including a gate connected to the second node (Q); and
a pull-up transistor (T6) connected between the first voltage input terminal (V1) and the output terminal (OUT), the pull-up transistor including a gate connected to the third node (QB),
wherein the first transistor (T1) of each of the first stages is a P-channel transistor, and
the first transistor (T1) of each of the second stages is an N-channel transistor,
wherein the plurality of cascade connected stages comprise a pair of cascade connected first stages (PST) that are cascade connected to a pair of cascade connected second stages (NST); or
wherein the plurality of cascade connected stages comprise a first stage that is cascade connected to a second stage.

2. The driving circuit of claim 1, wherein the first voltage (VGH) is greater than the second voltage (VGL).

3. The driving circuit of claim 1, wherein the clock signal includes a first clock signal (CLK1) and a second clock signal (CLK2),
the first clock signal is input to clock terminals of an odd-numbered first stage among the pair of first stages and an odd-numbered second stage among the pair of second stages,
the second clock signal is input to clock terminals of an even-numbered first stage among the pair of first stages and an even-numbered second stage among the pair of second stages, and
the second clock signal is phase-shifted by a 1/4 cycle with respect to the first clock signal.

4. The driving circuit of claim 1, 2 or 3, wherein the inverter of each of the first stages (PST) and the second stages (NST) includes:
a third transistor (T3) connected between the first voltage input terminal (V1) and the third node (QB), the third transistor including a gate connected to the first node (A); and
a fourth transistor (T4) connected between the third node (QB) and the second voltage input terminal (V2), the fourth transistor including a gate connected to the second node (Q).

5. The driving circuit of claim 1, 2 or 3, wherein the inverter of each of the first stages (PST) includes:
a third transistor (T3) connected between the first voltage input terminal (V1) and the third node (QB), the third transistor including a gate connected to the first node (A); and
a fourth transistor (T4) connected between the third node (QB) and the second voltage input terminal (V2), the fourth transistor including a gate connected to the first node (A).

6. The driving circuit of claim 5, wherein the fourth transistor (T4) of each of the first stages (PST) further includes a back gate connected to the second node.

7. The driving circuit of claim 6, wherein each of the first stages (PST) further comprises a seventh transistor (T7) connected between the first voltage input terminal (V1) and the first node (A), the seventh transistor (T7) including a gate connected to a reset terminal (RS).

8. The driving circuit of claim 1, 2 or 3, wherein the inverter of each of the second stages (NST) includes:
a third transistor (T3) connected between the first voltage input terminal (V1) and the third node (QB), the third transistor including a gate connected to the second node (Q); and
a fourth transistor (T4) connected between the third node (QB) and the second voltage input terminal (V2), the fourth transistor (T4) including a gate connected to the second node (Q).

9. The driving circuit of claim 8, wherein the first transistor (T1) of each of the second stages (NST) includes a pair of sub-transistors (T1-1, T1-2) connected in series.

10. The driving circuit of claim 9, wherein the pair of sub-transistors connected in series include a first sub-transistor (T1-1) and a second sub-transistor (T1-2),
the first sub-transistor (T1-1) further includes a back gate configured to receive a voltage of the second node (Q) of a previous stage, and
the second sub-transistor (T1-2) further includes a back gate configured to receive a voltage of the second node (Q) of a current stage.

11. The driving circuit of claim 1, 2 or 3, wherein the inverter of each of the second stages (NST) includes:
a third transistor (T3) connected between the first voltage input terminal (V1) and the third node (QB), the third transistor (T3) including a gate connected to the first node (A); and
a fourth transistor (T4) connected between the third node (QB) and the second voltage input terminal (V2), the fourth transistor (T4) including a gate connected to the second node (Q), and
the first transistor of each of the second stages includes a pair of sub-transistors connected in series.

12. The driving circuit of claim 11, wherein the pair of sub-transistors connected in series include a first sub-transistor and a second sub-transistor,
the first sub-transistor further includes a back gate configured to receive a voltage of the second node (Q) of a previous stage, and
the second sub-transistor further includes a back gate configured to receive a voltage of the second node (Q) of a current stage.

13. The driving circuit of claim 1, wherein the driving circuit is configured to repeat a first stage group and a second stage group,
each of the first stage group and the second stage group includes an odd-numbered first stage and an even-numbered second stage,
the clock signal includes a first clock signal and a second clock signal,
the first clock signal is input to clock terminals of the odd-numbered first stage and the even-numbered second stage of the first stage group,
the second clock signal is input to clock terminals of the odd-numbered first stage and the even-numbered second stage of the second stage group, and
the second clock signal is phase-shifted by a 1/2 cycle with respect to the first clock signal.

14. The driving circuit of claim 1, wherein a clock signal input to the clock terminal of the first stage and a clock signal input to the clock terminal of the second stage are identical.
